# EUROPEAN PATENT APPLICATION

(11) **EP 4 665 129 A1**
(43) Date of publication of application: **17.12.2025**
(21) Application number: 25179425.1
(22) Date of filing: 28.05.2025
(51) Int. Cl.: H10K 85/60, H10K 50/11, H10K 50/15

(54) **ORGANIC LIGHT-EMITTING DIODE WITH LOW VOLTAGE, HIGH EFFICIENCY, AND LONG LIFESPAN**

(30) Priority: 10.06.2024 KR 20240075159; 25.03.2025 KR 20250037886
(71) Applicant: SFC Co., Ltd., Cheongju-si, Chungcheongbuk-do 28122 (KR)
(72) Inventor: Kwak, Sang-woo, 28122 Cheongju-si, Chungcheongbuk-do (KR); Kim, Myeong-jun, 28122 Cheongju-si, Chungcheongbuk-do (KR); Jeong, Jae-gyeong, 28122 Cheongju-si , Chungcheongbuk-do (KR); Lim, Jae-gyun, 27111 Jecheon-si, Chungcheongbuk-do (KR); Choi, Ho-jeong, 28122 Cheongju-si , Chungcheongbuk-do (KR); Shin, Bong-ki, 28122 Cheongju-si , Chungcheongbuk-do (KR)
(74) Representative: Epping - Hermann - Fischer

(57) **Abstract**

The present invention relates to an organic light-emitting diode with high efficiency characteristics. More specifically, the present disclosure relates to an organic light-emitting diode that exhibits low driving voltage, high efficiency, and long lifespan by including an amine compound represented by Chemical Formula 1 as the emitting layer material, and an amine compound represented by Chemical Formula 2 or Chemical Formula 3 as the emitting-auxiliary layer material. Chemical Formulas 1 to 3 are as described in detail in the specification of the present disclosure.

## Description

### BACKGROUND OF THE INVENTION

### 1. Field of the invention

The present disclosure relates to an organic light emitting diode (OLED) with low voltage, high efficiency, and long lifespan. More specifically, the present disclosure relates to an organic light emitting diode that can exhibit low voltage, high efficiency, and long lifespan by respectively using amine compounds having a specific structure as a light-emitting layer material and as an emitting-auxiliary layer material in the organic light emitting diode.

### 2. Description of the Prior Art

Organic light-emitting diodes (OLEDs), based on self-luminescence, are used to create digital displays with the advantage of having a wide viewing angle and being able to be made thinner and lighter than liquid crystal displays. In addition, an OLED display exhibits a very fast response time. Accordingly, OLEDs find applications in the full color display field or the illumination field.

In general, the term "organic light-emitting phenomenon" refers to a phenomenon in which electrical energy is converted to light energy by means of an organic material. An organic light-emitting diode using the organic light-emitting phenomenon has a structure usually including an anode, a cathode, and an organic material layer interposed therebetween.

In this regard, the organic material layer may have, for the most part, a multilayer structure consisting of different materials, for example, a hole injection layer, a hole transport layer, a light-emitting layer, an electron transport layer, and an electron injection layer in order to enhance the efficiency and stability of the organic light-emitting diode. In the organic light-emitting diode having such a structure, application of a voltage between the two electrodes injects a hole from the anode and an electron from the cathode to the organic layer. In the luminescent zone, the hole and the electron recombine to produce an exciton. When the exciton returns to the ground state from the excited state, the molecule of the organic layer emits light. Such an organic light-emitting diode is known to have characteristics such as self-luminescence, high luminance, high efficiency, low driving voltage, a wide viewing angle, high contrast, and high-speed response.

Materials used as organic layers in OLEDs may be divided according to functions into luminescent materials and charge transport materials, for example, a hole injection material, a hole transport material, an electron transport material, and an electron injection material. Electron blocking materials or hole blocking materials may be added as necessary.

In organic light emitting diodes (OLEDs), the most critical issues are lifespan and efficiency. As displays have become larger in area, resolving issues related to efficiency and lifespan has become imperative. Here, efficiency, lifespan, and driving voltage are interrelated; as efficiency increases, the driving voltage tends to decrease, and a lower driving voltage reduces Joule heating during operation, thereby decreasing crystallization of organic materials and ultimately extending the device lifespan.

However, simply improving the organic material layers does not necessarily maximize efficiency. This is because achieving both long lifespan and high efficiency requires an optimal combination of factors such as the energy levels and T1 values between the respective organic layers, as well as intrinsic material properties (e.g., mobility, interfacial characteristics).

In addition, to address the emission issue within the hole transport layer in recent OLEDs, it is essential to include an emitting-auxiliary layer between the hole transport layer and the emitting layer. At present, it is necessary to develop different emitting-auxiliary layers corresponding to each emitting layer (R, G, B).

Generally, in an OLED, electrons are transferred from the electron transport layer to the light-emitting layer, and holes are transferred from the hole transport layer to the light=emitting layer, where they recombine to form excitons.

However, materials used for the hole transport layer typically have low HOMO values and thus often exhibit low T1 values. As a result, excitons generated in the emitting layer can transfer to the hole transport layer, leading to charge imbalance within the emitting layer. This may cause unintended emission at the interface of the hole transport layer, which results in degraded color purity and efficiency of the organic light emitting diode, as well as a shortened lifespan.

To solve these problems, there is a strong need to develop an emitting-auxiliary layer that has a high T1 value and a HOMO energy level between those of the hole transport layer and the emitting layer.

As conventional art relating to OLEDs including such an emitting-auxiliary layer, Korean Patent No. 10-1455156 (issued October 27, 2014) discloses an OLED structure having an emitting-auxiliary layer between the hole transport layer and the light-emitting layer, the auxiliary layer having a HOMO energy level between those of the hole transport and emitting layers. In addition, Korean Patent publication No. 10-2022-0123954 A (September 13, 2022) discloses an OLED employing an amine compound having both a carbazole structure and a fluorene structure as the emitting-auxiliary layer material.

However, despite various attempts made in the related art, including those described above, to develop methods for fabricating OLEDs including an emitting-auxiliary layer, there remains a continued need to develop OLEDs that offer further improved light-emission efficiency and long lifespan properties simultaneously.

### [Related Art Document]

### [Patent Literature]

(Patent Literature 0001) Korean Patent No. 10-1455156 (October 27, 2014)
(Patent Literature 0002) Korean Patent Publication No. 10-2022-0123954 A (September 13, 2022)

### SUMMARY OF THE INVENTION

Accordingly, the present disclosure is to provide an organic light emitting diode (OLED) having low voltage, high efficiency, and long lifespan characteristics by respectively including compounds having specific structures in the emitting layer and the emitting-auxiliary layer of the OLED.

In order to achieve the goal, the present disclosure provides an organic light emitting diode including: a first electrode; a second electrode facing the first electrode; and an organic layer interposed between the first electrode and the second electrode, the organic layer including a light-emitting layer and an emitting-auxiliary layer,
wherein the emitting layer includes at least one amine compound represented by Chemical Formula 1, and the emitting-auxiliary layer includes at least one amine compound represented by Chemical Formula 2 or Chemical Formula 3: 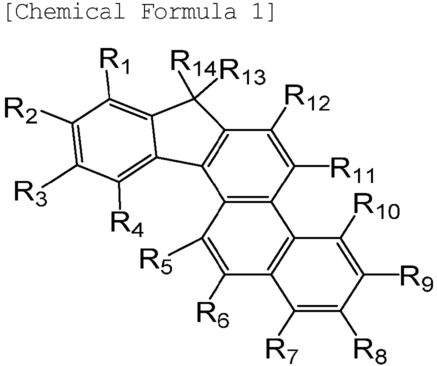 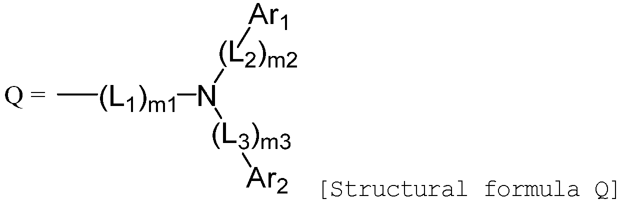 in Chemical Formula 1,
the substituents R₁ to R₄, which are same or different, are each independently one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₅ to R₁₂, which are same or different, are each independently one selected from among a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a substituted or unsubstituted a germanium of 0 to 40 carbon atoms, a nitro, a cyano, a halogen, and the structural formula **Q,**
one or two of the substituents R₅ to R₁₂ are single bonds connected to the linker L₁ or nitrogen atom (N) within the structural formula **Q,**
adjacent two of the substituents R₁ to R₁₂ may be linked to each other to form a aliphatic or aromatic single ring or polycyclic fused ring,
the substituents R₁₃ and R₁₄, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₁₃ and R₁₄ may be linked to each other to additionally form an aliphatic or aromatic mono- or polycyclic ring,
the linkers L₁ to L₃, which are same or different, are each independently a single bond or a linker selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
m1 to m3, which are same or different, are each independently 1 or 2, wherein when m1 is 2, the corresponding L₁ are same or different, when m2 is 2, the corresponding L₂ are same or different, and when m3 is 2, the corresponding L₃ are same or different,
Ar₁ and Ar₂, which are same or different, are each independently a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, and a substituted or unsubstituted aliphatic hydrocarbon ring-fused aryl of 8 to 30 carbon atoms; 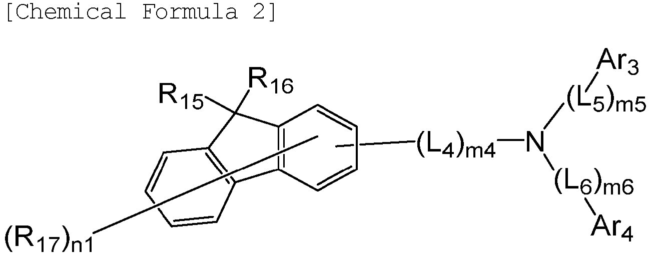 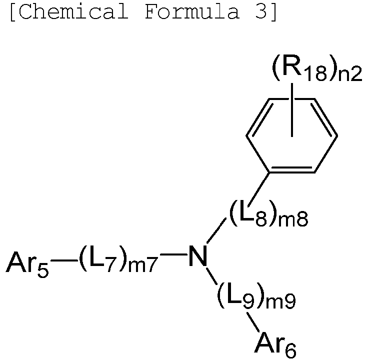 in Chemical Formula 2,
   the substituents R₁₅ and R₁₆, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
   the substituents R₁₅ and R₁₆ may be linked to each other to additionally form an aliphatic or aromatic mono- or polycyclic ring,
   the substituent R₁₇ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
   n1 is 7, wherein the corresponding R₁₇ are same or different,
   two adjacent substituents R₁₇ radicals may be linked to each other to additionally form an aliphatic or aromatic mono- or polycyclic ring,
   the linkers L₄ to L₆, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
   m4 to m6, which are same or different, are each independently 1 or 2, wherein when m4 is 2, the corresponding L₄ are same or different, when m5 is 2, the corresponding L₅ are same or different, and when m6 is 2, the corresponding L₆ are same or different,
   the substituents Ar₃ and Ar₄, which are same or different, are each independently any one selected from among a substituted or unsubstituted aryl of 6 to 50 carbon atoms, a substituted or unsubstituted cycloalkyl of 3 to 30 carbon atoms, and a substituted or unsubstituted aliphatic hydrocarbon ring-fused aryl of 8 to 30 carbon atoms; and
   in Chemical Formula 3,
      the substituent R₁₈ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
      n2 is 5, with the corresponding R₁₈ being same or different,
      wherein at least one of the five R₁₈ is a substituted or unsubstituted aryl of 6 to 20 carbon atoms,
      two adjacent substituents R₁₈ may be linked to each other to additionally form an aliphatic or aromatic mono- or polycyclic ring,
      the linkers L₇ to L₉, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
      m7 to m9, which are same or different, are each independently 1 or 2, wherein when m7 is 2, the corresponding L₇ radicals are same or different, when m8 is 2, the corresponding L8 are same or different, and when m9 is 2, the corresponding L₉ are same or different,
      the substituents Ar₅ and Ar₆, which are same or different, are each independently any one selected from among a substituted or unsubstituted aryl of 6 to 30 carbon atoms, a substituted or unsubstituted cycloalkyl of 3 to 30 carbon atoms, and a substituted or unsubstituted aliphatic hydrocarbon ring-fused aryl of 8 to 30 carbon atoms,
      wherein the term "substituted" in the expression "substituted or unsubstituted" used for the compounds of Chemical Formulas 1 to 3 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroaryl alkyl of 3 to 24 carbon atoms, an alkyl heteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a heteroaliphatic ring-fused aryl of 6 to 30 carbon atoms, a heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

The organic light emitting diode (OLED) according to the present disclosure can exhibit excellent device characteristics such as low driving voltage, high light-emission efficiency, and long lifespan.

In particular, when a compound represented by Chemical Formula 1, which is used in the light emitting layer of the OLED according to the present disclosure, and a compound represented by Chemical Formula 2 or Chemical Formula 3, which is used in the emitting-auxiliary layer, are used in combination, the OLED can exhibit characteristics of low driving voltage, high light-emission efficiency, and long lifespan.

### BRIEF DESCRIPTION OF THE DRAWINGS

The above and other aspects, features and advantages of the present disclosure will be more apparent from the following detailed description taken in conjunction with the accompanying drawings, in which:

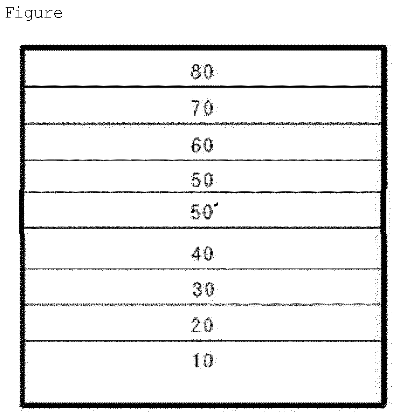

FIG. 1 is a schematic diagram of an organic light emitting diode according to some embodiments of the present disclosure.

### DETAILED DESCRIPTION OF THE EXEMPLARY EMBODIMENTS

Below, a detailed description will be given of the present disclosure. In each drawing of the present disclosure, sizes or scales of components may be enlarged or reduced from their actual sizes or scales for better illustration, and known components may not be depicted therein to clearly show features of the present disclosure. Therefore, the present disclosure is not limited to the drawings. When describing the principle of the embodiments of the present disclosure in detail, details of well-known functions and features may be omitted to avoid unnecessarily obscuring the presented embodiments.

In the drawing, for convenience of description, sizes of components may be exaggerated for clarity. For example, since sizes and thicknesses of components in drawings are arbitrarily shown for convenience of description, the sizes and thicknesses are not limited thereto. Furthermore, throughout the description, the terms "on" and "over" are used to refer to the relative positioning, and mean not only that one component or layer is directly disposed on another component or layer but also that one component or layer is indirectly disposed on another component or layer with a further component or layer being interposed therebetween. Also, spatially relative terms, such as "below", "beneath", "lower", and "between" may be used herein for ease of description to refer to the relative positioning.

Throughout the specification, when a portion may "include" a certain constituent element, unless explicitly described to the contrary, it may not be construed to exclude another constituent element but may be construed to further include other constituent elements. Further, throughout the specification, the word "on" means positioning on or below the object portion, but does not essentially mean positioning on the lower side of the object portion based on a gravity direction.

The present disclosure provides an organic light emitting diode including: a first electrode; a second electrode facing the first electrode; and an organic layer interposed between the first electrode and the second electrode, the organic layer including a light emitting layer and an emitting-auxiliary layer, wherein the light emitting layer includes at least one amine compound represented by Chemical Formula 1, and the emitting-auxiliary layer includes at least one amine compound represented by Chemical Formula 2 or 3: 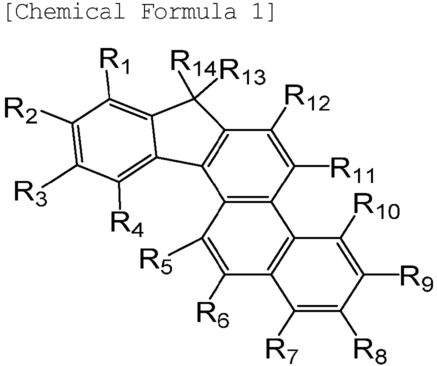 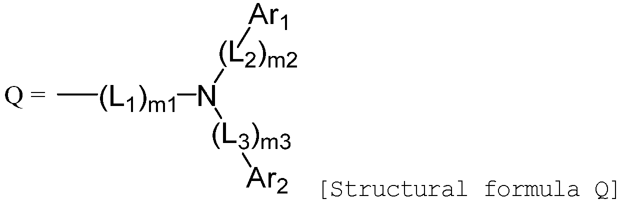 in Chemical Formula 1,
the substituents R₁ to R₄, which are same or different, are each independently one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₅ to R₁₂, which are same or different, are each independently one selected from among a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a substituted or unsubstituted a germanium of 0 to 40 carbon atoms, a nitro, a cyano, a halogen, and the structural formula Q,
one or two of the substituents R₅ to R₁₂ are single bonds connected to the linker L₁ or nitrogen atom (N) within the structural formula Q,
adjacent two of the substituents R₁ to R₁₂ may be linked to each other to form a aliphatic or aromatic single ring or polycyclic fused ring,
the substituents R₁₃ and R₁₄, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₁₃ and R₁₄ may be linked to each other to additionally form an aliphatic or aromatic mono- or polycyclic ring,
the linkers L₁ to L₃, which are same or different, are each independently a single bond or a linker selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
m1 to m3, which are same or different, are each independently 1 or 2, wherein when m1 is 2, the corresponding L₁ are same or different, when m2 is 2, the corresponding L2 are same or different, and when m3 is 2, the corresponding L₃ are same or different,
Ar₁ and Ar₂, which are same or different, are each independently a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, and a substituted or unsubstituted aliphatic hydrocarbon ring-fused aryl of 8 to 30 carbon atoms; 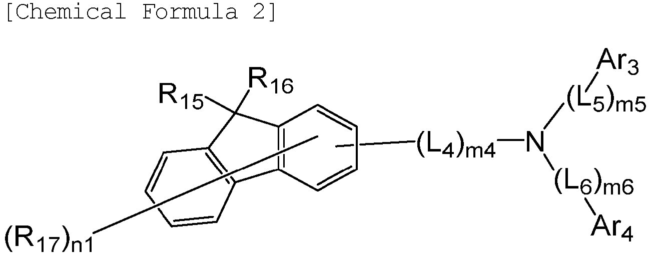 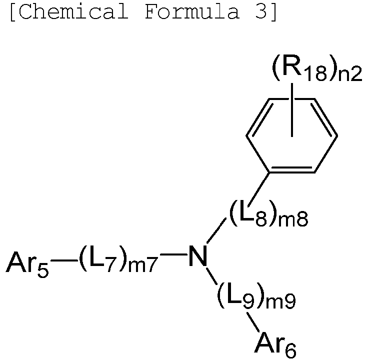 in Chemical Formula 2,
   the substituents R₁₅ and R₁₆, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
   the substituents R₁₅ and R₁₆ may be linked to each other to additionally form an aliphatic or aromatic mono- or polycyclic ring,
   the substituent R₁₇ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
   n1 is 7, wherein the corresponding R₁₇ are same or different,
   two adjacent substituents R₁₇ radicals may be linked to each other to additionally form an aliphatic or aromatic mono- or polycyclic ring,
   the linkers L₄ to L₆, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
   m4 to m6, which are same or different, are each independently 1 or 2, wherein when m4 is 2, the corresponding L₄ are same or different, when m5 is 2, the corresponding L₅ are same or different, and when m6 is 2, the corresponding L₆ are same or different,
   the substituents Ar₃ and Ar₄, which are same or different, are each independently any one selected from among a substituted or unsubstituted aryl of 6 to 50 carbon atoms, a substituted or unsubstituted cycloalkyl of 3 to 30 carbon atoms, and a substituted or unsubstituted aliphatic hydrocarbon ring-fused aryl of 8 to 30 carbon atoms; and
   in Chemical Formula 3,
      the substituent R₁₈ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
      n2 is 5, with the corresponding R₁₈ being same or different,
      wherein at least one of the five R₁₈ is a substituted or unsubstituted aryl of 6 to 20 carbon atoms,
      two adjacent substituents R₁₈ radicals may be linked to each other to additionally form an aliphatic or aromatic mono- or polycyclic ring,
      the linkers L₇ to L₉, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
      m7 to m9, which are same or different, are each independently 1 or 2, wherein when m7 is 2, the corresponding L₇ are same or different, when m8 is 2, the corresponding L₈ are same or different, and when m9 is 2, the corresponding L₉ are same or different,
      the substituents Ar₅ and Ar₆, which are same or different, are each independently any one selected from among a substituted or unsubstituted aryl of 6 to 30 carbon atoms, a substituted or unsubstituted cycloalkyl of 3 to 30 carbon atoms, and a substituted or unsubstituted aliphatic hydrocarbon ring-fused aryl of 8 to 30 carbon atoms,
      wherein the term "substituted" in the expression "substituted or unsubstituted" used for the compounds of Chemical Formulas 1 to 3 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroaryl alkyl of 3 to 24 carbon atoms, an alkyl heteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a heteroaliphatic ring-fused aryl of 6 to 30 carbon atoms, a heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

The expression indicating the number of carbon atoms, such as "a substituted or unsubstituted alkyl of 1 to 30 carbon atoms", "a substituted or unsubstituted aryl of 5 to 50 carbon atoms", etc. means the total number of carbon atoms of, for example, the alkyl or aryl radical or moiety alone, exclusive of the number of carbon atoms of substituents attached thereto. For instance, a phenyl group with a butyl at the para position falls within the scope of an aryl of 6 carbon atoms, even though it is substituted with a butyl radical of 4 carbon atoms.

As used herein, the term "aryl" means an organic radical derived from an aromatic hydrocarbon by removing one hydrogen that is bonded to the aromatic hydrocarbon. When the aryl group is substituted, the substituents may be fused with one another to form an additional ring. The aryl group may also include an organic radical obtained by the removal of a single hydrogen atom from an arene ring formed by the fusion of two arene rings.

Concrete examples of the aryl include aromatic radical groups such as phenyl, o-biphenyl, m-biphenyl, p-biphenyl, o-terphenyl, m-terphenyl, p-terphenyl, naphthyl, anthryl, phenanthryl, pyrenyl, indenyl, fluorenyl, tetrahydronaphthyl, perylenyl, chrysenyl, naphthacenyl, fluoranthenyl, and triphenylenyl, but are not limited thereto. The aryl group may also include organic radicals obtained by the removal of one hydrogen atom from a fused arene ring formed by two arene rings, such as a fluorene ring fused with a phenylene ring or a fluorene ring fused with a phenanthrene ring.

In addition, at least one hydrogen atom on the aryl group may be substituted by a deuterium atom, a tritium atom, a halogen atom, a hydroxy, a nitro, a cyano, a silyl, an amino, a germanium, an amidino, a hydrazino, a hydrazone, a carboxyl, a sulfonic acid, a phosphoric acid, an alkyl of 1 to 24 carbon atoms, a halogenated alkyl of 1 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, or an alkyl heteroaryl of 3 to 24 carbon atoms.

As used herein, the term "aromatic hydrocarbon ring" refers to an aromatic ring composed of carbon and hydrogen atoms and the term "aliphatic hydrocarbon ring" refers to a hydrocarbon ring that is composed of carbon and hydrogen atoms, but does not belong to the aromatic hydrocarbon rings. Particularly, the aliphatic hydrocarbon ring may have a bonding structure of the sp3 orbital for at least 30% of the carbon atoms as ring members, with 0 to 3 double and/or triple bonds within the ring. More particularly, the aliphatic hydrocarbon ring may have a bonding structure of the sp3 orbital for at least 50% of the carbon atoms as ring members, with 0 to 2 double and/or triple bonds within the ring.

As used herein, the term "aliphatic hydrocarbon ring-fused aryl" refers to a cyclic substituent having overall non-aromaticity, in which two adjacent carbon atoms of the aliphatic hydrocarbon ring are fused with two adjacent carbon atoms of the aryl ring, exclusive of the carbon atom that becomes an organic radical by removal of a hydrogen atom, to form a shared double bond. Specific examples include tetrahydronaphthyl, tetrahydrobenzocycloheptene, tetrahydrophenanthrenyl, tetrahydroanthracenyl, octahydrotriphenylenyl, and the like, but are not limited thereto.

The substituent "heteroaryl", used in the compound of the present disclosure, means a hetero aromatic radical of 2 to 24 carbon atoms, bearing as ring member(s) one to three heteroatoms selected from among N, O, P, Si, S, Ge, Se, and Te. In the aromatic radical, two or more rings may be fused. One or more hydrogen atoms on the heteroaryl may be substituted by the same substituents as on the aryl.

Concrete examples of the heteroaryl include thiophenyl, furanyl, pyrrolyl, imidazolyl, thiazolyl, oxazolyl, oxadiazolyl, triazolyl, pyridyl, bipyridyl, pyrimidinyl, triazinyl, acridinyl, carbolinyl, acenaphthoquinoxalinyl, indenoquinazolinyl, indenoisoquinolinyl, indenoquinolinyl, pyridoindolyl, pyridazinyl, pyrazinyl, quinolinyl, quinazolinyl, quinoxalinyl, phthalazinyl, pyridopyrimidinyl, pyridopyrazinyl, pyrazinopyrazinyl, isoquinolinyl, indolyl, carbazolyl, benzoxazolyl, benzimidazolyl, benzothiazolyl, benzocarbazolyl, benzofuranyl, benzothiophenyl, benzoselenophenyl, dibenzothiophenyl, dibenzofuranyl, dibenzoselenophenyl, phenanthrolinyl, thiazolinyl, isoxazolyl, thiadiazolyl, phenoxazinyl, phenothiazinyl, azadibenzofuranyl, azadibenzothiophenyl, azadibenzoselenophenyl, indolocarbazolyl, and the like, but are not limited thereto.

In addition, the term "heteroaromatic ring", as used herein, refers to an aromatic hydrocarbon ring bearing at least one heteroatom as an aromatic ring member. In the heteroaromatic ring, one to three carbon atoms of the aromatic hydrocarbon may be substituted by at least one selected particularly from N, O, P, Si, S, Ge, Se, and Te.

As used herein, the term "aliphatic hydrocarbon ring-fused heteroaryl" refers to the same cyclic substituent as in the aliphatic hydrocarbon ring-fused aryl, with the exception that a heteroaryl, instead of an aryl, is substituted. Specific examples include, but are not limited to, tetrahydroindole, tetrahydrobenzofuranyl, tetrahydrobenzothiophene, tetrahydrocarbazole, tetrahydrodibenzofuranyl, tetrahydroquinoline, and tetrahydroquinoxaline.

As used herein, the term "fused ring in which an aromatic hydrocarbon ring is fused with an aliphatic hydrocarbon ring" means a fused ring in which an aromatic hydrocarbon ring has two adjacent carbon atoms in common with an aliphatic hydrocarbon ring, as exemplified by a tetrahydronaphthalene ring in which the benzene ring shares two adjacent carbon atoms with the cyclohexane ring or by dihydroindene ring.

In addition, the "fused ring of a heteroaromatic ring and an aliphatic hydrocarbon ring," as used herein, refers to a fused ring in which a heteroaromatic ring has two adjacent carbon atoms in common with an aliphatic hydrocarbon ring, as exemplified by hexahydrodibenzofuran ring in which the benzofuran ring shares two adjacent carbon atoms with the cyclohexane ring.

As used herein, the term "alkyl" refers to an alkane missing one hydrogen atom and includes linear or branched structures. Examples of the alkyl substituent useful in the present disclosure include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cycloheptylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 4-methylhexyl, and 5-methylhexyl, but are not limited thereto. At least one hydrogen atom of the alkyl may be substituted by the same substituent as in the aryl.

As used herein, the term "halogenated alkyl" refers to an alkyl with at least one hydrogen atom substituted by a halogen. Preferably, the halogen may be a fluorine atom.

The term "cyclo" as used in substituents of the compounds of the present disclosure, such as cycloalkyl, cycloalkoxy, etc., refers to a structure responsible for a mono- or polycyclic ring of saturated hydrocarbons within an alkyl radical, an alkoxy radical, etc. Concrete examples of cycloalkyl include cyclopropyl, cyclobutyl, cyclopentyl, cyclohexyl, methylcyclopentyl, methylcyclohexyl, ethylcyclopentyl, ethylcyclohexyl, adamantyl, dicyclopentadienyl, decahydronaphthyl, norbornyl, bornyl, isobornyl, and so on. One or more hydrogen atoms on the cycloalkyl may be substituted by the same substituents as on the aryl. This is true of the cycloalkoxy.

In the present disclosure, the term "heterocycloalkyl" refers to a cycloalkyl with at least one heteroatom substituted as a ring member for a carbon atom within the ring. Preferably, one to three carbon atoms within the ring may be substituted by at least one selected from N, O, P, S, Si, Ge, Se, and Te.

In addition, the term "aromatic hydrocarbon ring- or heteroaromatic ring-fused cycloalkyl" refers to a cyclic substituent having overall non-aromaticity, in which two adjacent carbon atoms of the aliphatic hydrocarbon ring or heteroaromatic ring are fused with two adjacent carbon atoms of the cycloaryl ring, exclusive of the carbon atom that becomes an organic radical by removal of a hydrogen atom, to form a shared double bond. Specific examples include tetrahydronaphthyl, tetrahydrophenanthrene, tetrahydroquinoline, tetrahydroquinoxaline, cyclopentabenzofuran, and the like, but are not limited thereto.

Furthermore, the term "aromatic hydrocarbon ring-fused heterocycloalkyl" has the same meaning as the aromatic hydrocarbon ring-fused cycloalkyl, except for the cycloalkyl ring moiety having at least one heteroatom as a ring member, with non-aromaticity across the molecule thereof. Preferably, one to three carbon atoms within the cycloalkyl ring moiety are substituted by at least one heteroatom selected from among N, O, P, S, Si, Ge, Se, and Te. Specific examples include hexahydrodibenzofuranyl, hexahydrocarbazole, hexahydrodibenzothiophene, and dihydrobenzodioxin, but are not limited thereto.

As used herein, the "heteroaliphatic ring-fused aryl or heteroaryl" is same as the aliphatic hydrocarbon ring-fused aryl or heteroaryl, except for a heteroaliphatic ring substituted for the aliphatic hydrocarbon ring, with non-aromaticity across the molecule thereof. Concrete examples include cromane, dihydropyranopyridine, thiocromane, dihydrobenzodioxine, dihydrothiopyranopyridine, and dihydropyranopyrimidine.

The term "heteroaliphatic ring" refers to an aliphatic hydrocarbon bearing at least one heteroatom as a ring member. Preferably, one to three carbon atoms within an aliphatic hydrocarbon are substituted by at least one heteroatom selected from N, O, and S.

The term "alkoxy," as used in the compounds of the present disclosure, refers to an alkyl or cycloalkyl singularly bonded to oxygen. Concrete examples of the alkoxy include methoxy, ethoxy, propoxy, isobutoxy, sec-butoxy, pentoxy, iso-amyloxy, hexyloxy, cyclobutyloxy, cyclopentyloxy, adamantyloxy, dicyclopentyloxy, bornyloxy, isobornyloxy, and the like, but are not limited thereto. One or more hydrogen atoms on the alkoxy may be substituted by the same substituents as on the aryl.

Concrete examples of the arylalkyl used in the compounds of the present disclosure include phenylmethyl (benzyl), phenylethyl, phenylpropyl, naphthylmethyl, naphthylethyl, and the like, but are not limited thereto. One or more hydrogen atoms on the arylalkyl may be substituted by the same substituents as on the aryl.

Concrete examples of the alkylaryl used in the compound of the present disclosure include tolyl, xylenyl, dimethylnaphthyl, t-butylphenyl, t-butylnaphthyl, and t-butylphenanthryl, but are not limited thereto. One or more hydrogen atoms on the alkylaryl may be substituted by the same substituents as on the aryl.

As used herein, the term "alkenyl" refers to an alkyl substituent containing a carbon-carbon double bond between two carbon atoms and the term "alkynyl" refers to an alkyl substituent containing a carbon-carbon triple bond between two carbon atoms.

As used herein, the term "alkylene" refers to an organic radical regarded as derived from an alkane by removal two hydrogen atoms from one carbon atom for methylene or different carbon atoms for ethylene or higher, such as propylene, isopropylene, isobutylene, sec-butylene, tert-butylene, pentylene, iso-amylene, hexylene, and the like, but with no limitations thereto. One or more hydrogen atoms on the alkylene may be substituted by the same substituents as on the aryl.

In the present disclosure, the term "amine" refers to a functional group including -NH₂, in which one or two of the hydrogen atoms in -NH₂ are substituted by any one selected from among alkyl, cycloalkyl, aryl, aliphatic hydrocarbon ring-fused aryl, arylalkyl, alkylaryl, heteroaryl, and aliphatic hydrocarbon ring-fused heteroaryl. When both the hydrogen atoms bonded to the nitrogen atom in -NH₂ are substituted by the foregoing substituents, they may be same or different. One or more hydrogen atoms on the alkyl, cycloalkyl, aryl, aliphatic hydrocarbon ring-fused aryl, arylalkyl, alkylaryl, heteroaryl, or aliphatic hydrocarbon ring-fused heteroaryl may be substituted by the same substituents as on the aryl.

Each of the aryl radicals in the aryl, arylheteroaryl, aliphatic hydrocarbon ring-fused aryl, and cycloalkylaryl bonded to the nitrogen atom in the amine may be a monocyclic or polycyclic one. Each of the heteroaryl radicals in the heteroarylamine, and arylheteroarylamine may be a mono- or polycyclic one.

Examples of the amine include an alkylamine in which one or two alkyl radicals, which are same or different, are bonded to the nitrogen atom; an arylamine in which one or two aryl radicals, which are same or different, are bonded to the nitrogen atom; and an alkylaryl amine in which one alkyl radical and one aryl radical are bonded to the nitrogen atom. In addition, heteroaryl amine, aryl heteroaryl amine, alkyl (aliphatic hydrocarbon ring-fused aryl) amine, aryl (aliphatic hydrocarbon-fused aryl) amine, cycloalkyl (aliphatic hydrocarbon ring-fused aryl)amine, cycloalkyl arylamine, heteroaryl (aliphatic hydrocarbon ring-fused aryl)amine are also exemplified.

The silyl used in the compounds of the present disclosure refers to a functional group based on -SiH3 in which at least one of the three hydrogen atoms bonded to the silicon atom is substituted by any one selected from among alkyl, cycloalkyl, aryl, aliphatic hydrocarbon ring-fused aryl, arylalkyl, alkylaryl, heteroaryl, aliphatic hydrocarbon ring-fused heteroaryl. Two or three substituents, when used to substitute two or three hydrogen atoms bonded to the silicon atom in -SiH3, may be same or different. One or more hydrogen atoms on the alkyl, cycloalkyl, aryl, aliphatic hydrocarbon ring-fused aryl, aryl alkyl, alkyl aryl, heteroaryl, and aliphatic hydrocarbon ring-fused heteroaryl may be substituted by the same substituents as on the aryl.

Here, each of the aryl radicals in the aryl, aryl heteroaryl, aliphatic hydrocarbon ring-fused aryl, cycloalkyl aryl, etc. which are bonded to the silicon atom in the silyl may be a mono- or polycyclic aryl. Also, each of the heteroaryl radicals in the heteroaryl, aryl heteroaryl, etc. may be mono- or polycyclic heteroaryl.

Examples of the silyl include alkylsilyl in which one or two or three same or different alkyl radicals are bonded to the silicon atom, arylsilyl in which one or two or three same or different aryl radicals are bonded to the silicon atom, alkylaryl silyl in which one alkyl radical and one aryl radical are bonded to the silicon atom, and alkylaryl heteroaryl silyl in which one alkyl radical, one aryl radical, and one heteroaryl radical are bonded to the silicon atom. In addition, alkyl(heteroaryl)silyl, arylheteroarylsilyl, alkyl(aliphatic hydrocarbon ring-fused aryl)silyl, alkyl(aryl) (aliphatic hydrocarbon ring-fused aryl)silyl, cycloalkyl(aliphatic hydrocarbon ring-fused aryl)silyl, cycloalkyl arylheteroarylsilyl, and alkyl(heteroaryl)(aliphatic hydrocarbon ring-fused aryl)silyl may be exemplified.

Furthermore, specific examples of the silyl include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

As used herein, the term "germanium" (or germyl or germane) can be accounted for by the definitions for silyl radicals, with the exception that the silicone atom (Si) in the silyl radical is substituted by a germanium atom (Ge).

Concrete examples of the germanium radical include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more hydrogen atoms on the germanium radical may be substituted by the same substituents as on the aryl.

As used herein, the substituent (B) adjacent to a substituent (A) within an aromatic ring means a substituent (B) bonded to a carbon atom(s) as a ring member(s) adjacent to a carbon atom as a ring member having the substituent (A) bonded thereto, within the aromatic ring. Also, the substituent (B) adjacent to a substituent (A) within an aliphatic ring means a substituent (B) bonded to a carbon atom(s) as a ring member(s) adjacent to a carbon atom as a ring member having the substituent (A) bonded thereto, within the aliphatic ring. Further, the substituent (B) adjacent to a substituent (A) within an aliphatic chain structure means a substituent (B) bonded to a carbon atom(s) as a ring member(s) adjacent to a carbon atom as a ring member having the substituent (A) bonded thereto, within the aliphatic chain structure.

In a preferable embodiment, the substituent accounted for by the term "substituted" in the expression "substituted or unsubstituted" used for compounds of Chemical Formulas 1 to 3 may be at least one selected from the group consisting of a deuterium atom, a tritium atom, a cyano, a halogen, a hydroxy, a nitro, an alkyl of 1 to 12 carbon atoms, a halogenated alkyl of 1 to 12 carbon atoms, an alkenyl of 2 to 12 carbon atoms, an alkynyl of 2 to 12 carbon atoms, a cycloalkyl of 3 to 12 carbon atoms, a heteroalkyl of 1 to 12 carbon atoms, an aryl of 6 to 18 carbon atoms, an arylalkyl of 7 to 20 carbon atoms, an alkylaryl of 7 to 20 carbon atoms, a heteroaryl of 2 to 18 carbon atoms, a heteroarylalkyl of 3 to 18 carbon atoms, an alkyl heteroaryl of 3 to 18 carbon atoms, an aromatic hydrocarbon ring-fused cycloalkyl of 9 to 20 carbon atoms, a heteroaromatic ring-fused cycloalkyl of 7 to 20 carbon atoms, an aromatic hydrocarbon ring-fused heterocycloalkyl of 9 to 20 carbon atoms, an aliphatic hydrocarbon ring-fused aryl of 9 to 20 carbon atoms, an aliphatic hydrocarbon ring-fused heteroaryl of 7 to 20 carbon atoms, an alkoxy of 1 to 12 carbon atoms, an amine of 1 to 18 carbon atoms, a silyl of 1 to 18 carbon atoms, a germanium of 1 to 18 carbon atoms, an aryloxy of 6 to 18 carbon atoms, and an arylthionyl of 6 to 18 carbon atoms 6. The substituent may have a deuterium or tritium atom, instead of at least one hydrogen atom, bonded thereto.

In a more preferable embodiment of the present disclosure, the substituted or unsubstituted aromatic hydrocarbon ring-fused cycloalkyl of 7 to 30 carbon atoms may be a substituted or unsubstituted aromatic hydrocarbon ring-fused cycloalkyl of 9 to 20 carbon atoms.

In a more preferable embodiment of the present disclosure, the substituted or unsubstituted heteroaromatic ring-fused cycloalkyl of 5 to 30 carbon atoms may be a substituted or unsubstituted heteroaromatic ring-fused cycloalkyl of 7 to 20 carbon atoms.

In a more preferable embodiment of the present disclosure, the substituted or unsubstituted aromatic hydrocarbon ring-fused heterocycloalkyl of 6 to 30 carbon atoms may be a substituted or unsubstituted aromatic hydrocarbon ring-fused heterocycloalkyl of 9 to 20 carbon atoms.

In a more preferable embodiment of the present disclosure, the substituted or unsubstituted aliphatic hydrocarbon ring-fused aryl of 8 to 30 carbon atoms may be a substituted or unsubstituted aliphatic hydrocarbon ring-fused aryl of 9 to 20 carbon atoms.

In a more preferable embodiment of the present disclosure, the substituted or unsubstituted aliphatic hydrocarbon ring-fused heteroaryl of 5 to 30 carbon atoms may be a substituted or unsubstituted aliphatic hydrocarbon ring-fused heteroaryl of 7 to 20 carbon atoms.

In a more preferable embodiment of the present disclosure, the substituted or unsubstituted heteroaliphatic ring-fused aryl of 6 to 30 carbon atoms may be a substituted or unsubstituted heteroaliphatic ring-fused aryl of 7 to 20 carbon atoms.

In a more preferable embodiment of the present disclosure, the substituted or unsubstituted heteroaliphatic ring-fused heteroaryl of 5 to 30 carbon atoms may be a substituted or unsubstituted heteroaliphatic ring-fused heteroaryl of 6 to 20 carbon atoms.

The present disclosure is technically characterized by the use of an amine compound represented by Chemical Formula 1 as the light-emitting layer material in the organic light emitting diode, and the use of an amine compound represented by Chemical Formula 2 or Chemical Formula 3 as the emitting-auxiliary layer material. In this regard, in the amine compound represented by Chemical Formula 1, one or two of the substituents R₅ to R₁₂ located on the phenanthrene ring moiety of the indeno-phenanthrene ring structure are connected to an amine group represented by the structure Q. In the structure where an amine group is bonded to the indeno-phenanthrene ring, the nitrogen atom of the amine group represented by Q causes localization of the intramolecular electron distribution. However, by introducing a substituent such as an aryl or heteroaryl group to the amine group, the electron distribution becomes delocalized, resulting in enhanced stability and improved lifespan. Therefore, an OLED exhibiting higher efficiency and longer lifespan than conventional OLEDs can be realized.

In recent OLEDs, as described above, it is preferable to form an emitting-auxiliary layer between the hole transport layer and the light-emitting layer in order to solve the emission issue occurring in the hole transport layer. Furthermore, it may be necessary to develop different emitting-auxiliary layers corresponding to each emitting layer (R, G, B).

Accordingly, in the present disclosure, by using an amine compound represented by Chemical Formula 1 as the light-emitting layer material and forming an emitting-auxiliary layer using an amine compound represented by Chemical Formula 2 or Chemical Formula 3, it is possible to optimize the energy levels and T1 values between the organic material layers, as well as the intrinsic properties of the materials (e.g., mobility, interfacial characteristics), thereby improving both the lifespan and efficiency of the organic light-emitting diode.

To achieve the goal, in the organic light-emitting diode according to the present disclosure, the amine compound represented by Chemical Formula 2, when used as the emitting-auxiliary layer material, is characterized in that one carbon atom of the benzene rings at either end of the fluorene ring is bonded to the linker L₄ or nitrogen atom (N) within the amine group ( 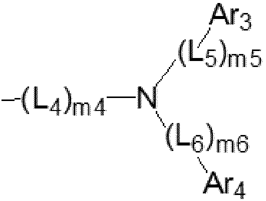 ) . In addition, the amine compound represented by Chemical Formula 3, when used as the emitting-auxiliary layer material, is characterized in that one carbon atom of the benzene ring containing substituent R₁₈ is bonded to the linker L8 or nitrogen atom (N) within the amine group ( 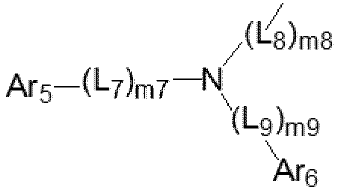 ).

In addition, the amine compound represented by Chemical Formula 1, which is used as the emitting layer material in the organic light emitting diode according to the present disclosure, is preferably one of the amine compounds represented by Chemical Formulas 1-1 to 1-4. 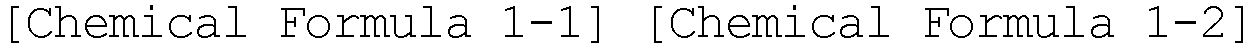 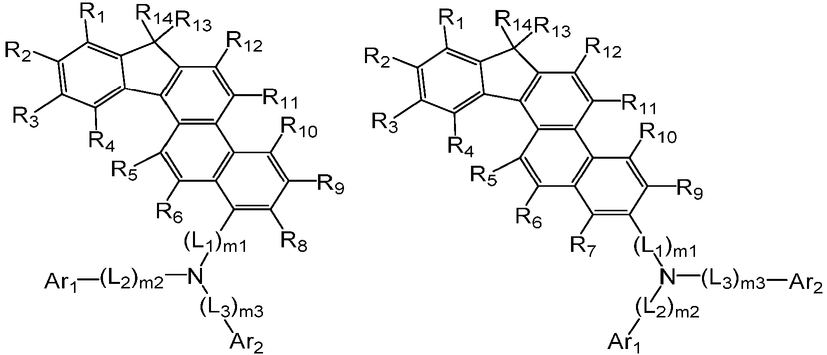 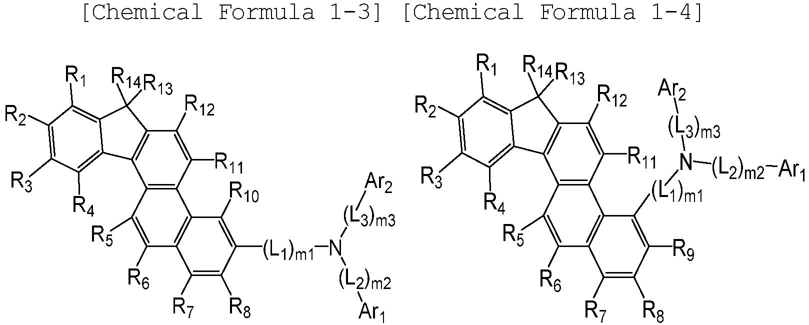 wherein,
the substituents R₁ to R₁₂, which are same or different, are each independently a hydrogen atom or a deuterium atom,
the substituents R₁₃ and R₁₄, which are same or different, are each independently any one selected from among a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the linkers L₁ to L₃, which are same or different, are each independently a single bond or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
the substituents Ar₁ and Ar₂, which are same or different, are each independently any one selected from a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, and a substituted or unsubstituted aliphatic hydrocarbon ring-fused aryl of 8 to 30 carbon atoms, either or both of Ar₁ and Ar₂ being a substituted or unsubstituted heteroaryl of 3 to 30 carbon atoms,
m1 to m3 are each 1 or 2, wherein when m1 is 2, the corresponding L₁ radicals are same or different, when m2 is 2, the corresponding L2 radicals are same or different, and when m3 is 2, the corresponding L₃ are same or different,
adjacent two of the substituents R₁ to R₁₂ are linked to each other to additionally form an aliphatic or aromatic mono- or polycyclic ring, and
R₁₃ and R₁₄ are connected to each other to additionally form an aliphatic or aromatic mono- or polycyclic ring,
wherein the term "substituted" in the expression "substituted or unsubstituted" used for the compounds of Chemical Formulas 1-1 to 1-4 is as defined above.

In an embodiment, at least one of Ar₁ and Ar₂ in Chemical Formula 1 may be a substituted or unsubstituted heteroaryl of 4 to 20 carbon atoms bearing an oxygen atom (O) or sulfur atom (S), preferably a substituted or unsubstituted heteroaryl of 4 to 20 carbon atoms bearing only one or two oxygen atoms (O), or a substituted or unsubstituted heteroaryl of 4 to 20 carbon atoms bearing only one or two sulfur atoms (S).

In an embodiment, in Chemical Formulas 1 and 2, R₁₃ to R₁₆, which are same or different, may each be independently a substituted or unsubstituted alkyl of 1 to 10 carbon atoms.

In an embodiment, at least one of Ar₃ and Ar₄ in Chemical Formula 2 may be a substituted or unsubstituted cycloalkyl of 4 to 20 carbon atoms. In this regard, in Chemical Formula 2, Ar₃ and Ar₄, which are same or different, may each be independently a substituted or unsubstituted cycloalkyl of 4 to 20 carbon atoms.

In an embodiment, when at least one of Ar₃ and Ar₄ in Chemical Formula 2 is a substituted or unsubstituted cycloalkyl of 4 to 20 carbon atoms, the ring structure in the substituted or unsubstituted cycloalkyl of 4 to 20 carbon atoms may be any one selected from among the following Structural Formulas 1 to 6:

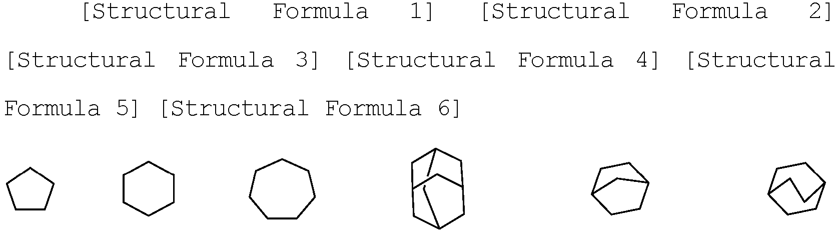

In Structural Formulas 1 to 6, one hydrogen atom within the ring structures is removed, and the carbon atom in the ring structure that was bonded to the removed hydrogen is bonded to a linker L5 or L₆ or a nitrogen atom (N) within Chemical Formula 2.

In an embodiment, Ar₅ and Ar₆ in Chemical Formula 3 are same or different and may each be independently a substituted or unsubstituted aryl of 6 to 20 carbon atoms.

In an embodiment, R₁₇ within Chemical Formula 2, which are same or different, may each be independently a hydrogen atom or deuterium atom.

In an embodiment, concrete examples of the amine compound represented by Chemical Formula 1 include the following [Compound 1-1] to [Compound 1-120]:

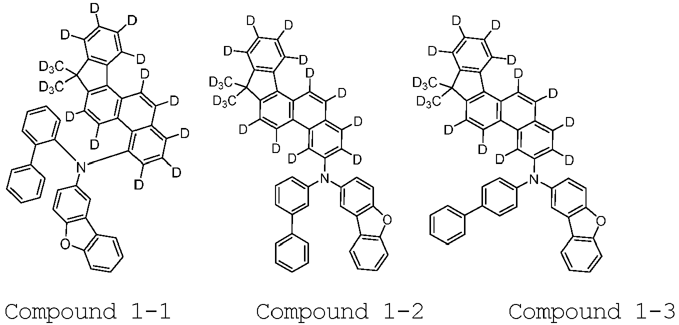

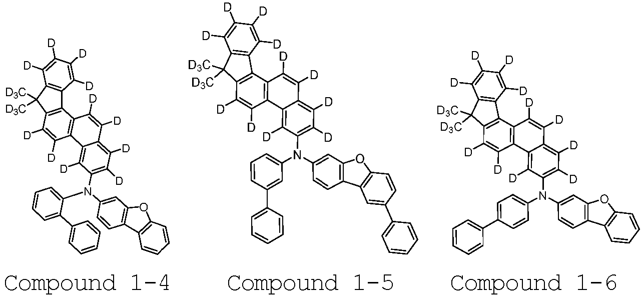

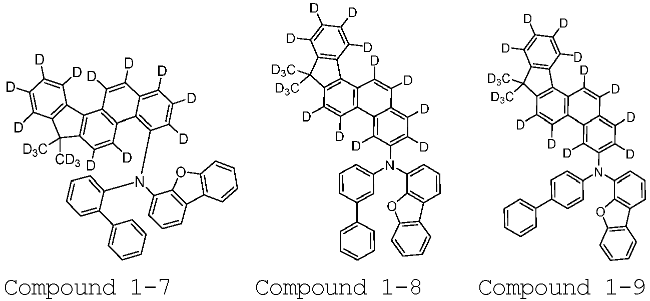

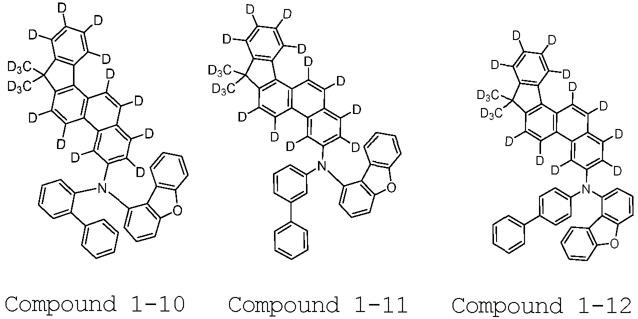

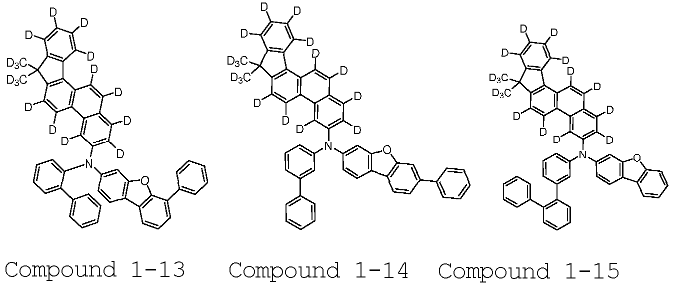

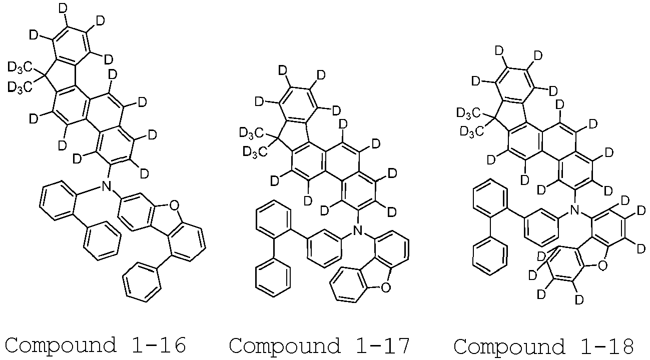

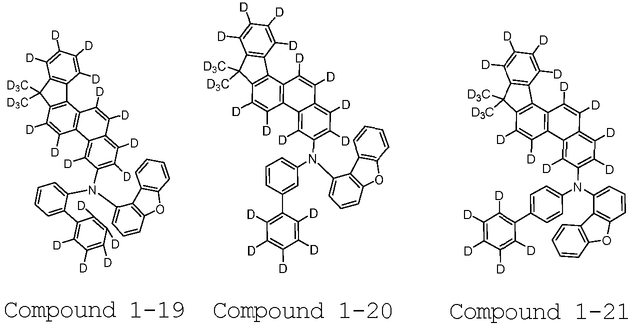

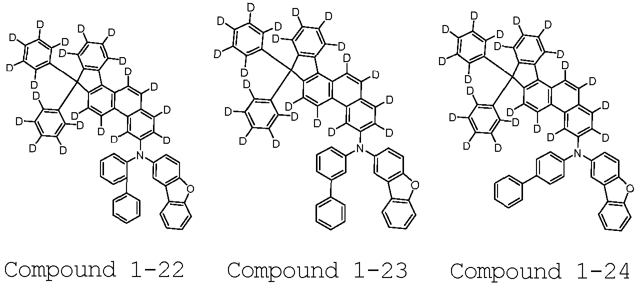

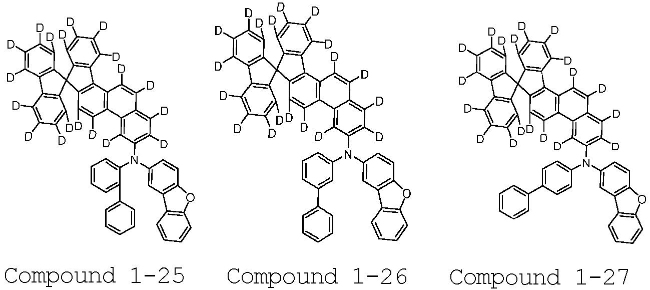

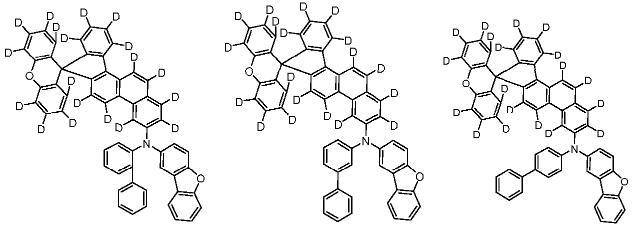

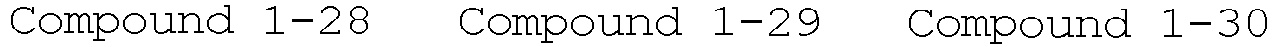

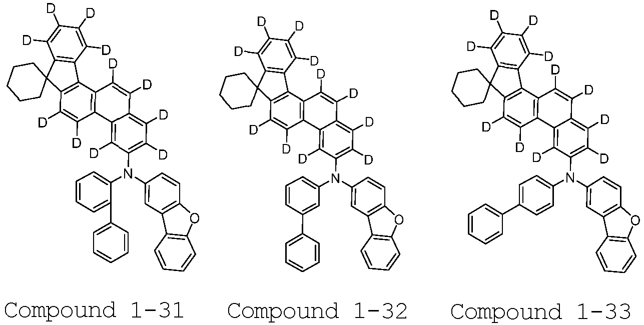

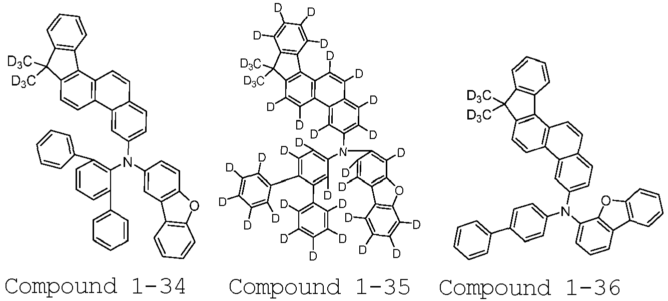

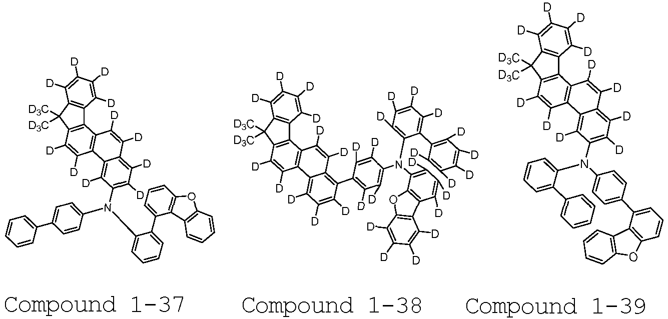

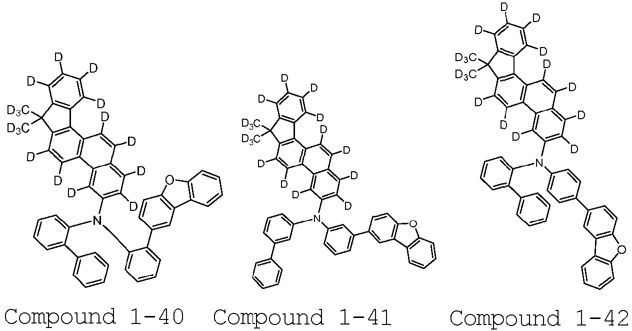

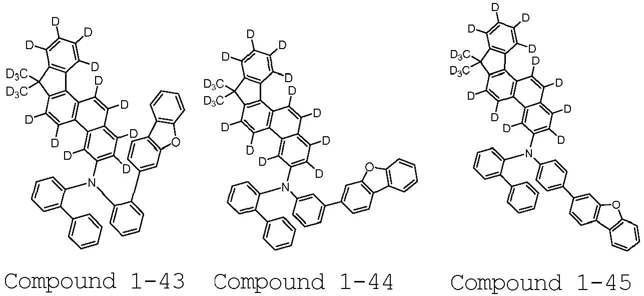

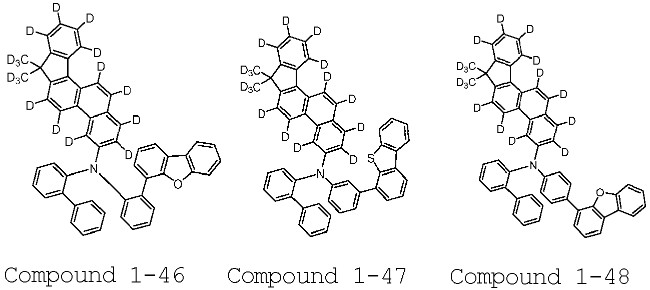

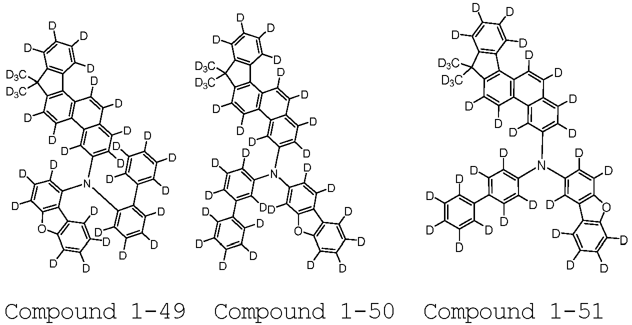

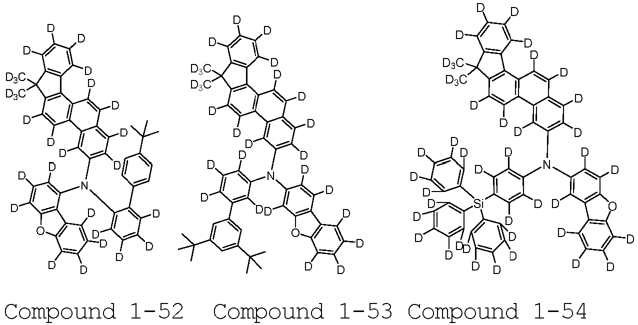

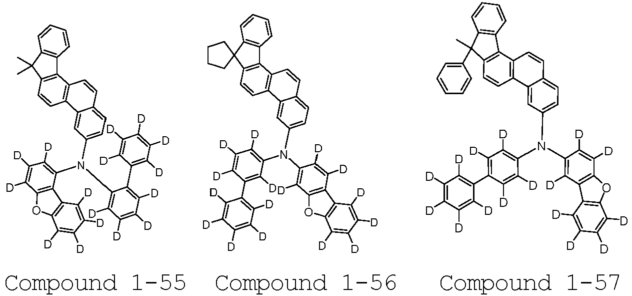

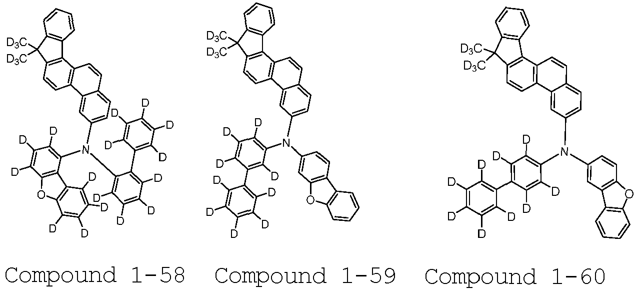

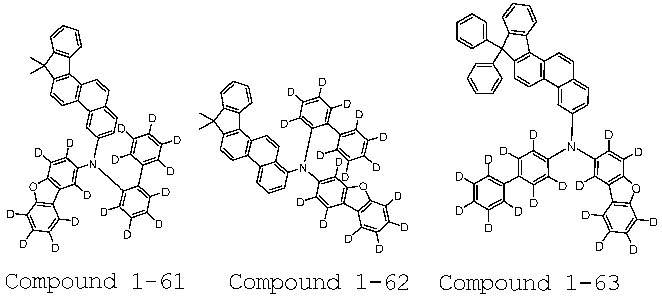

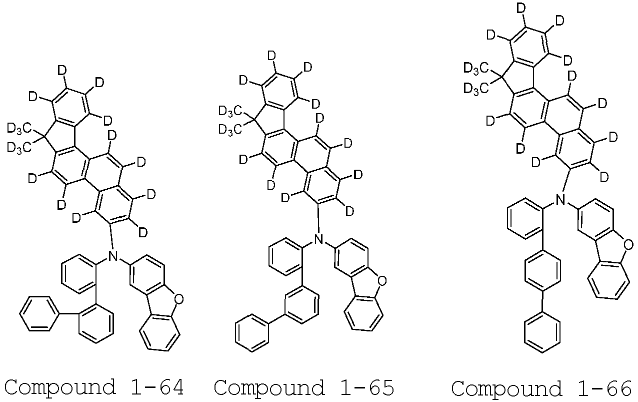

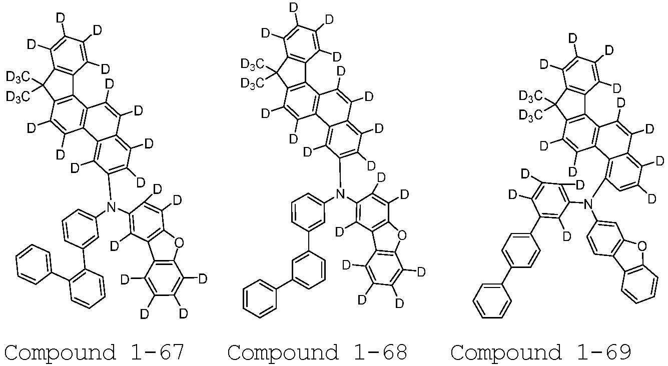

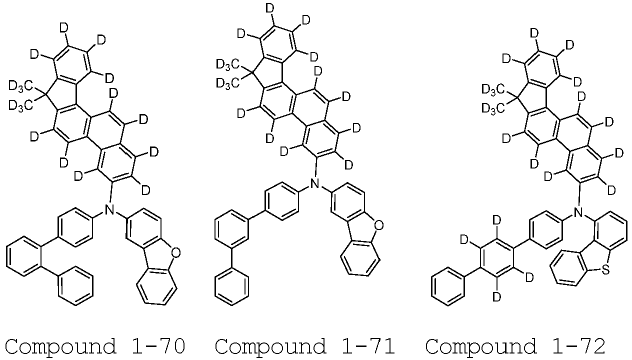

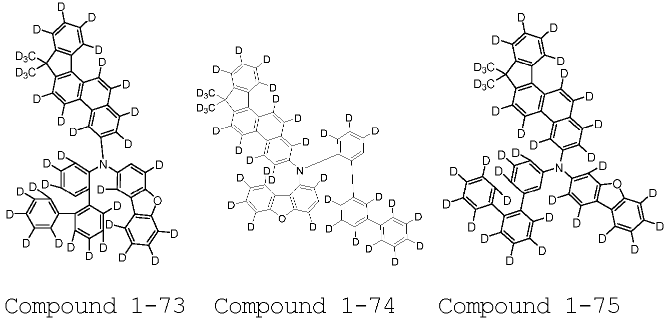

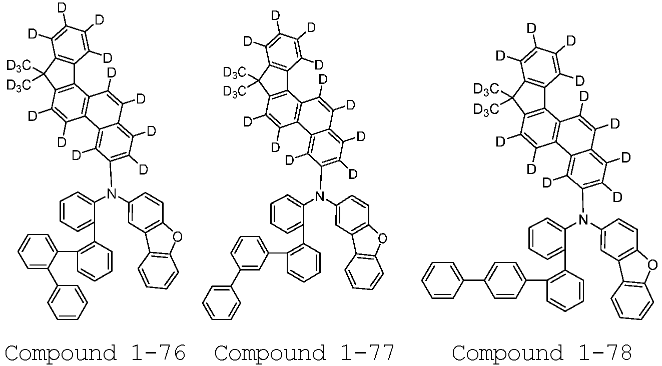

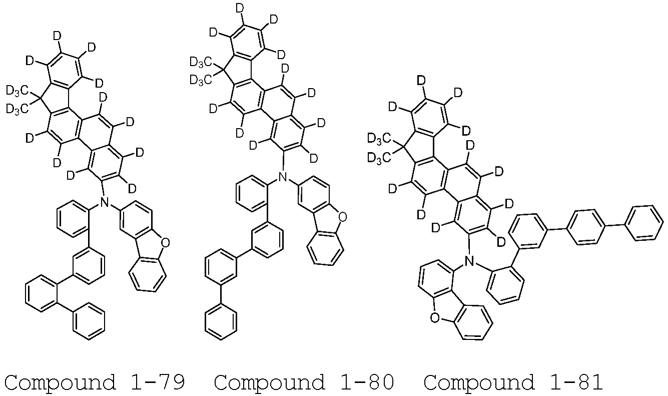

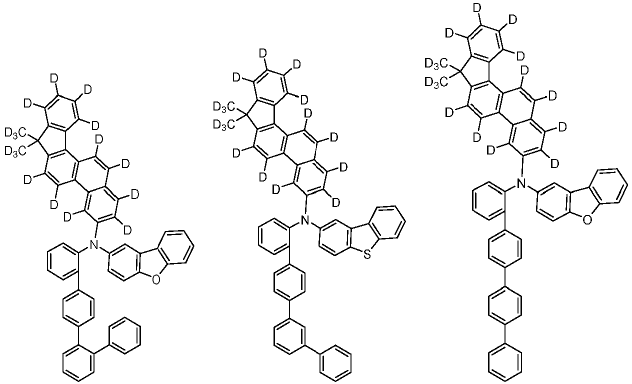

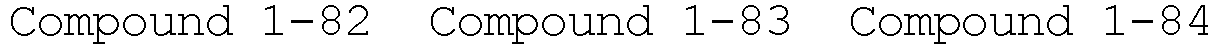

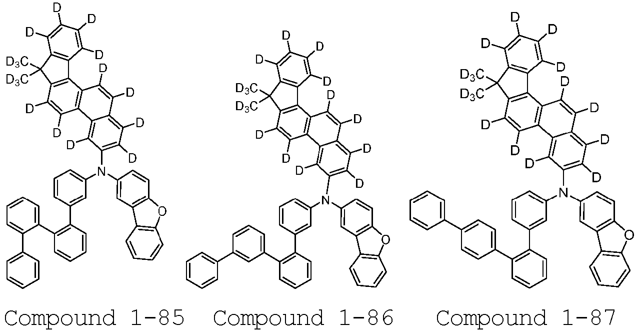

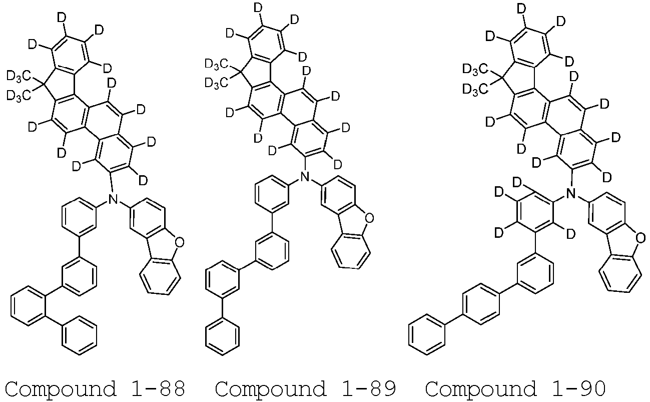

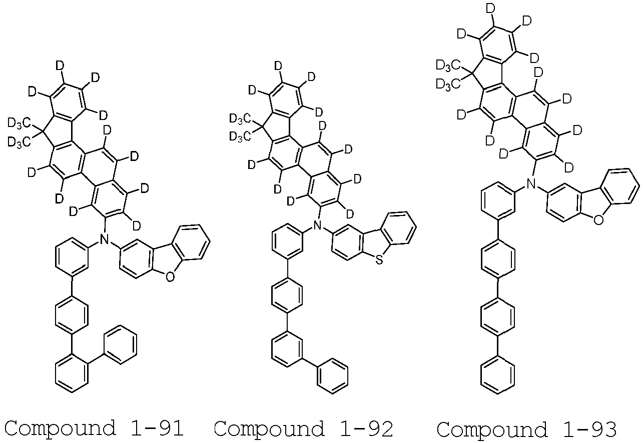

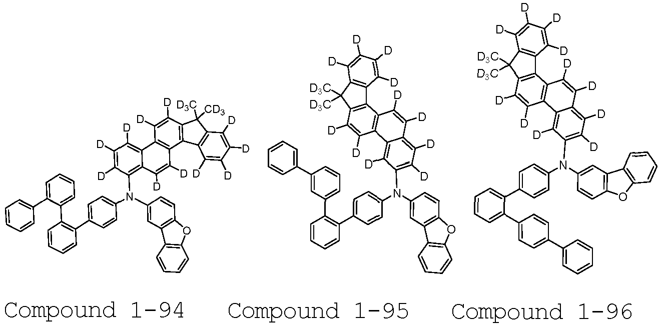

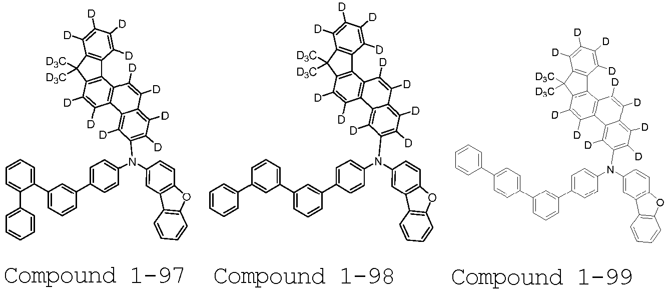

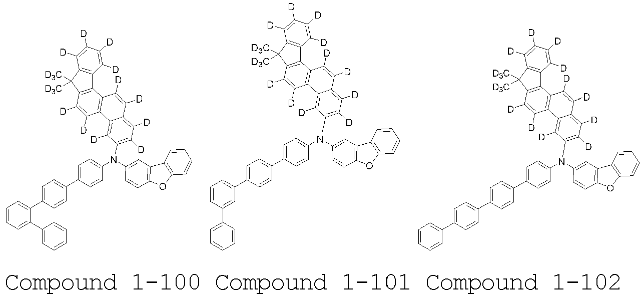

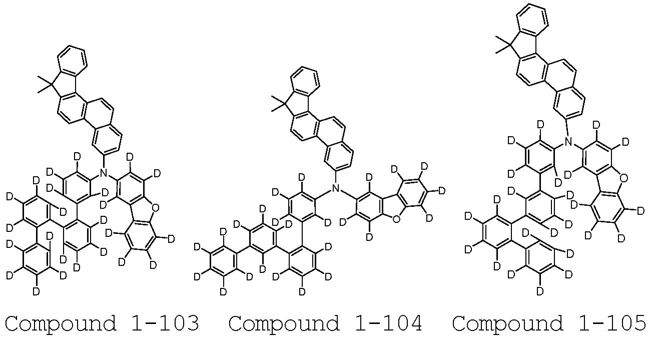

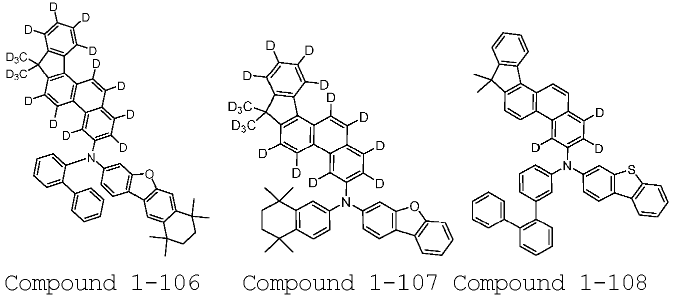

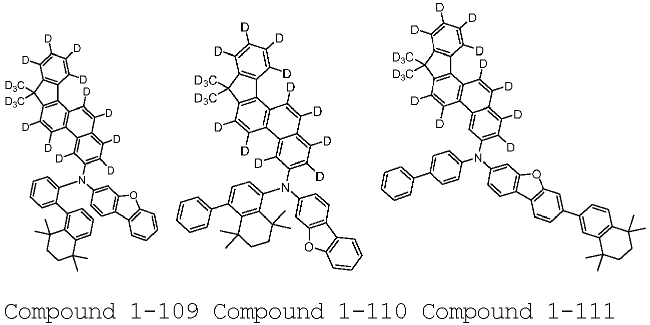

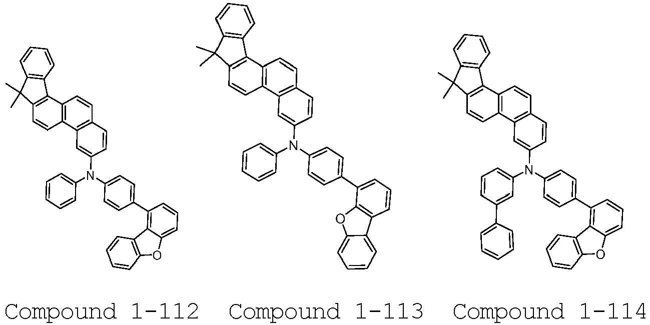

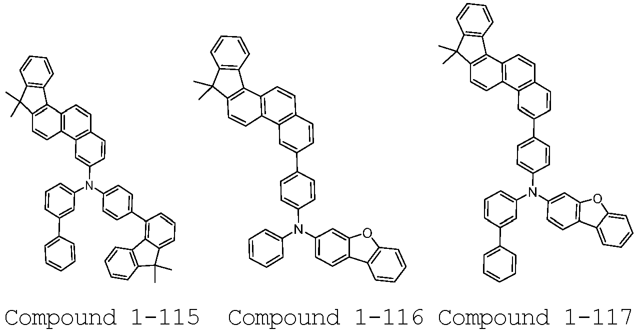

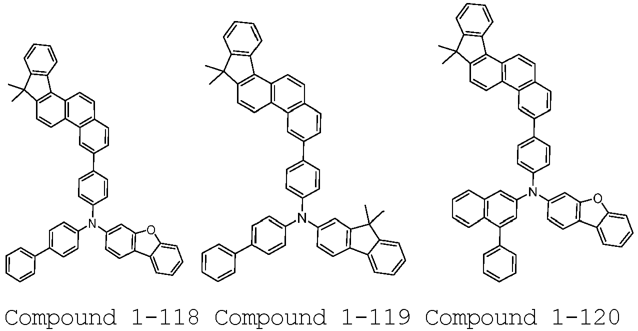

In an embodiment, concrete examples of the amine compound represented by Chemical Formula 2 include the compounds represented by the following [Compound 2-1] to [Compound 2-48]:

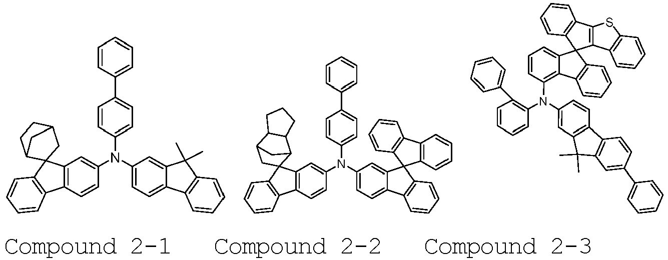

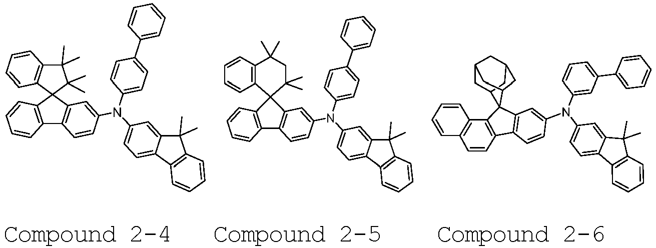

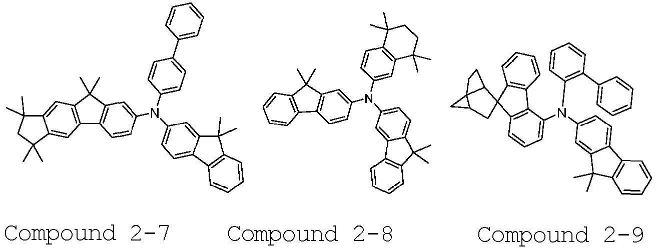

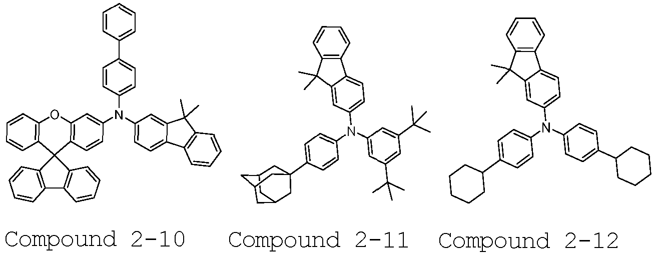

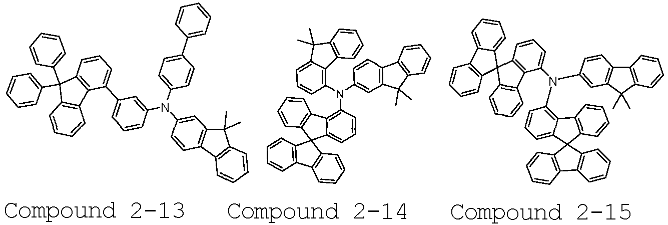

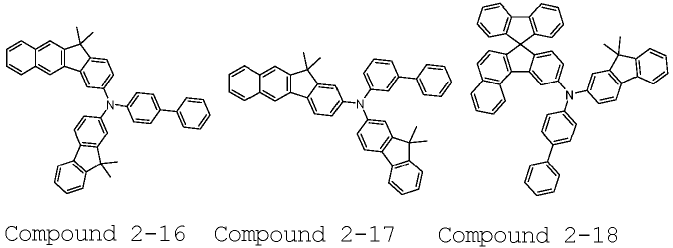

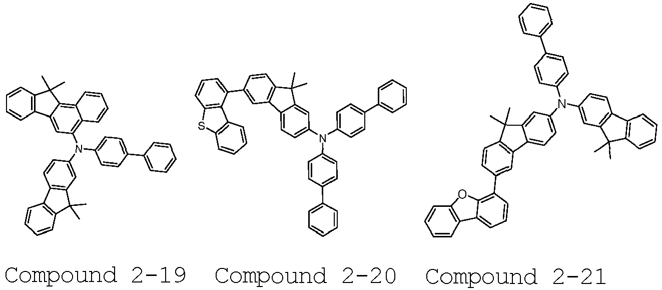

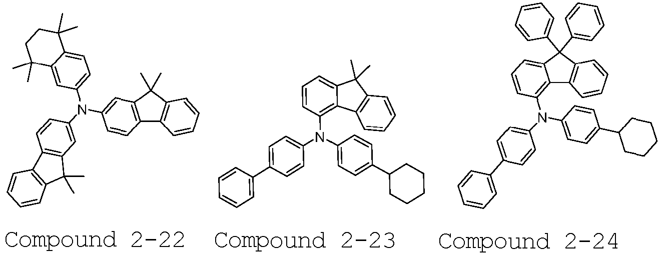

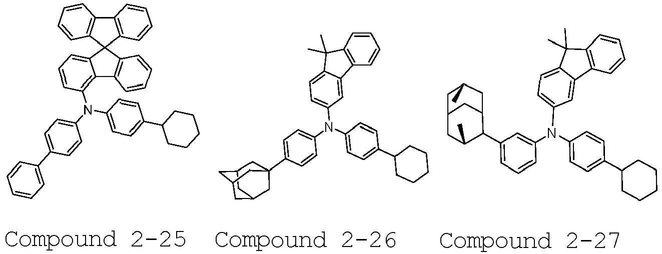

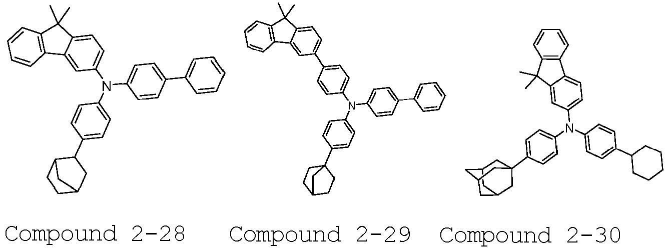

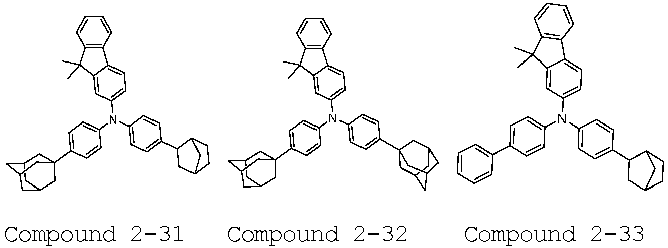

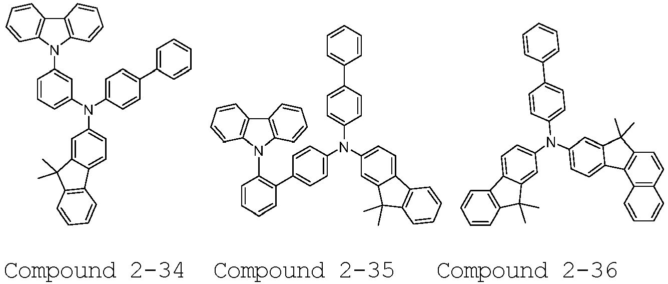

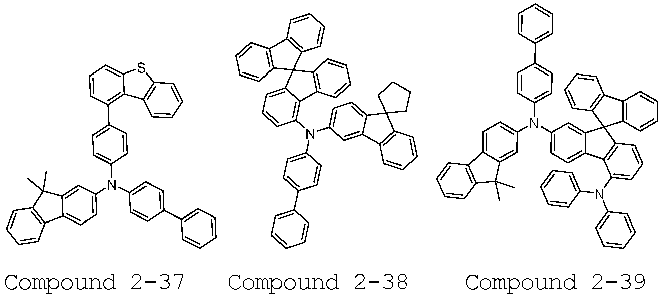

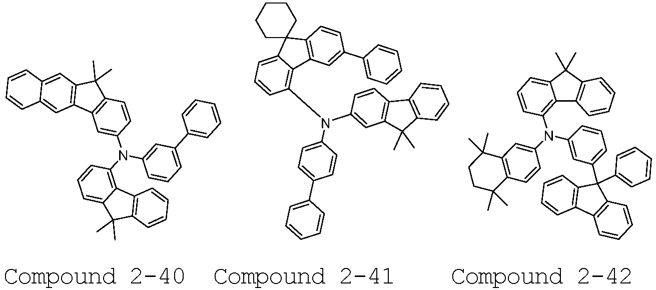

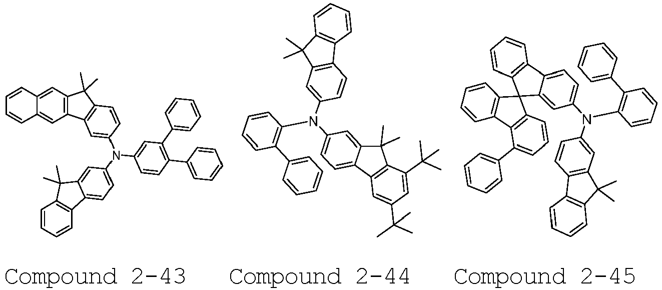

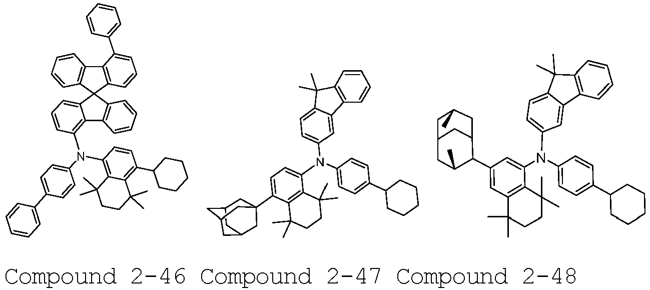

In an embodiment, concrete examples of the amine compound represented by Chemical Formula 3 include the compounds represented by the following [Compound 3-1] to [Compound 3-39]:

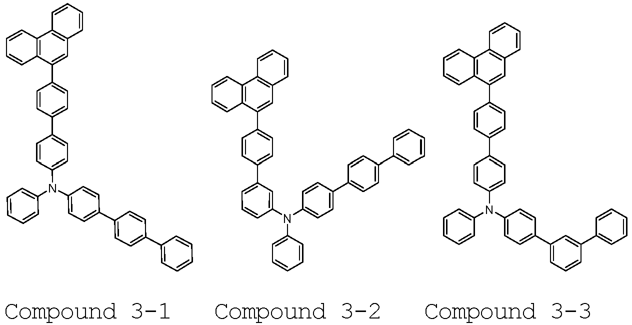

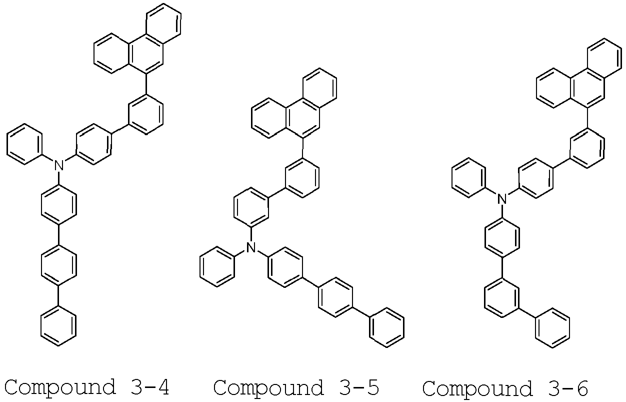

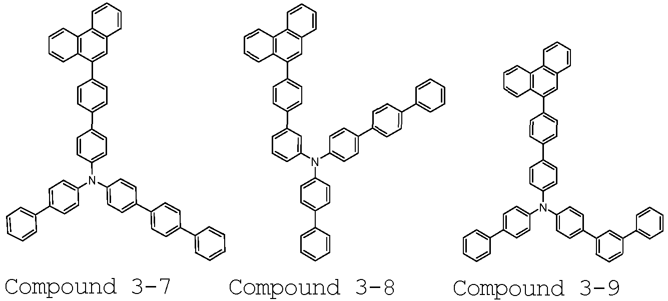

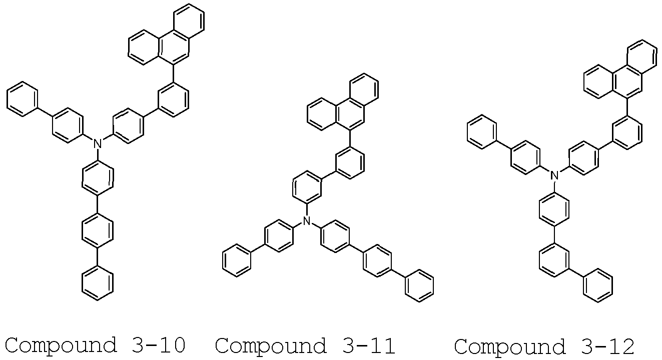

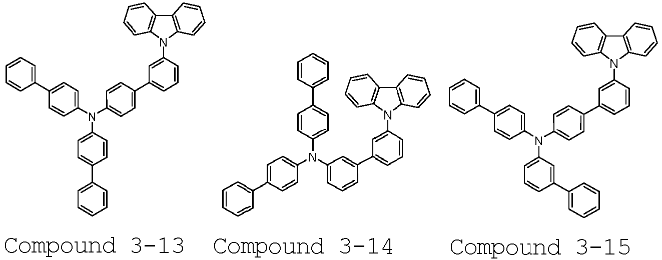

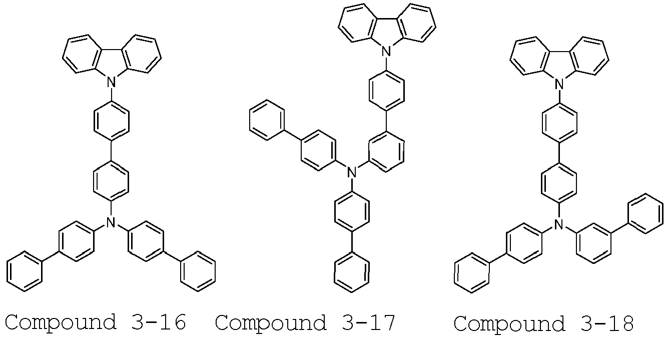

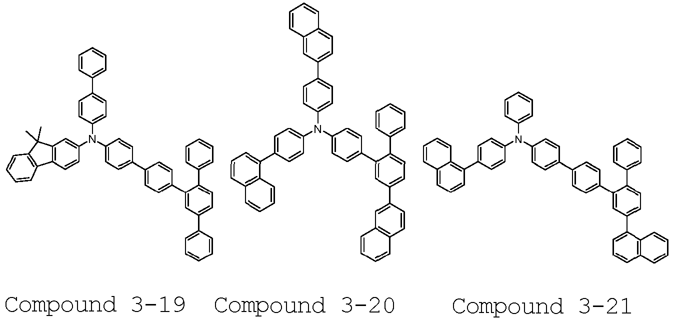

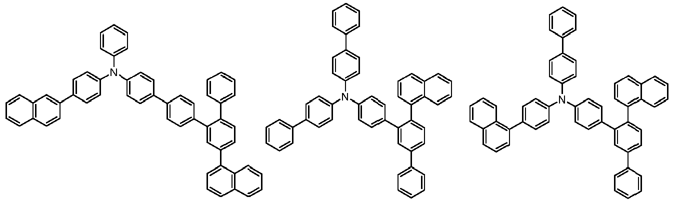

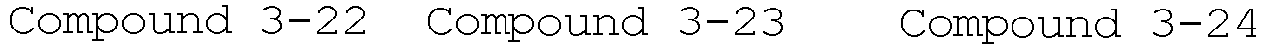

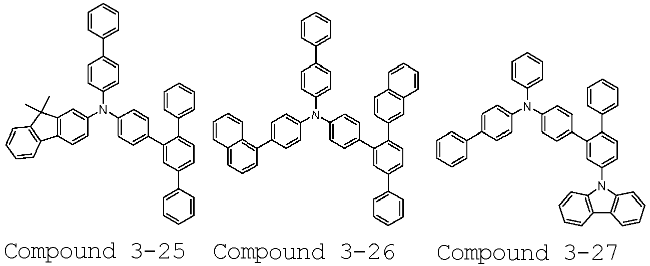

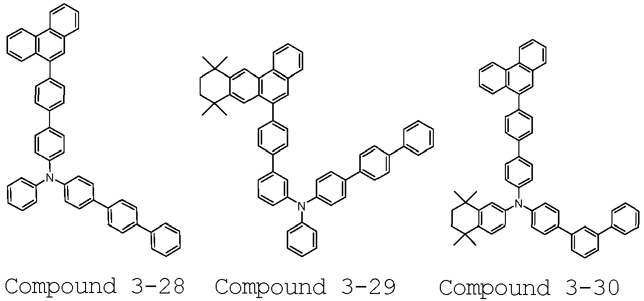

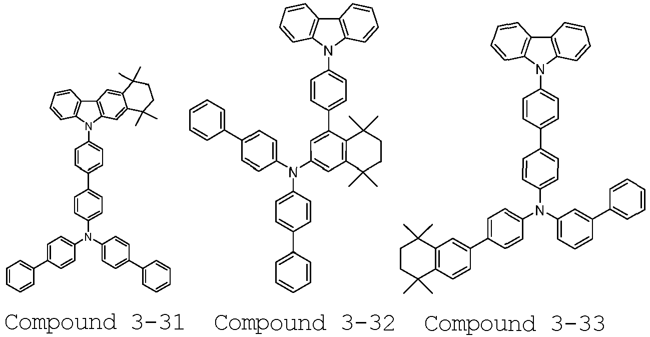

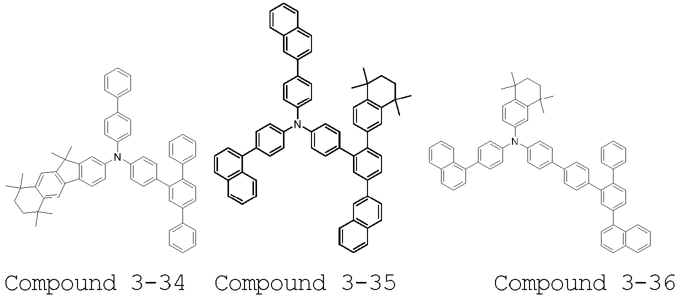

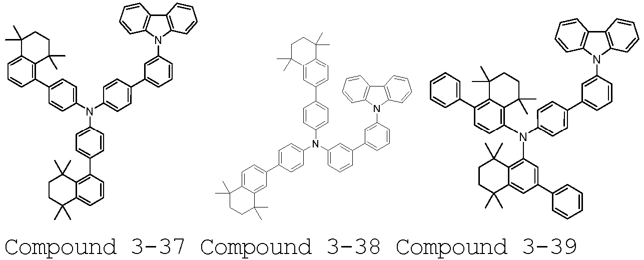

Throughout the description of the present disclosure, the phrase "(organic layer, light-emitting layer, or emitting-auxiliary layer) includes at least one organic compound" may be construed to mean that "(organic layer) may include a single organic compound species or two or more different species of organic compounds falling within the scope of the present disclosure".

In the organic light-emitting diode according to the present disclosure, the light-emitting layer includes a host and a dopant, and the amine compound represented by Chemical Formula 1 may be used as a host in the light-emitting layer. That is, the OLED according to the present disclosure may include one or more of the compounds represented by Chemical Formula 1 as a host material in the light-emitting layer.

More specifically, the organic light-emitting diode according to the present disclosure includes: a first electrode; a second electrode facing the first electrode; and an organic layer interposed between the first electrode and the second electrode and including a light-emitting layer and an emitting-auxiliary layer, wherein the light-emitting layer includes at least one amine compound represented by Chemical Formula 1, and the emitting-auxiliary layer includes at least one amine compound represented by Chemical Formula 2 or Chemical Formula 3. In this regard, the light-emitting layer includes a host and a dopant, and the amine compound represented by Chemical Formula 1 may serve as a host in the emitting layer. Due to this structural characteristic, the OLED according to the present disclosure can exhibit high efficiency, low driving voltage, and long lifespan.

In one embodiment, the organic layer in the OLED of the present disclosure may further include at least one layer selected from a hole injection layer, a hole transport layer, a functional layer capable of both hole injection and hole transport, an electron blocking layer, a hole blocking layer, an electron transport layer, and an electron injection layer.

In an embodiment, the OLED according to the present disclosure may include at least one of a hole transport layer and a hole injection layer between the first electrode and the emitting-auxiliary layer, and may include at least one of an electron transport layer and an electron injection layer between the light-emitting layer and the second electrode.

In an embodiment, the light-emitting layer of the OLED according to the present disclosure may additionally include one or more host compounds different from the amine compound represented by Chemical Formula 1. That is, the host may include, in addition to the compound represented by Chemical Formula 1, one or more different host compounds, thereby including two or more types of host compounds. These host compounds may be used in a mixed or laminated form. In the case of lamination, the host layer containing the amine compound of the present disclosure may be laminated above or below a layer containing a different host compound.

Here, when two or more host compounds, i.e., the compound represented by Chemical Formula 1 along with at least one additional host compound, are used in a mixed or laminated form, the additional host compound may be preferably a compound having an electron-accepting moiety. Due to the high HOMO/LUMO levels of hole injection and electron injection barriers resulting from the combination or lamination of the compound represented by Chemical Formula 1 which has an electron-donating amine group with a compound having an electron-accepting moiety, the recombination zone can be confined to the interface between the two hosts, thereby minimizing current loss and realizing a high-efficiency, long-lifespan OLED.

The compound having an electron-accepting moiety may be a compound that includes a moiety favorable for accepting electrons, such as an azine compound having a nitrogen-bearing heteroaromatic ring (e.g., pyridine, pyrimidine, or triazine) or a compound substituted with a cyano group (-CN). Preferably, it may be a compound including a heteroaryl radical bearing 1 to 3 nitrogen atoms (N) in the molecule, or an aryl radical bearing 1 to 3 cyano groups (-CN) in the molecule.

When two or more host compounds are used, the mixing ratio of the compound represented by Chemical Formula 1 to the additional host compound may range from 1:9 to 9:1, preferably from 2:8 to 8:2, and more preferably from 4:6 to 6:4.

More specifically, the host in the light-emitting layer of the OLED may include at least one organic compound represented by Chemical Formula B, either mixed with the amine compound represented by Chemical Formula 1 or laminated above or below a layer containing the amine compound represented by Chemical Formula 1: 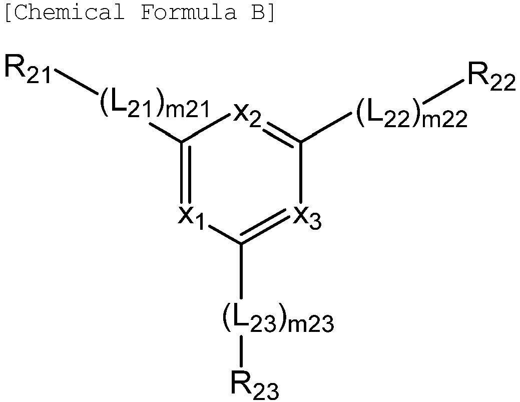 wherein,
X₁ to X₃, which are same or different, are each independently N or CR₂₄, with a proviso that at least one of X₁ to X₃, wherein when two of X₁ to X₃ are CR₂₄, the corresponding CR₂₄ radicals are same or different,
L₂₁ to L₂₃, which are same or different, are each independently any one selected from among a single bond, a substituted or unsubstituted arylene of 6 to 20 carbon atoms, a substituted or unsubstituted heteroarylene of 3 to 20 carbon atoms, and a substituted or unsubstituted, aliphatic hydrocarbon ring-fused arylene of 8 to 20 carbon atoms,
m21 to m23, which are same or different, are each independently an integer of 1 to 2, wherein when they are 2, the corresponding L₂₁ to L₂₃ are individually same or different, and
R₂₁ to R₂₄, which are same or different, are each independently any one selected from among a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a substituted or unsubstituted a germanium of 0 to 40 carbon atoms, a nitro, a cyano, and a halogen atom,
wherein the term "substituted" in the expression "substituted or unsubstituted" used for the compound of Chemical Formula B means having at least one substituent selected from the group consisting of a deuterium atom, a tritium atom, a cyano, a halogen, a hydroxy, a nitro, alkyl of 1 to 30 carbon atoms, halogenated alkyl of 1 to 30 carbon atoms, alkenyl of 2 to 30 carbon atoms, alkynyl of 2 to 30 carbon atoms, cycloalkyl of 3 to 30 carbon atoms, a heteroalkyl of 1 to 30 carbon atoms, an aryl of 6 to 30 carbon atoms, an arylalkyl of 7 to 30 carbon atoms, an alkylaryl of 7 to 30 carbon atoms, a heteroaryl of 2 to 30 carbon atoms, a heteroarylalkyl of 3 to 30 carbon atoms, an alkylheteroaryl of 3 to 30 carbon atoms, an alkoxy of 1 to 30 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted, heteroaliphatic ring-fused aryl of 6 to 30 carbon atoms, a substituted or unsubstituted, heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, aryloxy of 6 to 30 carbon atoms, and an arylthionyl of 6 to 30 carbon atoms, with at least one hydrogen atom on the substituent being substitutable with a deuterium or tritium atom.
In a more preferred embodiment of the present disclosure, X₁ to X₃ in Chemical Formula B may each be N, and at least one of R₂₁ to R23 may be a substituted or unsubstituted carbazole.
In an embodiment, the emitting layer of the organic light emitting diode according to the present disclosure includes a host and a dopant. When the amine compound represented by Chemical Formula 1 is used as the host, the dopant in the emitting layer may include at least one organometallic compound containing a transition metal.

Hereinafter, when the amine compound represented by Chemical Formula 1 in the present disclosure is used as a host in the light-emitting layer, the dopant compound used in the light-emitting layer will be described in more detail.

In a more preferred embodiment of the present disclosure, the OLED according to the present disclosure includes, as a dopant in the emitting layer, not a fluorescent dopant material that transfers only in the singlet state using Förster energy transfer, which is typically used in conventional host-dopant systems, but rather a phosphorescent dopant material that undergoes energy transfer via Dexter energy transfer, which enables transition regardless of singlet or triplet state. Such a phosphorescent dopant material may comprise one or more organometallic compounds containing metals selected from Ir, Pt, Os, Ti, Zr, Hf, Eu, Tb, Tm, Fe, Co, Ni, Ru, Rh, Re, and Pd. Any known dopant material that emits light from a triplet excited state may be used without particular limitation.

Preferably, the phosphorescent dopant may be an organometallic compound containing a transition metal. More preferably, the transition metal complex may be selected from Ir, Pt, and Pd. Specific examples include Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd), Ir(ppy)₂tmd, Ir(pmi)₃, Ir(pmb)₃, FCNIr, FCNIrpic, FIr₆, FIrN₄, FIrpic, PtOEP, Ir(chpy)₃, P0-01(C₃₁H₂₃IrN₂O₂S₂), Ir(ppz)₃, Ir(dfppz)₃, PtNON, Pt-10, Pt-11, and the like, but are not limited thereto.

Here, when the light-emitting layer contains both a host and a dopant, the content of the dopant may typically be selected in the range of about 0.01 to about 20 parts by weight, based on 100 parts by weight of the host, but with no limitations thereto.

In addition, the light-emitting layer may further include various host and dopant materials in addition to the dopant and host described above. Preferably, the dopant in the emitting layer of the OLED includes, in addition to the aforementioned organometallic compound, at least one dopant compound containing boron, and these dopants may be used in a mixed or laminated configuration.

More specifically, the dopant in the light- emitting layer of the OLED may include at least one polycyclic compound represented by [Chemical Formula 4], in addition to the organometallic compound containing a transition metal, either mixed together or laminated above or below the layer containing the organometallic compound: 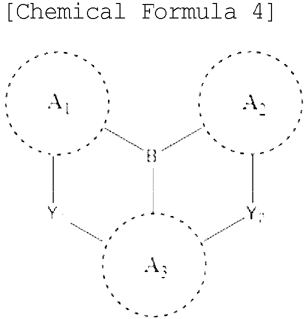 wherein,
Y₁ and Y₂, which are same or different, are each independently any one selected from among O, S, NR₃₁, CR₃₂R₃₃, SiR₃₄R₃₅, and GeR36R₃₇,
A₁ to A₃, which are same or different, are each independently any one selected from among a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted, aliphatic hydrocarbon ring-fused aromatic hydrocarbon ring of 8 to 50 carbon atoms, a substituted or unsubstituted heteroaromatic ring of 2 to 50 carbon atoms, and a substituted or unsubstituted, aliphatic hydrocarbon ring-fused heteroaromatic ring of 5 to 50 carbon atoms,
R₃₁ to R₃₇, which are same or different, are each independently any one selected from among a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a substituted or unsubstituted a germanium of 0 to 40 carbon atoms, a nitro, a cyano, and a halogen atom,
R₃₁ to R₃₇ may be connected to the A₁ to A₃ ring moieties to additionally form an aliphatic or aromatic mono-or polycyclic ring, and
linkage may be made between R₃₂ and R₃₃, between R₃₄ and R₃₅, and between R36 and R₃₇ to additionally form an aliphatic or aromatic mono- or polycyclic ring,
wherein the term "substituted" in the expression "substituted or unsubstituted" used for the compound of Chemical Formula 4 means having at least one substituent selected from the group consisting of a deuterium atom, a tritium atom, a cyano, a halogen, a hydroxy, a nitro, alkyl of 1 to 30 carbon atoms, halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroaryl alkyl of 3 to 24 carbon atoms, an alkyl heteroaryl of 3 to 24 carbon atoms, an alkoxy of 1 to 24 carbon atoms, aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted, heteroaliphatic ring-fused aryl of 6 to 30 carbon atoms, a substituted or unsubstituted, heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

The polycyclic compound represented by Chemical Formula 4 is a boron-based thermally activated delayed fluorescence emitter and enables Förster energy transfer from the triplet state of a phosphorescence sensitizer to the singlet state of the boron-based thermally activated delayed fluorescence emitter, thereby reducing the number of long-lived triplet excitons involved in device degradation and improving the device lifespan. In addition, due to the high molar absorption coefficient thereof, the compound enhances the rate of fluorescence resonance energy transfer from the phosphorescence sensitizer to the emitter and exhibits the multi-resonance effect that leads to a narrower emission spectrum, resulting in improved color purity. These characteristics contribute to enhanced efficiency and lifespan of the device.

In a more preferred embodiment of the present disclosure, A₁ to A₃ may be the same or different, and each may independently be a substituted or unsubstituted aromatic hydrocarbon ring of 6 to 30 carbon atoms, or a substituted or unsubstituted, aliphatic hydrocarbon ring-fused aromatic hydrocarbon ring of 8 to 50 carbon atoms.

In an embodiment, the emitting-auxiliary layer of the OLED may be formed by mixing or depositing two or more different compounds.

More specifically, the emitting-auxiliary layer of the OLED according to the present disclosure may include, in addition to the amine compound represented by Chemical Formula 2 or Chemical Formula 3, at least one additional an emitting-auxiliary compound different from the amine compound represented by Chemical Formula 2 or Chemical Formula 3. These compounds may be deposited as a mixture, co-deposited, or laminated.

Here, the an emitting-auxiliary compound different from the amine compound represented by Chemical Formula 2 or Chemical Formula 3 in the emitting-auxiliary layer of the OLED may, like the additional host compounds described for the emitting layer, include two or more different emitting-auxiliary compounds deposited as a mixture, co-deposited, or laminated. In the case of lamination, a host compound different from the amine compound represented by Chemical Formula 2 or 3 may be laminated above or below the layer including the amine compound of the present disclosure.

The term "emitting-auxiliary compound different from the amine compound represented by Chemical Formula 2 or Chemical Formula 3" refers to any compound usable for the emitting-auxiliary layer, other than the specific amine compound used whether it be one represented by Chemical Formula 2 or 3, without limitation as to the type of compound.

For example, if one compound represented by Chemical Formula 2 is used in the emitting-auxiliary layer, an additional compound used may be a compound represented by Chemical Formula 3, which is different from that of Chemical Formula 2. Alternatively, a compound different from both Chemical Formulas 2 and 3 may be used.

More preferably, the emitting-auxiliary layer of the present disclosure includes two or more different amine compounds represented by Chemical Formula 2 or Chemical Formula 3, which may be deposited as a mixture, co-deposited, or laminated. That is, the emitting-auxiliary layer according to the present disclosure includes two or more different amine compounds represented by Chemical Formula 2 or 3, which may be deposited as a mixture, co-deposited, or laminated.

Specifically, when the first host is composed of two or more compounds, these compounds may be mixed and deposited from a single evaporation source by sublimation or vaporization, or may be co-deposited onto the light-emitting layer from separate evaporation sources. Alternatively, they may be laminated to form a first light-emitting layer.

As a method for forming the light-emitting layer, a thin film may be formed by co-depositing multiple first host materials from separated evaporation sources, or by pre-mixing the multiple host materials and then depositing the mixture. Alternatively, the light-emitting layer may be formed by sequential deposition of the host materials.

In a more preferred embodiment of the present disclosure, the organic light-emitting diode according to the present disclosure includes the first electrode as an anode and the second electrode as a cathode, with the light-emitting layer and the emitting-auxiliary layer interposed between the anode and the cathode, wherein a hole injection layer and a hole transport layer are sequentially located between the anode and the emitting-auxiliary layer and an electron transport and an electron injection layer are sequentially located between the light-emitting layer and the cathode.

Below, with reference to the drawing, a description will be given of the organic light-emitting diode of the present disclosure.

FIG. 1 is a schematic view illustrating the structure of an organic light-emitting diode according to an embodiment of the present disclosure.

As shown in FIG. 1, the organic light-emitting diode according to an embodiment of the present disclosure comprises an anode (20), a hole transport layer (40), an emitting-auxiliary layer (50'), a light-emitting layer (50) containing a host and a dopant, an electron transport layer (60), and a cathode (80), wherein the anode and the cathode serve as a first electrode and a second electrode, respectively, with the interposition of the hole transport layer between the anode and the emitting-auxiliary layer, and the electron transport layer between the light-emitting layer and the cathode.

Furthermore, the organic light-emitting diode according to an embodiment of the present disclosure may include a hole injection layer (30) between the anode (20) and the hole transport layer (40), and an electron injection layer (70) between the electron transport layer (60) and the cathode (80).

Reference is made to FIG. 1 with regard to the organic light-emitting diode of the present disclosure and the fabrication thereof.

First, a substrate (10) is coated with an anode electrode material to form an anode (20). So long as it is used in a typical organic electroluminescence (EL) device, any substrate may be used as the substrate (10). Preferable is an organic substrate or transparent plastic substrate that exhibits excellent transparency, surface smoothness, ease of handling, and waterproofness. As the anode material, indium tin oxide (ITO), indium zinc oxide (IZO), tin oxide (SnO2), or zinc oxide (ZnO), which are transparent and superior in terms of conductivity, may be used.

A hole injection layer material is applied on the anode (20) by thermal deposition in a vacuum or by spin coating to form a hole injection layer (30). Subsequently, thermal deposition in a vacuum or by spin coating may also be conducted to form a hole transport layer (40) with a hole transport layer material on the hole injection layer (30).

So long as it is typically used in the art, any material may be selected for the hole injection layer (30) without particular limitations thereto. Examples include, but are not limited to, 2-TNATA [4,4',4"-tris(2-naphthylphenyl-phenylamino)-triphenylamine], NPD [N,N'-di(1-naphthyl)-N,N'- diphenylbenzidine)], TPD [N,N'-diphenyl-N,N'-bis(3-methylphenyl)-1,1'- biphenyl-4,4'-diamine], DNTPD [N,N'-diphenyl-N,N'-bis-[4-(phenyl-m-tolylamino)-phenyl]-biphenyl-4,4'-diamine] HAT-CN [1,4,5,8,9,11-Hexaazatriphenylenehexacarbonitrile].

Any material that is typically used in the art may be selected for the hole transport layer (40) without particular limitations thereto. Examples include, but are not limited to, N,N'-bis(3-methylphenyl)-N,N'-diphenyl-[1,1-biphenyl]-4,4'-diamine(TPD) or N,N'-di(naphthalen-1-yl)-N,N'-diphenylbenzidine (a-NPD), N-[[1,1'-biphenyl]-4-yl]-9,9-dimethyl-N-[4-(9-phenyl-9H-carbazol-3-yl)phenyl]-9H-fluorene-2-amine(BCFN), and the like.

In an embodiment of the present disclosure, an electron blocking layer may be additionally disposed on the hole transport layer. Functioning to prevent the electrons injected from the electron injection layer from entering the hole transport layer from the light-emitting layer, the electron blocking layer is adapted to increase the life span and luminous efficiency of the diode. The electron blocking layer may be formed of a well-known material or a combination of well-known materials, as necessary, at a suitable position between the light-emitting layer and the hole injection layer. Particularly, the electron blocking layer may be formed between the light-emitting layer and the hole transport layer.

Next, the emitting-auxiliary layer (50') and light-emitting layer (50) may each be deposited on the hole transport layer (40) by deposition in a vacuum or by spin coating.

Here, the amine compound represented by Chemical Formula 2 or Chemical Formula 3 may be used as the emitting-auxiliary layer material in the OLED, and the light-emitting layer (50) may be composed of a host and a dopant. The materials constituting these layers are as previously described.

In addition, the emitting-auxiliary layer (50') and the light-emitting layer (50) may each be formed by mixing two or more different components or by sequentially laminating them.

According to a specific embodiment of the present disclosure, the thickness of the emitting-auxiliary layer (50') may range from 300 to 1,500 Å, preferably from 400 to 1,200 Å, and the thickness of the light-emitting layer (50) may range from 100 to 500 Å, preferably from 200 to 400 Å.

The electron transport layer (60) may be deposited on the emitting layer by vacuum deposition or spin coating.

In the present disclosure, the electron transport layer (60) functions to stably transport electrons injected from the electron-injecting electrode (cathode), and known electron transport materials may be used. Examples of such known materials include quinoline derivatives, particularly tris(8-quinolinolato)aluminum (Alq₃), Liq, TAZ, BAlq, beryllium bis(benzoquinolin-10-olate) (Bebq₂), Compound 201, Compound 202, BCP, and oxadiazole derivatives such as PBD, BMD, and BND, but are not limited thereto.

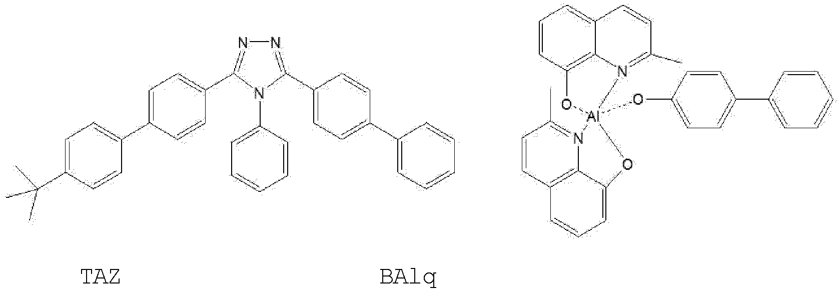

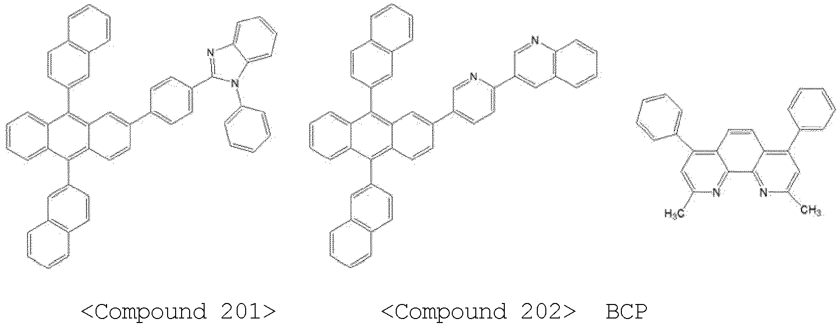

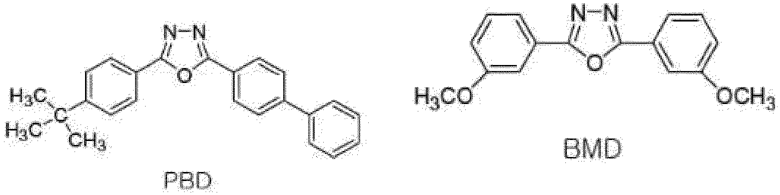

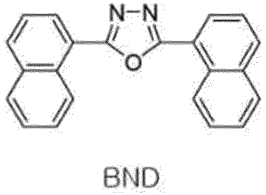

In the organic light emitting diode of the present disclosure, an electron injection layer (EIL) that functions to facilitate electron injection from the cathode may be deposited on the electron transport layer. The material for the EIL is not particularly limited.

Any material that is conventionally used in the art can be available for the electron injection layer (70) without particular limitations. Examples include CsF, NaF, LiF, Li2O, and BaO. Deposition conditions for the electron injection layer may vary, depending on compounds used, but may be generally selected from condition scopes that are almost the same as for the formation of hole injection layers.

The electron injection layer (70) may range in thickness from about 1 Å to about 100 Å, and particularly from about 3 Å to about 90 Å. Given the thickness range for the electron injection layer, the diode can exhibit satisfactory electron injection properties without actually elevating a driving voltage.

In order to facilitate electron injection, the cathode (80) may be made of a material having a small work function, such as metal or metal alloy such as lithium (Li), magnesium (Mg), calcium (Ca), an alloy aluminum (Al) thereof, aluminum-lithium (Al-Li), magnesium-indium (Mg-In), and magnesium-silver (Mg-Ag). Alternatively, ITO or IZO may be employed to form a transparent cathode for an organic light-emitting diode.

Moreover, the organic light-emitting diode of the present disclosure may further comprise a light-emitting layer containing a blue, green, or red luminescent material that emits radiations in the wavelength range of 380 nm to 800 nm. That is, the light-emitting layer in the present disclosure has a multi-layer structure wherein the blue, green, or red luminescent material may be a fluorescent material or a phosphorescent material.

Furthermore, at least one selected from among the layers may be deposited using a single-molecule deposition process or a solution process.

Here, the deposition process is a process by which a material is vaporized in a vacuum or at a low pressure and deposited to form a layer, and the solution process is a method in which a material is dissolved in a solvent and applied for the formation of a thin film by means of inkjet printing, roll-to-roll coating, screen printing, spray coating, dip coating, spin coating, etc.

Also, the organic light-emitting diode of the present disclosure may be applied to a device selected from among flat display devices; flexible display devices; stretchable display devices; monochrome or grayscale flat illumination devices; monochrome or grayscale flexible illumination devices; vehicle or aircraft display devices, and display devices for virtual or augmented reality.

A better understanding of the present disclosure may be obtained through the following examples which are set forth to illustrate, but are not to be construed as limiting the present disclosure.

### (EXAMPLES)

### SYNTHESIS EXAMPLE 1. Synthesis of [Compound 1-1] Synthesis Example 1-1. Synthesis of A-1

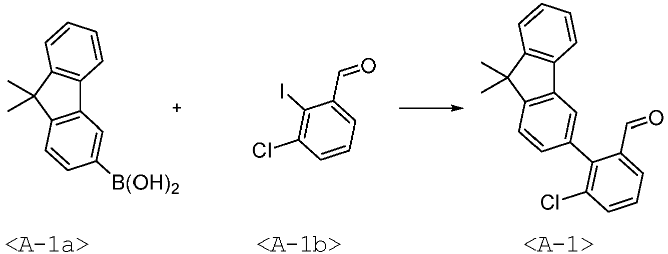

In a reactor, <A-1a> (44.7 g), <A-1b> (50 g), tetrakis triphenylphosphine palladium (4.3 g), potassium carbonate (52 g), toluene (600 mL), and water (150 mL) were refluxed together for 12 hours under a nitrogen atmosphere. After completion of the reaction, the layers thus formed were separated. The organic layer was concentrated in a vacuum, followed by purification through column chromatography to afford <A-1>. (43 g, 75%)

### Synthesis Example 1-2. Synthesis of A-2

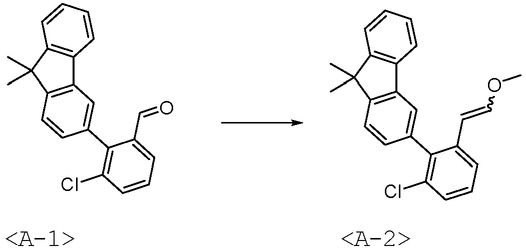

To tetrahydrofuran (200 mL) in a reactor was added 1M potassium tert-butoxide (65 mL) before the temperature was reduced to 0°C under a nitrogen atmosphere. A solution of (methoxymethyl)triphenyl phosphonium chloride (33.5 g) in tetrahydrofuran (200 mL) was dropwise added. After 30 minutes, a solution of <A-1> (20 g) in tetrahydrofuran (200 mL) was slowly added and then stirred at room temperature for 2 hours. After completion of the reaction, the reaction mixture was washed water. The organic layer thus formed was concentrated in a vacuum, followed by purification through column chromatography to afford <A-2>. (20.7 g, 95%)

### Synthesis Example 1-3. Synthesis of A-3

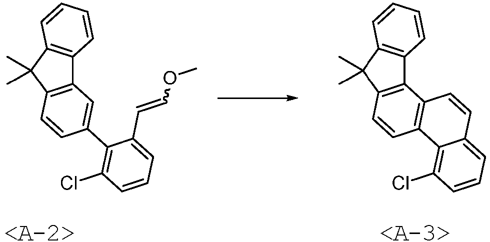

In a reactor, <A-2> (20 g), bismuth (III) trifluoromethane sulfonate (1.9 g), and 1,2-dichloroethane (300 mL) were stirred together at room temperature for 3 hours under a nitrogen atmosphere. After completion of the reaction, the organic layer thus formed was concentrated in a vacuum. Isolation through column chromatography afforded <A-3>. (10.2 g, 52%)

### Synthesis Example 1-4. Synthesis of A-4

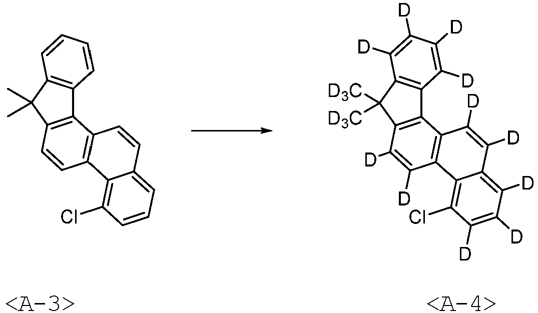

In a reactor, <A-3> (10 g), D6-benzene (500 mL), and triflic acid (20 mL) were refluxed together for 48 hours. After completion of the reaction, water was added, and the layers thus formed were separated. The organic layer was concentrated in a vacuum, followed by purification through column chromatography to afford <A-4>. (8.7 g, 83%)

### Synthesis Example 1-5. Synthesis of [Compound 1-1]

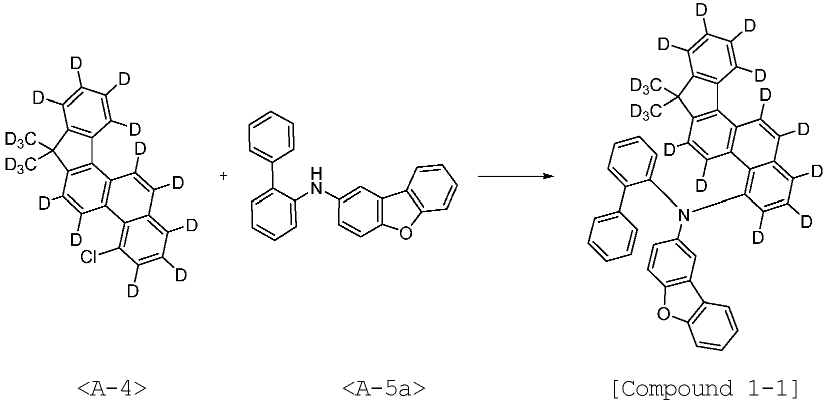

In a reactor, <A-4> (10 g), <A-5a> (10.7 g), bis(tri t-butyl phosphine)palladium (0.3 g), sodium t-butoxide(5.57 g), and toluene (100 mL) were refluxed together for 2 hours under a nitrogen atmosphere. After completion of the reaction, the layers thus formed were separated. The organic layer was concentrated in a vacuum, followed by purification through column chromatography to afford [Compound 1-1]. (12.5 g, 67%)
MS (MALDI-TOF) : m/z 644.36 [M⁺]

### SYNTHESIS EXAMPLE 2. Synthesis of [Compound 1-2]

### Synthesis Example 2-1. Synthesis of B-1

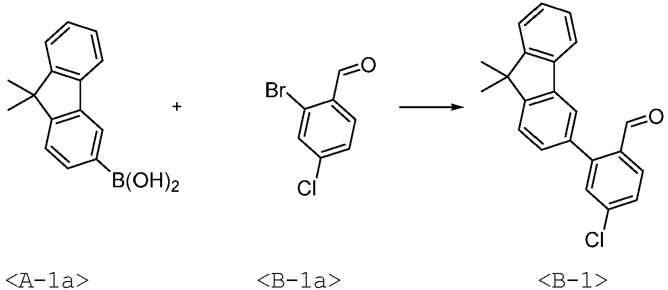

<B-1> was synthesized in the same manner as in Synthesis Example 1-1, with the exception of using <B-1a> instead of <A-1b>. (yield 78%)

### Synthesis Example 2-2. Synthesis of B-2

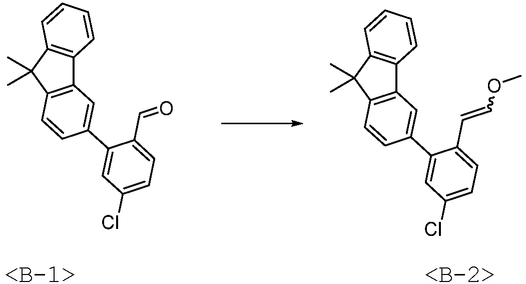

<B-2> was synthesized in the same manner as in Synthesis Example 1-2, with the exception of using <B-1> instead of <A-1>. (yield 94%)

### Synthesis Example 2-3. Synthesis of B-3

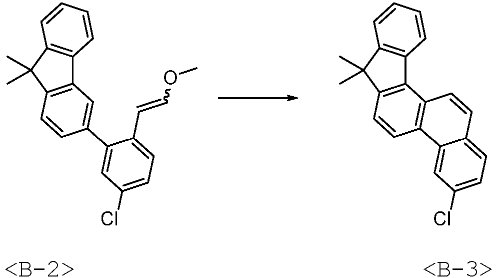

<B-3> was synthesized in the same manner as in Synthesis Example 1-3, with the exception of using <B-2> instead of <A-2>. (yield 56%)

### Synthesis Example 2-4. Synthesis of B-4

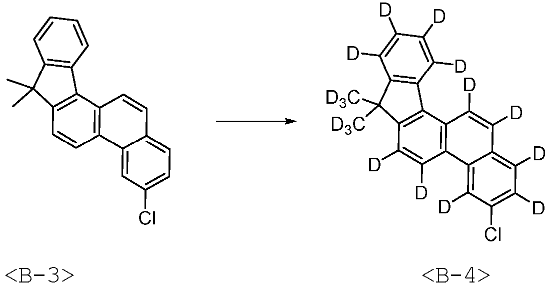

<B-4> was synthesized in the same manner as in Synthesis Example 1-4, with the exception of using <B-3> instead of <A-3>. (yield 89%)

### Synthesis Example 2-5. Synthesis of [Compound 1-2]

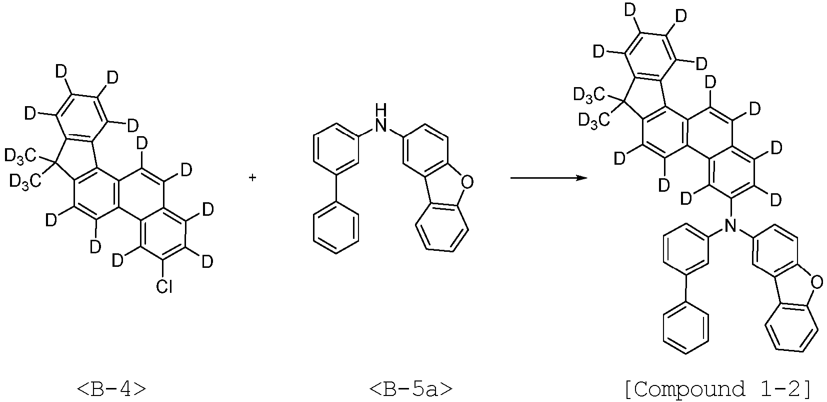

[Compound 1-2] was synthesized in the same manner as in Synthesis Example 1-5, with the exception of using <B-4> and <B-5a> instead of <A-4> and <A-5a>, respectively. (yield 52%)
MS (MALDI-TOF) : m/z 644.36 [M⁺]

### SYNTHESIS EXAMPLE 3. Synthesis of [Compound 1-3]

### Synthesis Example 3-1. Synthesis of [Compound 1-3]

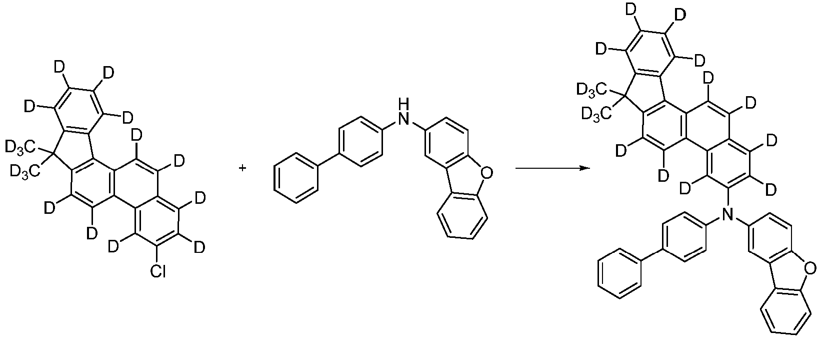

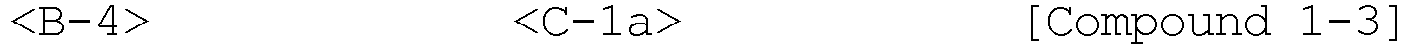

[Compound 1-3] was synthesized in the same manner as in Synthesis Example 1-5, with the exception of using<B-4> and <C-1a> instead of <A-4> and <A-5a>, respectively. (yield 55%)
MS (MALDI-TOF) : m/z 644.36 [M⁺]

### SYNTHESIS EXAMPLE 4. Synthesis of [Compound 1-7]

### Synthesis Example 4-1. Synthesis of [Compound 1-7]

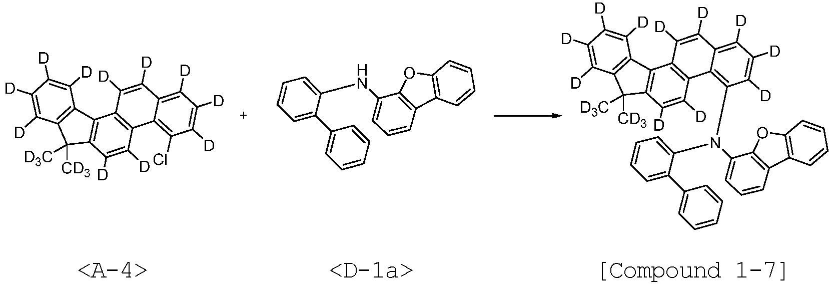

[Compound 1-7] was synthesized in the same manner as in Synthesis Example 1-5, with the exception of using <D-1a> instead of <A-5a>. (yield 59%)
MS (MALDI-TOF) : m/z 644.36 [M⁺]

### SYNTHESIS EXAMPLE 5. Synthesis of [Compound 1-10]

### Synthesis Example 5-1. Synthesis of [Compound 1-10]

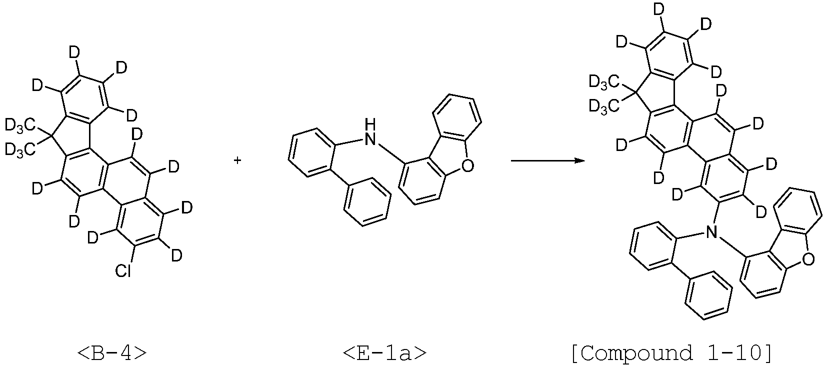

[Compound 1-10] was synthesized in the same manner as in Synthesis Example 1-5, with the exception of using <B-4> and <E-1a> instead of <A-4> and <A-5a>, respectively. (yield 48%)
MS (MALDI-TOF) : m/z 644.36 [M⁺]

### SYNTHESIS EXAMPLE 6. Synthesis of [Compound 1-15]

### Synthesis Example 6-1. Synthesis of F-1

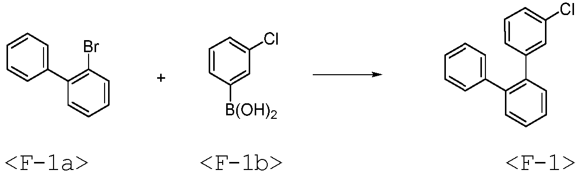

<F-1> was synthesized in the same manner as in Synthesis Example 1-1, with the exception of using <F-1a> and <F-1b> instead of <A-1b> and <A-1a>, respectively. (yield 78%)

### Synthesis Example 6-2. Synthesis of F-2

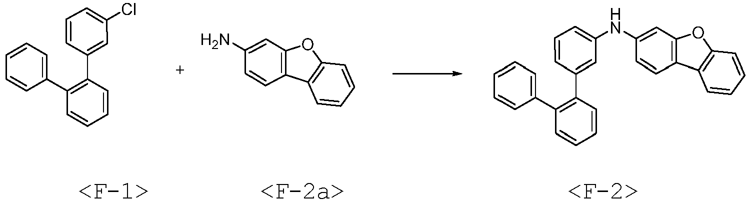

In a reactor, <F-1> (15 g), <F-2a> (10.9 g), tris(dibenzylidene acetone) dipalladium (1.04 g), sodium t-butoxide (11.1 g), Sphos (0.93 g), and toluene (150 mL) were refluxed together for 2 hours under a nitrogen atmosphere. After completion of the reaction, the layers thus formed were separated. The organic layer was concentrated in a vacuum, followed by purification through column chromatography to afford <F-2>. (17.3 g, 74%)

### Synthesis Example 6-3. Synthesis of [Compound 1-15]

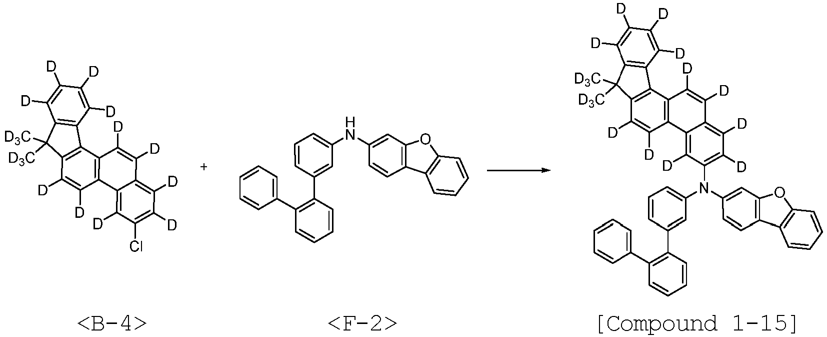

[Compound 1-15] was synthesized in the same manner as in Synthesis Example 1-5, with the exception of using <B-4> and <F-2> instead of <A-4> and <A-5a>, respectively. (yield 52%)
MS (MALDI-TOF) : m/z 720.39 [M⁺]

### SYNTHESIS EXAMPLE 7. Synthesis of [Compound 1-17]

### Synthesis Example 7-1. Synthesis of G-1

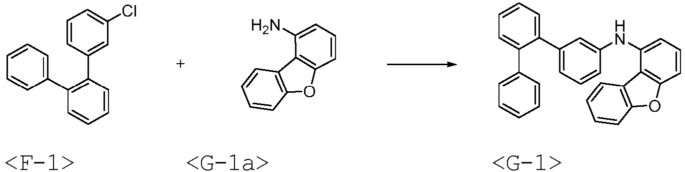

<G-1> was synthesized in the same manner as in Synthesis Example 6-2, with the exception of using <G-1a> instead of <F-2a>. (yield 77%)

### Synthesis Example 7-2. Synthesis of [Compound 1-17]

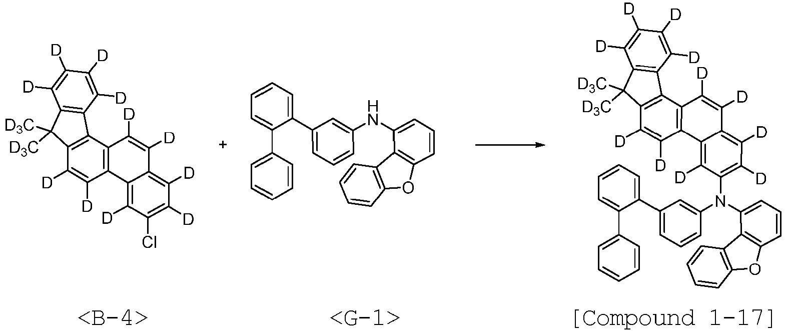

[Compound 1-17] was synthesized in the same manner as in Synthesis Example 1-5, with the exception of using <B-4> and <G-1> instead of <A-4> and <A-5a>, respectively. (yield 52%)
MS (MALDI-TOF) : m/z 720.39 [M⁺]

### SYNTHESIS EXAMPLE 8. Synthesis of [Compound 1-32]

### Synthesis Example 8-1. Synthesis of H-1

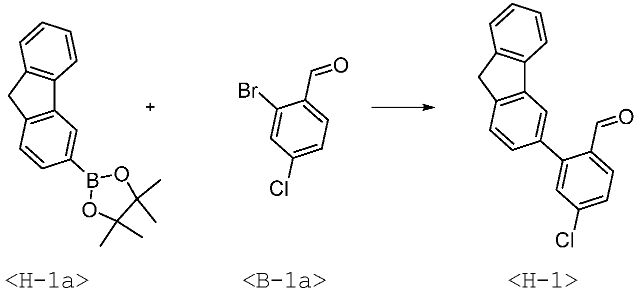

<H-1> was synthesized in the same manner as in Synthesis Example 1-1, with the exception of using <H-1a> and <B-1a> instead of <A-1a> and <A-1b>, respectively. (yield 79%)

### Synthesis Example 8-2. Synthesis of H-2

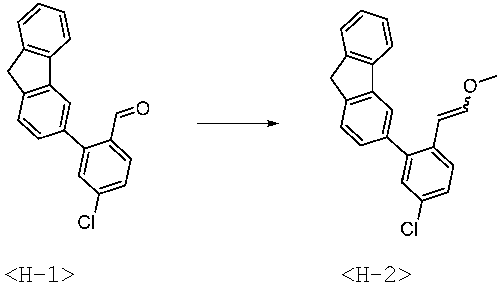

<H-2> was synthesized in the same manner as in Synthesis Example 1-2, with the exception of using <H-1> instead of <A-1>. (yield 97%)

### Synthesis Example 8-3. Synthesis of H-3

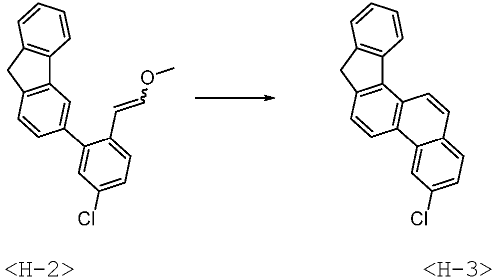

<H-3> was synthesized in the same manner as in Synthesis Example 1-3, with the exception of using <H-2> instead of <A-2>. (yield 55%)

### Synthesis Example 8-4. Synthesis of H-4

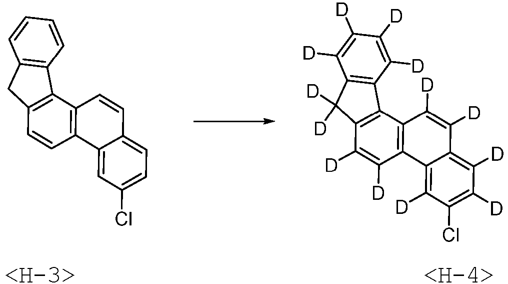

<H-4> was synthesized in the same manner as in Synthesis Example 1-4, with the exception of using <H-3> instead of <A-3>. (yield 84%)

### Synthesis Example 8-5. Synthesis of H-5

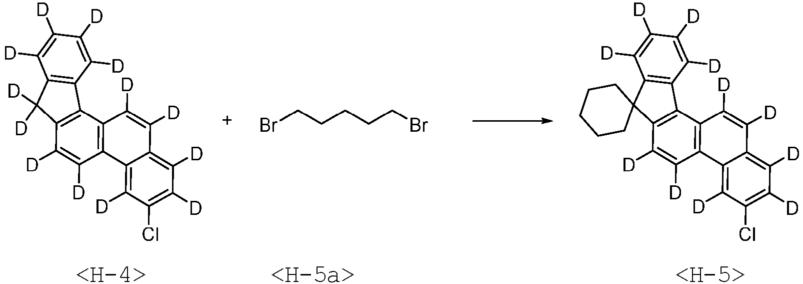

In a reactor, <H-4> (20 g), dimethylsulfoxide (30 mL), and benzyltriethyl ammonium chloride (0.51 g) were stirred together under a nitrogen atmosphere. Thirty minutes later, 50 wt% sodium hydroxide (13 mL) was added, followed by <H-5a> (16.1 g). Stirring was conducted for 10 hours. After completion of the reaction, the layers thus formed were separated. The organic layer was concentrated in a vacuum, followed by purification through column chromatography to afford <H-5>. (21.5 g, 84%)

### Synthesis Example 8-6. Synthesis of [Compound 1-32]

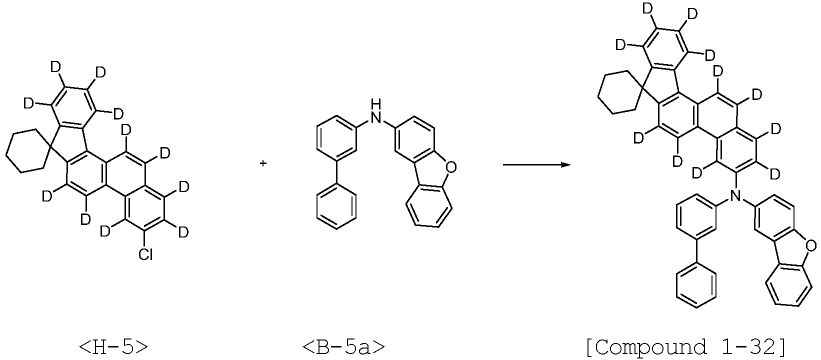

[Compound 1-32] was synthesized in the same manner as in Synthesis Example 1-5, with the exception of using <H-5> and <B-5a> instead of <A-4> and <A-5a>, respectively. (12.5 g, 57%)
MS (MALDI-TOF) : m/z 678.36 [M⁺]

### SYNTHESIS EXAMPLE 9. Synthesis of [Compound 1-38]

### Synthesis Example 9-1. Synthesis of I-1

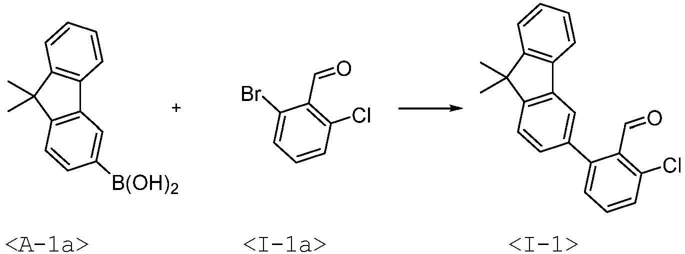

<I-1> was synthesized in the same manner as in Synthesis Example 1-1, with the exception of using <I-1a> instead of <A-1b>. (yield 74%)

### Synthesis Example 9-2. Synthesis of I-2

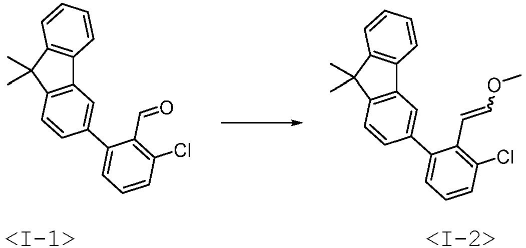

<I-2> was synthesized in the same manner as in Synthesis Example 1-2, with the exception of using <I-1> instead of <A-1>. (yield 93%)

### Synthesis Example 9-3. Synthesis of I-3

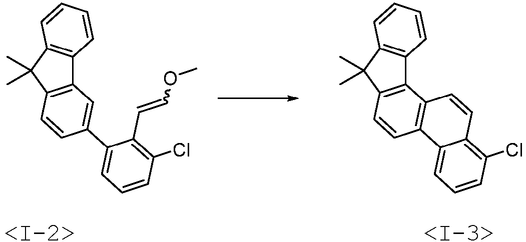

<I-3> was synthesized in the same manner as in Synthesis Example 1-3, with the exception of using <I-2> instead of <A-2>. (yield 54%)

### Synthesis Example 9-4. Synthesis of I-4

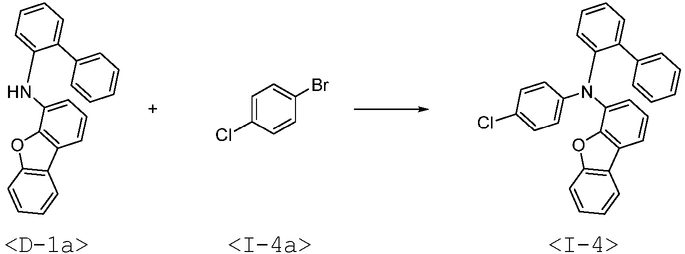

<I-4> was synthesized in the same manner as in Synthesis Example 1-5, with the exception of using <I-4a> and <D-1a> instead of <A-4> and <A-5a>, respectively. (yield 61%)

### Synthesis Example 9-5. Synthesis of I-5

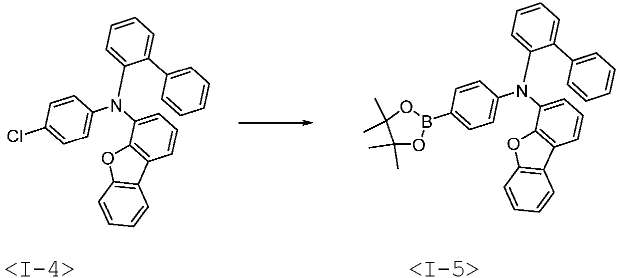

In a reactor, <I-4> (15 g), bispinacolate diboron (13.9 g), tris(dibenzylideneacetone) palladium (1.67 g), Sphos (1.5 g), and 1,4-dioxane (150 mL) were stirred together for 4 hours. After completion of the reaction, the layers thus formed were separated. The organic layer was concentrated in a vacuum, followed by purification through column chromatography to afford <I-5>. (20 g, 82%)

### Synthesis Example 9-6. Synthesis of I-6

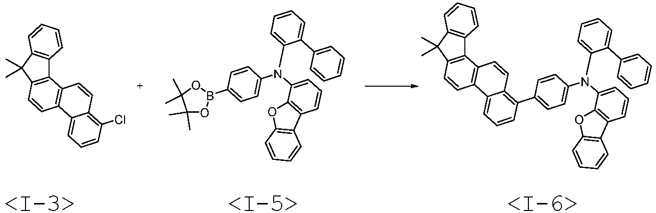

In a reactor, <I-3> (18 g), <I-5> (29.42 g), tetrakis(triphenylphosphine)palladium (3.16 g), potassium carbonate (18.91 g), toluene (72 mL), ethanol (54 mL), and water (54 mL) were refluxed together for 2 hours under a nitrogen atmosphere. After completion of the reaction, the layers thus formed were separated. The organic layer was concentrated in a vacuum, followed by purification through column chromatography to afford <I-6>. (16.5 g, 52%)

### Synthesis Example 9-7. Synthesis of [Compound 1-38]

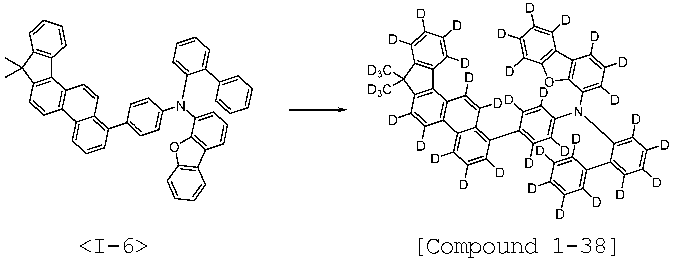

[Compound 1-38] was synthesized in the same manner as in Synthesis Example 1-4, with the exception of using <I-6> instead of <A-3>. (yield 77%)
MS (MALDI-TOF) : m/z 740.52 [M⁺]

### SYNTHESIS EXAMPLE 10. Synthesis of [Compound 1-107]

### Synthesis Example 10-1. Synthesis of J-1

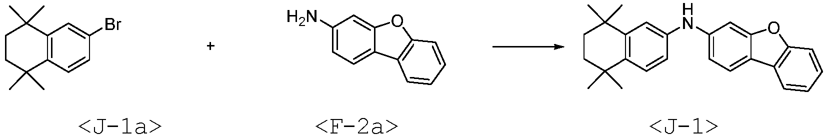

In a reactor, <J-1a> (30 g), <F-2a> (21.6 g), tris(dibenzylidene acetone) dipalladium (2.06 g), sodium t-butoxide (22 g), BINAP (1.84 g), and toluene (300 mL) were refluxed together for 2 hours under a nitrogen atmosphere. After completion of the reaction, the layers thus formed were separated. The organic layer was concentrated in a vacuum, followed by purification through column chromatography to afford <J-1>. (37.3 g, 90%)

### Synthesis Example 10-2. Synthesis of [Compound 1-107]

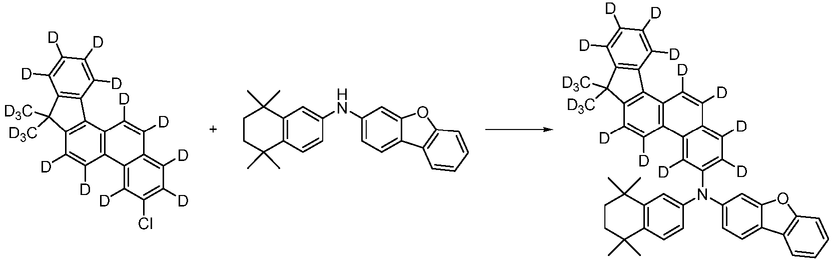

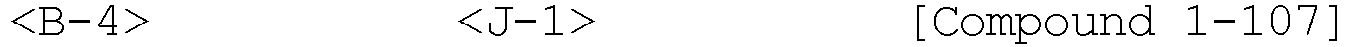

[Compound 1-107] was synthesized in the same manner as in Synthesis Example 1-5, with the exception of using <B-4> and <J-1> instead of <A-4> and <A-5a>, respectively. (yield 54%)
MS (MALDI-TOF) : m/z 678.44 [M⁺]

### SYNTHESIS EXAMPLE 11. Synthesis of [Compound 1-108]

### Synthesis Example 11-1. Synthesis of K-1

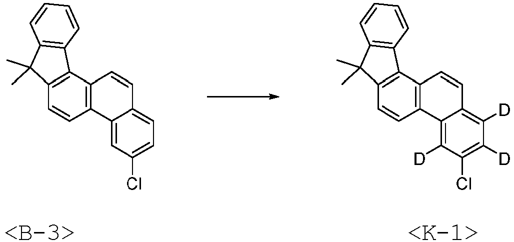

In a reactor, <B-3> (20 g), silver carbonate (3.35 g), cyclohexyldiphenyl phosphine (8.16 g), potassium carbonate (8.40 g), and deuterated water (24.4 g) were refluxed together. After 12 hours, the mixture was cooled to room temperature and added with a saturated ammonium chloride aqueous solution. The layers thus formed were separated and the organic layer was concentrated in a vacuum, followed by purification through column chromatography to afford <K-1>. (18.2 g, 90%)

### Synthesis Example 11-2. Synthesis of K-2

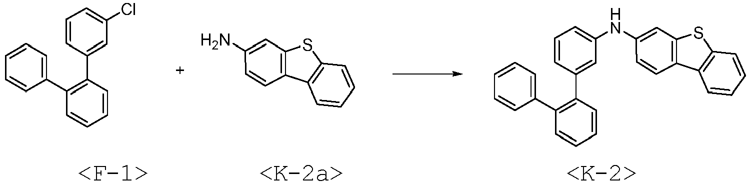

<K-2> was synthesized in the same manner as in Synthesis Example 6-2, with the exception of using <K-2a> instead of <F-2a>. (yield 71%)

### Synthesis Example 11-3. Synthesis of [Compound 1-108]

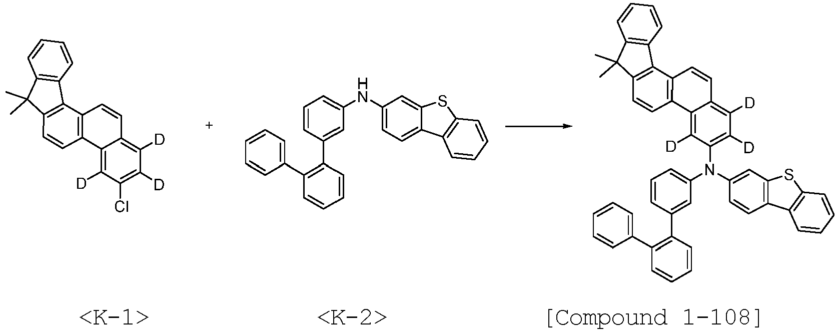

[Compound 1-108] was synthesized in the same manner as in Synthesis Example 1-5, with the exception of using <K-1> and <K-2> instead of <A-4> and <A-5a>, respectively. (yield 60%)
MS (MALDI-TOF) : m/z 722.28 [M⁺]

### SYNTHESIS EXAMPLE 12. Synthesis of [Compound 2-12]

### Synthesis Example 12-1. Synthesis of [Compound 2-12]

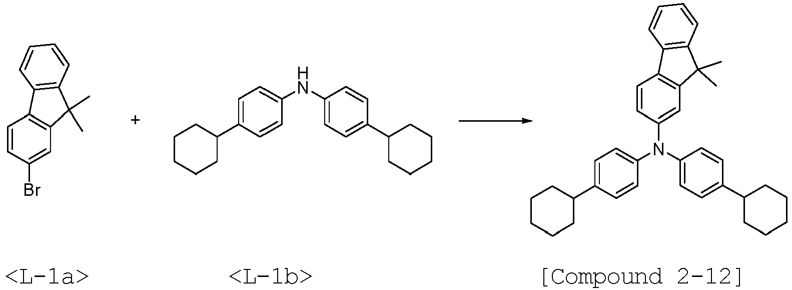

[Compound 2-12] was synthesized in the same manner as in Synthesis Example 1-5, with the exception of using <L-1a> and <L-1b> instead of <A-4> and <A-5a>, respectively. (yield 53%)
MS (MALDI-TOF) : m/z 525.34 [M⁺]

### SYNTHESIS EXAMPLE 13. Synthesis of [Compound 2-30]

### Synthesis Example 13-1. Synthesis of M-1

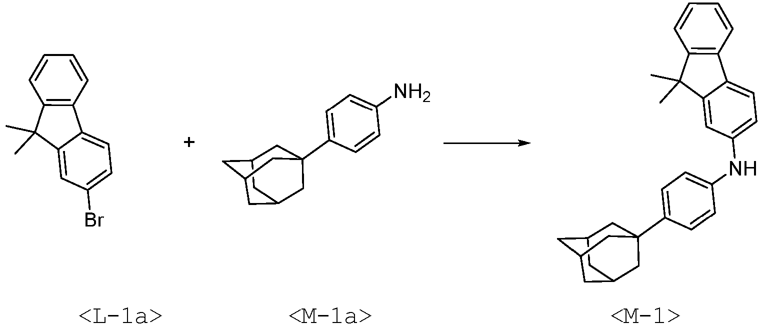

<M-1> was synthesized in the same manner as in Synthesis Example 10-1, with the exception of using <L-1a> and <M-1a> instead of <J-1a> and <F-2a>, respectively. (yield 89%)

### Synthesis Example 13-2. Synthesis of [Compound 2-30]

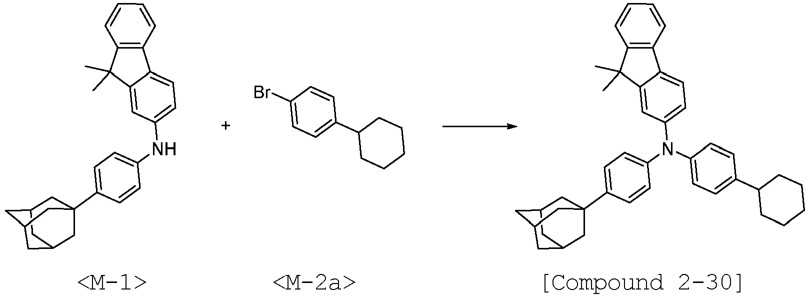

[Compound 2-30] was synthesized in the same manner as in Synthesis Example 1-5, with the exception of using <M-2a> and <M-1> instead of <A-4> and <A-5a>, respectively. (yield 59%)
MS (MALDI-TOF) : m/z 577.37 [M⁺]

### SYNTHESIS EXAMPLE 14. Synthesis of [Compound 2-33]

### Synthesis Example 14-1. Synthesis of [Compound 2-33]

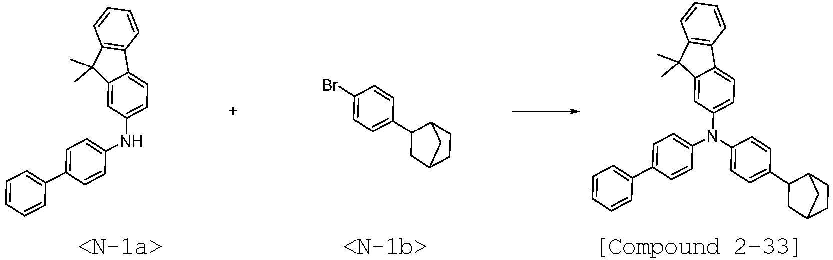

[Compound 2-33] was synthesized in the same manner as in Synthesis Example 1-5, with the exception of using <N-1b> and <N-1a> instead of <A-4> and <A-5a>, respectively. (yield 56%)
MS (MALDI-TOF) : m/z 531.29 [M⁺]

### SYNTHESIS EXAMPLE 15. Synthesis of [Compound 3-11]

### Synthesis Example 15-1. Synthesis of O-1

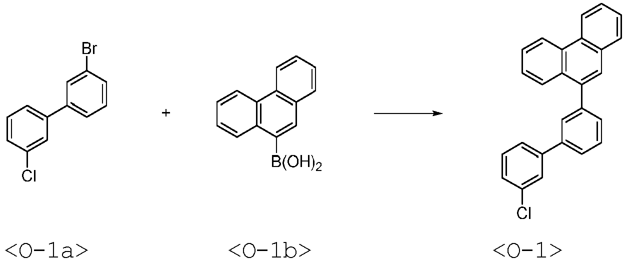

<O-1> was synthesized in the same manner as in Synthesis Example 1-1, with the exception of using <O-1b> and <O-1a> instead of <A-1a> and <A-1b>, respectively. (yield 81%)

### Synthesis Example 15-2. Synthesis of [Compound 3-11]

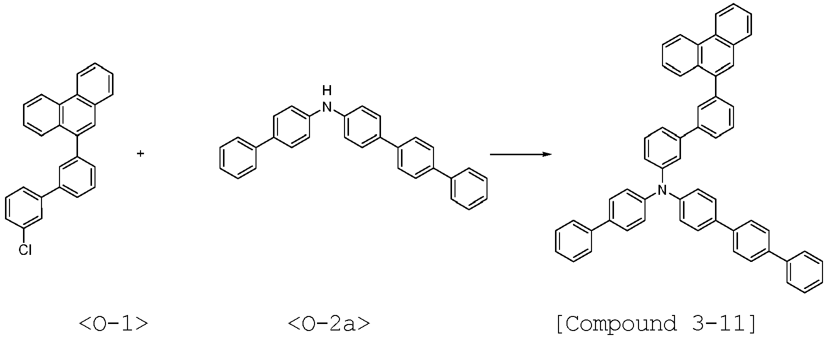

[Compound 3-11] was synthesized in the same manner as in Synthesis Example 1-5, with the exception of using <O-1> and <O-2a> instead of <A-4> and <A-5a>, respectively. (yield 58%)
MS (MALDI-TOF) : m/z 725.31 [M⁺]

### SYNTHESIS EXAMPLE 16. Synthesis of [Compound 3-13]

### Synthesis Example 16-1. Synthesis of P-1

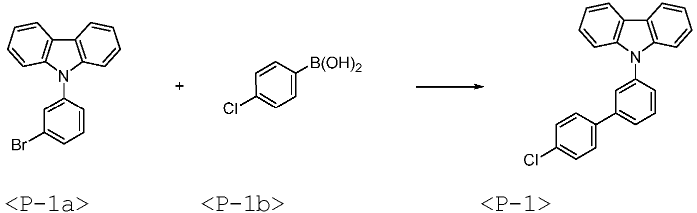

<P-1> was synthesized in the same manner as in Synthesis Example 1-1, with the exception of using <P-1b> and <P-1a> instead of <A-1a> and <A-1b>, respectively. (yield 81%)

### Synthesis Example 16-2. Synthesis of [Compound 3-13]

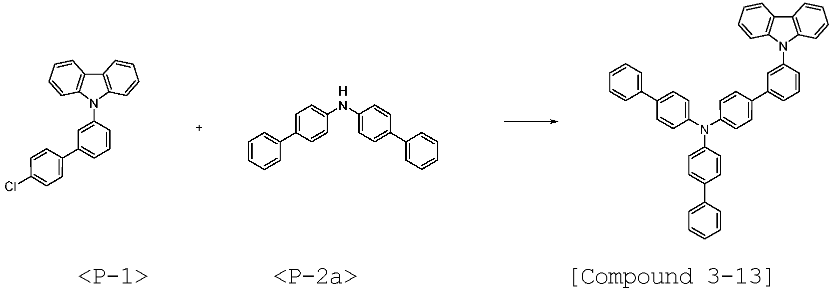

[Compound 3-13] was synthesized in the same manner as in Synthesis Example 1-5, with the exception of using <P-1> and <P-2a> instead of <A-4> and <A-5a>, respectively. (yield 53%)
MS (MALDI-TOF) : m/z 638.27 [M⁺]

### SYNTHESIS EXAMPLE 17. Synthesis of [Compound 3-25]

### Synthesis Example 17-1. Synthesis of [Compound 3-25]

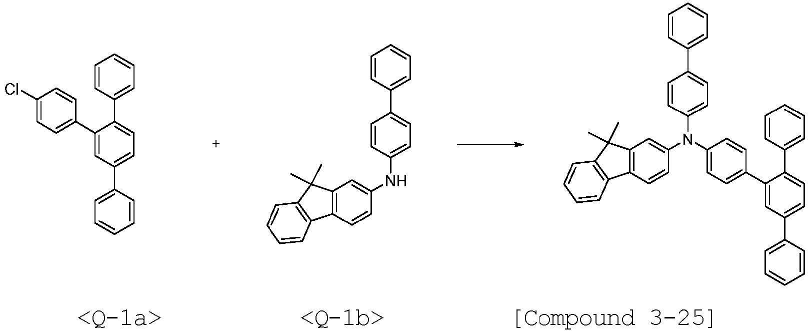

[Compound 3-25] was synthesized in the same manner as in Synthesis Example 1-5, with the exception of using and <Q-1a> synthesized as taught in Angewandte Chemie, International Edition (2016),55(27),7728 and <Q-1b> instead of <A-4> and <A-5a>, respectively. (yield 51%)
MS (MALDI-TOF) : m/z 665.31 [M⁺]

### SYNTHESIS EXAMPLE 18. Synthesis of [Compound 3-34]

### Synthesis Example 18-1. Synthesis of [Compound 3-34]

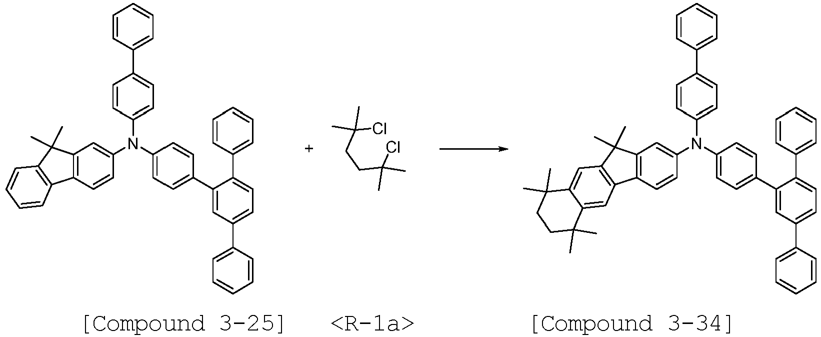

In a reactor, a mixture of [Compound 3-25] (17 g), aluminum chloride (10.2 g), and methylene chloride (170 mL) was cooled to 0°C under a nitrogen atmosphere. One hour after <R-1a> (7.01 g) was added, a saturated sodium hydrogen carbonate aqueous solution was introduced. The layers thus formed were separated, and the organic layer was concentrated, followed by purification through column chromatography to afford [Compound 3-34]. (yield 45%)
MS (MALDI-TOF) : m/z 775.42 [M⁺]

### SYNTHESIS EXAMPLE 19. [RPH-1]

### Synthesis Example 19-1. Synthesis of S-1

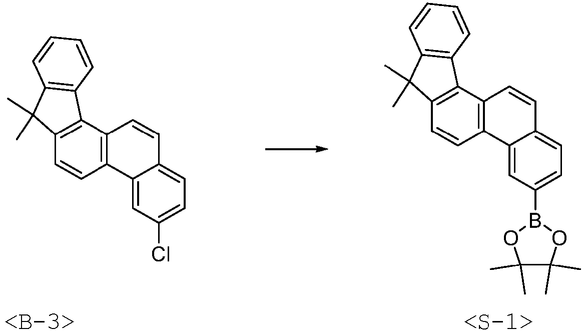

<S-1> was synthesized in the same manner as in Synthesis Example 9-5, with the exception of using <B-3> instead of <I-4>. (yield 83%)

### Synthesis Example 19-2. Synthesis of [RPH-1]

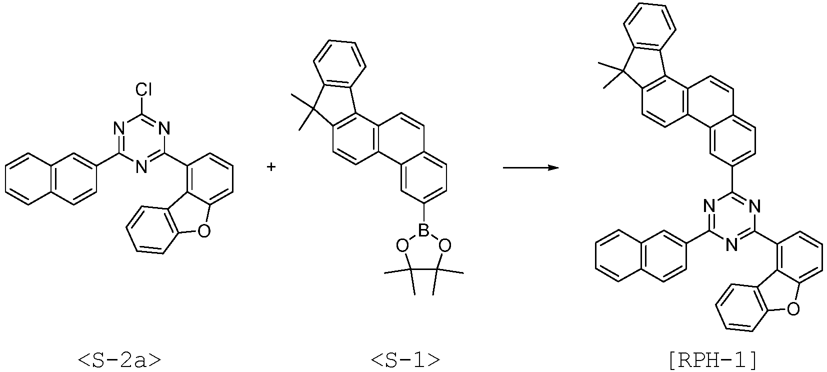

[RPH-1] was synthesized in the same manner as in Synthesis Example 9-6, with the exception of using <S-2a> and <S-1> instead of <I-3> and <I-5>, respectively. (yield 54%)
MS (MALDI-TOF) : m/z 665.25 [M⁺]

### SYNTHESIS EXAMPLE 20. [RPH-2]

### Synthesis Example 20-1. Synthesis of T-1

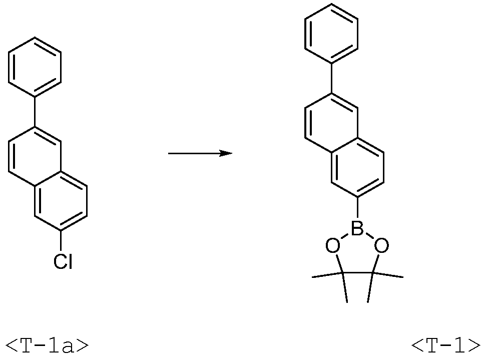

<T-1> was synthesized in the same manner as in Synthesis Example 9-5, with the exception of using <T-1a> instead of <I-4>. (yield 77%)

### Synthesis Example 20-2. Synthesis of [RPH-2]

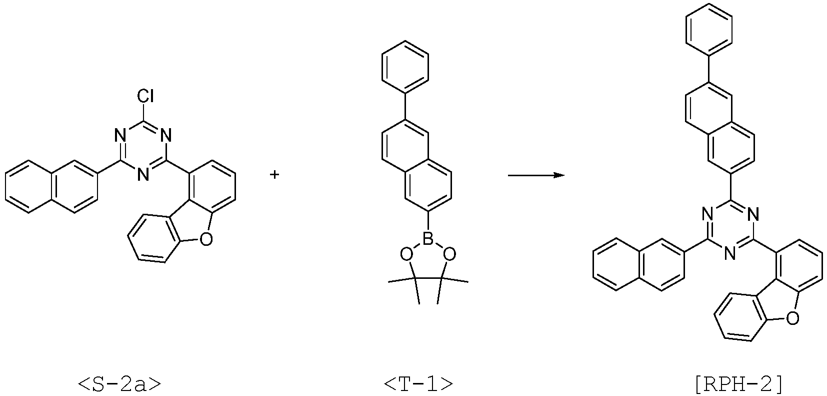

[RPH-2] was synthesized in the same manner as in Synthesis Example 9-6, with the exception of using <S-2a> and <T-1> instead of <I-3> and <I-5>, respectively. (yield 59%)
MS (MALDI-TOF) : m/z 575.20 [M⁺]

### EXAMPLE 1 TO 55 : Fabrication of Organic Light-Emitting Diodes

An ITO glass substrate was patterned to have a translucent area of 2 mm x 2 mm and cleansed. The ITO glass was mounted in a vacuum chamber that was then set to have a base pressure of 1x10-6 torr. On the ITO glass substrate, HAT-CN (50 Å) and NPD (1500 Å) were sequentially deposited to form a hole injection layer and hole transport layer, respectively. Then, the emitting-auxiliary compound was deposited to form a film (750 Å) as an emitting-auxiliary layer. Thereafter, a light-emitting layer (400 Å) was formed of a 1:1 mixture of the host compound according to the present disclosure and one of the following [RPH-1] to [RPH-3], and the dopant compound [RD] (5 wt%), followed by sequentially forming ET : Liq = 1:1 (300 Å) as electron transport and electron injection layers, respectively. A cathode was formed by depositing Al (1000 Å), thereby fabricating an organic light-emitting diode. The organic light-emitting diodes thus obtained were measured at 0.4 mA for luminescence properties:

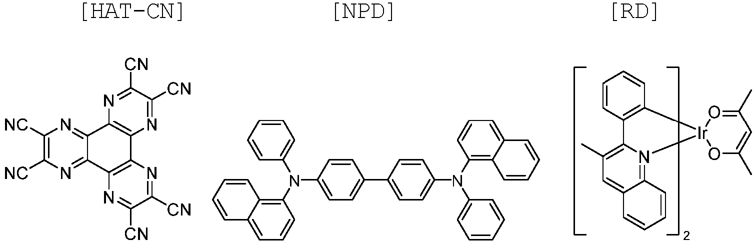

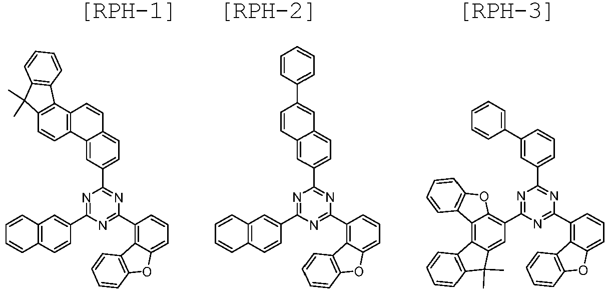

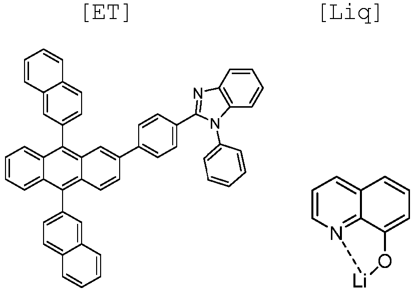

### COMPARATIVE EXAMPLES 1 TO 31

Organic light-emitting diodes for the Comparative Examples were fabricated in the same manner as in the Examples, with the exception of using following [RH-1] or [RH-2] and the following [RP-1] or [RP-2] as hosts and emitting-auxiliary layer compounds, respectively, instead of the compounds according to the present disclosure.

Here, the structures of [RH-1], [RH-2], [RP-1] and [RP-2] are as follows:

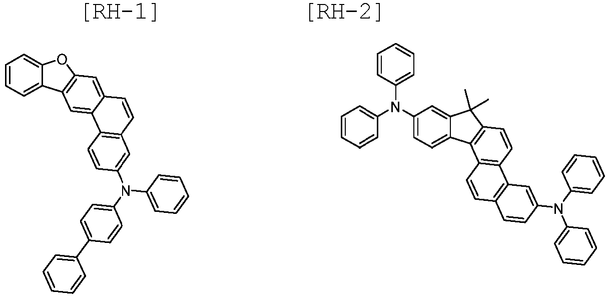

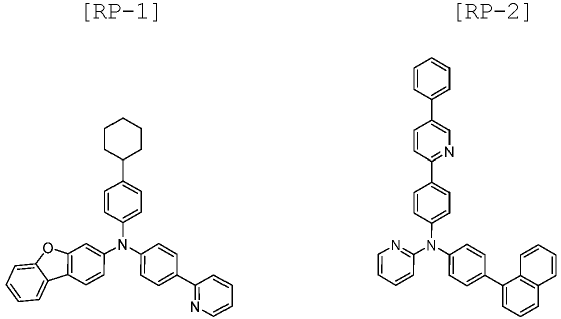

**TABLE 1**

| Ex. No. | 1^{st} Host | 2^{nd} Host | Emitt ing-Aux. Layer | Driving Volt. (V) | Emission Effici. (Cd/A) | Lifespan (T95, hr) | Light Color |
|---|---|---|---|---|---|---|---|
| Ex. 1 | 1-1 | RPH-1 | 2-12 | 3.59 | 28.8 | 193 | Red |
| Ex. 2 | 1-2 | RPH-1 | 2-12 | 3.57 | 29.1 | 188 | Red |
| Ex. 3 | 1-3 | RPH-1 | 2-12 | 3.56 | 29.0 | 176 | Red |
| Ex. 4 | 1-7 | RPH-1 | 2-12 | 3.58 | 28.9 | 197 | Red |
| Ex. 5 | 1-10 | RPH-1 | 2-12 | 3.60 | 28.5 | 170 | Red |
| Ex. 6 | 1-15 | RPH-1 | 2-12 | 3.54 | 29.4 | 193 | Red |
| Ex. 7 | 1-17 | RPH-1 | 2-12 | 3.57 | 28.0 | 159 | Red |
| Ex. 8 | 1-32 | RPH-1 | 2-12 | 3.59 | 28.9 | 183 | Red |
| Ex. 9 | 1-38 | RPH-1 | 2-12 | 3.60 | 28.8 | 195 | Red |
| Ex. 10 | 1-107 | RPH-1 | 2-12 | 3.63 | 28.3 | 164 | Red |
| Ex. 11 | 1-108 | RPH-1 | 2-12 | 3.51 | 28.2 | 150 | Red |
| Ex. 12 | 1-1 | RPH-1 | 2-30 | 3.57 | 29.1 | 197 | Red |
| Ex. 13 | 1-3 | RPH-1 | 2-30 | 3.56 | 29.3 | 183 | Red |
| Ex. 14 | 1-10 | RPH-1 | 2-30 | 3.59 | 29.2 | 180 | Red |
| Ex. 15 | 1-17 | RPH-1 | 2-30 | 3.57 | 28.4 | 171 | Red |
| Ex. 16 | 1-38 | RPH-1 | 2-30 | 3.61 | 29.0 | 193 | Red |
| Ex. 17 | 1-107 | RPH-1 | 2-30 | 3.60 | 28.9 | 185 | Red |
| Ex. 18 | 1-7 | RPH-1 | 2-33 | 3.50 | 28.1 | 197 | Red |
| Ex. 19 | 1-15 | RPH-1 | 2-33 | 3.48 | 28.6 | 193 | Red |
| Ex. 20 | 1-17 | RPH-1 | 2-33 | 3.49 | 28.3 | 159 | Red |
| Ex. 21 | 1-32 | RPH-1 | 2-33 | 3.51 | 28.1 | 183 | Red |
| Ex. 22 | 1-38 | RPH-1 | 2-33 | 3.53 | 27.9 | 195 | Red |
| Ex. 23 | 1-107 | RPH-1 | 2-33 | 3.55 | 27.6 | 164 | Red |
| Ex. 24 | 1-2 | RPH-1 | 3-11 | 3.51 | 27.3 | 163 | Red |
| Ex. 25 | 1-7 | RPH-1 | 3-11 | 3.52 | 27.7 | 157 | Red |
| Ex. 26 | 1-15 | RPH-1 | 3-11 | 3.51 | 27.5 | 161 | Red |
| Ex. 27 | 1-32 | RPH-1 | 3-11 | 3.50 | 27.6 | 154 | Red |
| Ex. 28 | 1-38 | RPH-1 | 3-11 | 3.50 | 27.1 | 167 | Red |
| Ex. 29 | 1-107 | RPH-1 | 3-11 | 3.54 | 27.3 | 153 | Red |
| Ex. 30 | 1-1 | RPH-1 | 3-13 | 3.53 | 27.0 | 150 | Red |
| Ex. 31 | 1-2 | RPH-1 | 3-13 | 3.57 | 27.1 | 148 | Red |
| Ex. 32 | 1-7 | RPH-1 | 3-13 | 3.58 | 26.9 | 153 | Red |
| Ex. 33 | 1-10 | RPH-1 | 3-13 | 3.60 | 27.1 | 154 | Red |
| Ex. 34 | 1-32 | RPH-1 | 3-13 | 3.59 | 27.3 | 149 | Red |
| Ex. 35 | 1-38 | RPH-1 | 3-13 | 3.60 | 27.2 | 151 | Red |
| Ex. 36 | 1-3 | RPH-1 | 3-25 | 3.58 | 27.5 | 163 | Red |
| Ex. 37 | 1-7 | RPH-1 | 3-25 | 3.59 | 27.3 | 148 | Red |
| Ex. 38 | 1-10 | RPH-1 | 3-25 | 3.64 | 27.6 | 152 | Red |
| Ex. 39 | 1-17 | RPH-1 | 3-25 | 3.61 | 27.5 | 151 | Red |
| Ex. 40 | 1-32 | RPH-1 | 3-25 | 3.62 | 27.3 | 155 | Red |
| Ex. 41 | 1-38 | RPH-1 | 3-25 | 3.63 | 27.3 | 151 | Red |
| Ex. 42 | 1-7 | RPH-1 | 3-34 | 3.57 | 26.7 | 141 | Red |
| Ex. 43 | 1-10 | RPH-1 | 3-34 | 3.53 | 26.8 | 143 | Red |
| Ex. 44 | 1-17 | RPH-1 | 3-34 | 3.55 | 26.9 | 146 | Red |
| Ex. 45 | 1-32 | RPH-1 | 3-34 | 3.57 | 26.7 | 149 | Red |
| Ex. 46 | 1-38 | RPH-1 | 3-34 | 3.58 | 26.7 | 141 | Red |
| Ex. 47 | 1-107 | RPH-1 | 3-34 | 3.52 | 26.6 | 140 | Red |
| Ex. 48 | 1-7 | RPH-2 | 2-12 | 3.49 | 30.0 | 250 | Red |
| Ex. 49 | 1-17 | RPH-2 | 2-12 | 3.50 | 29.1 | 206 | Red |
| Ex. 50 | 1-38 | RPH-2 | 3-13 | 3.49 | 28.4 | 203 | Red |
| Ex. 51 | 1-107 | RPH-2 | 3-13 | 3.41 | 27.9 | 200 | Red |
| Ex. 52 | 1-7 | RPH-3 | 2-30 | 3.40 | 29.2 | 233 | Red |
| Ex. 53 | 1-17 | RPH-3 | 2-30 | 3.48 | 29.5 | 220 | Red |
| Ex. 54 | 1-32 | RPH-3 | 3-34 | 3.49 | 27.8 | 200 | Red |
| Ex. 55 | 1-38 | RPH-3 | 3-34 | 3.49 | 27.9 | 193 | Red |
| C. Ex. 1 | RH-1 | RPH-1 | 2-12 | 4.03 | 21.6 | 80 | Red |
| C. Ex. 2 | RH-1 | RPH-1 | 2-30 | 4.01 | 21.9 | 84 | Red |
| C. Ex. 3 | RH-1 | RPH-1 | 2-33 | 3.91 | 21.1 | 82 | Red |
| C. Ex. 4 | RH-1 | RPH-1 | 3-11 | 3.96 | 20.8 | 60 | Red |
| C. Ex. 5 | RH-1 | RPH-1 | 3-13 | 3.95 | 21.2 | 49 | Red |
| C. Ex. 6 | RH-1 | RPH-1 | 3-25 | 4.05 | 20.1 | 67 | Red |
| C. Ex. 7 | RH-2 | RPH-1 | 2-12 | 3.92 | 21.3 | 83 | Red |
| C. Ex. 8 | RH-2 | RPH-1 | 2-30 | 3.96 | 21.5 | 71 | Red |
| C. Ex. 9 | RH-2 | RPH-1 | 2-33 | 3.83 | 21.2 | 69 | Red |
| C. Ex. 10 | RH-2 | RPH-1 | 3-11 | 3.85 | 21.0 | 67 | Red |
| C. Ex. 11 | RH-2 | RPH-1 | 3-13 | 3.87 | 20.3 | 55 | Red |
| C. Ex. 12 | RH-2 | RPH-1 | 3-25 | 3.91 | 19.9 | 63 | Red |
| C. Ex. 13 | RH-1 | RPH-1 | RP-1 | 4.83 | 15.1 | 33 | Red |
| C. Ex. 14 | RH-1 | RPH-1 | RP-2 | 4.91 | 13.8 | 30 | Red |
| C. Ex. 15 | RH-2 | RPH-1 | RP-1 | 4.80 | 15.1 | 29 | Red |
| C. Ex. 16 | RH-2 | RPH-1 | RP-2 | 4.87 | 14.1 | 25 | Red |
| C. Ex. 17 | 1-1 | RPH-1 | RP-1 | 4.52 | 19.3 | 28 | Red |
| C. Ex. 18 | 1-7 | RPH-1 | RP-1 | 4.53 | 19.2 | 30 | Red |
| C. Ex. 19 | 1-17 | RPH-1 | RP-1 | 4.51 | 18.6 | 31 | Red |
| C. Ex. 20 | 1-1 | RPH-1 | RP-2 | 4.60 | 16.9 | 25 | Red |
| C. Ex. 21 | 1-7 | RPH-1 | RP-2 | 4.61 | 17.9 | 27 | Red |
| C. Ex. 22 | 1-17 | RPH-1 | RP-2 | 4.59 | 17.3 | 28 | Red |
| C. Ex. 23 | 1-1 | RPH-1 | - | 4.60 | 20.8 | 113 | Red |
| C. Ex. 24 | 1-7 | RPH-1 | - | 4.61 | 20.4 | 110 | Red |
| C. Ex. 25 | 1-17 | RPH-1 | - | 4.57 | 20.3 | 105 | Red |
| C. Ex. 26 | 1-17 | RPH-2 | RP-1 | 4.41 | 19.3 | 67 | Red |
| C. Ex. 27 | 1-17 | RPH-2 | RP-2 | 4.50 | 18.4 | 49 | Red |
| C. Ex. 28 | 1-17 | RPH-2 | - | 4.50 | 21.3 | 137 | Red |
| C. Ex. 29 | 1-17 | RPH-3 | RP-1 | 4.40 | 20.0 | 57 | Red |
| C. Ex. 30 | 1-17 | RPH-3 | RP-2 | 4.49 | 19.1 | 40 | Red |
| C. Ex. 31 | 1-17 | RPH-3 | - | 4.51 | 22.0 | 119 | Red |

As shown in Table 1, the organic light emitting diodes employing the compounds according to the present disclosure in a light-emitting layer and an emitting-auxiliary layer formed between the light emitting layer and the hole transport layer demonstrates a high-efficiency and long-lifespan with excellent luminous efficiency and lifetime characteristics at low driving voltage, compared to organic light emitting diodes using conventional compound (Comparative Examples 1 to 31).

### EXAMPLES 56 TO 101 : Fabrication of Organic Light-Emitting Diodes

Organic light-emitting diodes were fabricated in the same manner as in Examples 1 to 55, with the exception that two different compounds, rather than a single compound, were respectively used as the first and second emitting-auxiliary layer materials, as shown in Table 2 below. The light-emission characteristics of the OLEDs were measured at 0.4 mA, and the results are shown in Table 2.

### COMPARATIVE EXAMPLES 32 TO 51 : Fabrication of Organic Light-Emitting Diodes

Organic light-emitting diodes for the Comparative Examples were fabricated in the same structure as in the Examples, except that RH-1 or RH-2 was used as the host compound in the emitting layer instead of the compound according to the present disclosure, or RP-1 and RP-2 were used as the emitting-auxiliary layer compounds instead of the compound according to the present disclosure. The light-emission characteristics of the OLEDs were measured at 0.4 mA.

**TABLE 2**

| Ex. No. | 1^{st} Host | 2^{nd} Host | 1^{st} Aux. Layer | 2^{nd} Aux. layer | Driving Volt. (V) | Emission Effici. (Cd/A) | Lifespan (T95,hr) | Light Color |
|---|---|---|---|---|---|---|---|---|
| Ex. 56 | 1-1 | RPH-1 | 2-12 | 3-11 | 3.46 | 29.7 | 231 | Red |
| Ex. 57 | 1-1 | RPH-1 | 2-12 | 3-13 | 3.46 | 29.2 | 215 | Red |
| Ex. 58 | 1-1 | RPH-1 | 2-12 | 3-25 | 3.48 | 28.2 | 217 | Red |
| Ex. 59 | 1-1 | RPH-1 | 2-12 | 3-34 | 3.45 | 27.5 | 200 | Red |
| Ex. 60 | 1-1 | RPH-1 | 2-30 | 3-11 | 3.44 | 30.0 | 235 | Red |
| Ex. 61 | 1-1 | RPH-1 | 2-30 | 3-13 | 3.47 | 29.5 | 219 | Red |
| Ex. 62 | 1-1 | RPH-1 | 2-30 | 3-25 | 3.50 | 28.3 | 204 | Red |
| Ex. 63 | 1-1 | RPH-1 | 2-30 | 3-34 | 3.45 | 28.0 | 200 | Red |
| Ex. 64 | 1-1 | RPH-1 | 2-33 | 3-11 | 3.40 | 29.6 | 227 | Red |
| Ex. 65 | 1-1 | RPH-1 | 2-33 | 3-13 | 3.41 | 29.1 | 221 | Red |
| Ex. 66 | 1-1 | RPH-1 | 2-33 | 3-25 | 3.43 | 27.8 | 216 | Red |
| Ex. 67 | 1-1 | RPH-1 | 2-33 | 3-34 | 3.40 | 28.2 | 213 | Red |
| Ex. 68 | 1-15 | RPH-1 | 2-12 | 3-11 | 3.41 | 30.1 | 228 | Red |
| Ex. 69 | 1-15 | RPH-1 | 2-12 | 3-13 | 3.42 | 29.6 | 215 | Red |
| Ex. 70 | 1-15 | RPH-1 | 2-12 | 3-25 | 3.44 | 28.8 | 220 | Red |
| Ex. 71 | 1-15 | RPH-1 | 2-12 | 3-34 | 3.41 | 28.1 | 203 | Red |
| Ex. 72 | 1-15 | RPH-1 | 2-30 | 3-11 | 3.39 | 30.0 | 221 | Red |
| Ex. 73 | 1-15 | RPH-1 | 2-30 | 3-13 | 3.42 | 29.9 | 219 | Red |
| Ex. 74 | 1-15 | RPH-1 | 2-30 | 3-25 | 3.45 | 28.9 | 200 | Red |
| Ex. 75 | 1-15 | RPH-1 | 2-30 | 3-34 | 3.40 | 28.6 | 205 | Red |
| Ex. 76 | 1-15 | RPH-1 | 2-33 | 3-11 | 3.41 | 29.8 | 223 | Red |
| Ex. 77 | 1-15 | RPH-1 | 2-33 | 3-13 | 3.40 | 30.1 | 219 | Red |
| Ex. 78 | 1-15 | RPH-1 | 2-33 | 3-25 | 3.39 | 29.9 | 213 | Red |
| Ex. 79 | 1-15 | RPH-1 | 2-33 | 3-34 | 3.40 | 29.2 | 207 | Red |
| Ex. 80 | 1-107 | RPH-1 | 2-12 | 3-11 | 3.50 | 29.2 | 202 | Red |
| Ex. 81 | 1-107 | RPH-1 | 2-12 | 3-13 | 3.50 | 28.7 | 200 | Red |
| Ex. 82 | 1-107 | RPH-1 | 2-12 | 3-25 | 3.52 | 27.7 | 203 | Red |
| Ex. 83 | 1-107 | RPH-1 | 2-12 | 3-34 | 3.49 | 27.0 | 200 | Red |
| Ex. 84 | 1-107 | RPH-1 | 2-30 | 3-11 | 3.48 | 29.5 | 206 | Red |
| Ex. 85 | 1-107 | RPH-1 | 2-30 | 3-13 | 3.51 | 29.0 | 201 | Red |
| Ex. 86 | 1-107 | RPH-1 | 2-30 | 3-25 | 3.54 | 27.8 | 206 | Red |
| Ex. 87 | 1-107 | RPH-1 | 2-30 | 3-34 | 3.49 | 27.5 | 210 | Red |
| Ex. 88 | 1-107 | RPH-1 | 2-33 | 3-11 | 3.44 | 29.1 | 200 | Red |
| Ex. 89 | 1-107 | RPH-1 | 2-33 | 3-13 | 3.45 | 28.6 | 203 | Red |
| Ex. 90 | 1-107 | RPH-1 | 2-33 | 3-25 | 3.47 | 27.3 | 200 | Red |
| Ex. 91 | 1-107 | RPH-1 | 2-33 | 3-34 | 3.44 | 27.7 | 207 | Red |
| Ex. 92 | 1-107 | RPH-1 | 2-12 | 2-33 | 3.53 | 28.5 | 180 | Red |
| Ex. 93 | 1-15 | RPH-2 | 2-12 | 3-11 | 3.33 | 31.2 | 279 | Red |
| Ex. 94 | 1-15 | RPH-2 | 2-12 | 3-34 | 3.32 | 29.2 | 250 | Red |
| Ex. 95 | 1-15 | RPH-2 | 2-30 | 3-13 | 3.33 | 31.0 | 271 | Red |
| Ex. 96 | 1-15 | RPH-2 | 2-30 | 3-25 | 3.40 | 30.1 | 261 | Red |
| Ex. 97 | 1-15 | RPH-2 | 3-11 | 3-34 | 3.53 | 27.9 | 173 | Red |
| Ex. 98 | 1-107 | RPH-3 | 2-12 | 3-11 | 3.39 | 30.0 | 223 | Red |
| Ex. 99 | 1-107 | RPH-3 | 2-12 | 3-34 | 3.39 | 28.3 | 216 | Red |
| Ex. 100 | 1-107 | RPH-3 | 2-30 | 3-13 | 3.34 | 30.3 | 231 | Red |
| Ex. 101 | 1-107 | RPH-3 | 2-30 | 3-25 | 3.40 | 29.9 | 231 | Red |
| C. Ex. 32 | RH-1 | RPH-1 | 2-12 | 3-13 | 4.23 | 21.6 | 117 | Red |
| C. Ex. 33 | RH-1 | RPH-1 | 2-12 | 3-25 | 4.31 | 21.4 | 119 | Red |
| C. Ex. 34 | RH-1 | RPH-1 | 2-30 | 3-13 | 4.21 | 21.9 | 113 | Red |
| C. Ex. 35 | RH-1 | RPH-1 | 2-30 | 3-25 | 4.27 | 21.8 | 115 | Red |
| C. Ex. 36 | RH-1 | RPH-1 | 2-33 | 3-13 | 4.15 | 20.8 | 110 | Red |
| C. Ex. 37 | RH-1 | RPH-1 | 2-33 | 3-25 | 4.20 | 20.5 | 106 | Red |
| C. Ex. 38 | RH-2 | RPH-1 | 2-12 | 3-13 | 4.12 | 21.3 | 114 | Red |
| C. Ex. 39 | H-2 | RPH-1 | 2-12 | 3-25 | 4.20 | 21.1 | 120 | Red |
| C. Ex. 40 | RH-2 | RPH-1 | 2-30 | 3-13 | 4.10 | 21.5 | 116 | Red |
| C. Ex. 41 | RH-2 | RPH-1 | 2-30 | 3-25 | 4.16 | 21.5 | 118 | Red |
| C. Ex. 42 | RH-2 | RPH-1 | 2-33 | 3-13 | 4.04 | 20.6 | 113 | Red |
| C. Ex. 43 | RH-2 | RPH-1 | 2-33 | 3-25 | 4.09 | 20.2 | 109 | Red |
| C. Ex. 44 | 1-15 | RPH-1 | RP-1 | RP-2 | 4.98 | 13.4 | 23 | Red |
| C. Ex. 45 | 1-107 | RPH-1 | RP-1 | RP-2 | 4.99 | 12.5 | 21 | Red |
| C. Ex. 46 | 1-107 | RPH-2 | RP-1 | RP-2 | 4.87 | 13.7 | 10 | Red |
| C. Ex. 47 | RH-1 | RPH-2 | 2-30 | 3-25 | 4.17 | 23.0 | 167 | Red |
| C. Ex. 48 | RH-2 | RPH-2 | 2-33 | 3-11 | 3.94 | 22.1 | 161 | Red |
| C. Ex. 49 | 1-107 | RPH-3 | RP-1 | RP-2 | 4.76 | 15.1 | 17 | Red |
| C. Ex. 5C | RH-1 | RPH-3 | 2-12 | 3-13 | 4.11 | 22.7 | 111 | Red |
| C. Ex. 51 | RH-2 | RPH-3 | 2-33 | 3-25 | 3.97 | 21.3 | 102 | Red |

As shown in Table 2, the OLEDs employing the host compound for the emitting layer, the first emitting-auxiliary layer compound, and the second an emitting-auxiliary layer compound according to the present disclosure demonstrate significantly improved luminous efficiency and lifetime characteristics at low driving voltage. This result confirms that the OLEDs of the present disclosure, which utilize structurally distinctive compounds, provide superior high-efficiency and long-lifespan performance compared to OLEDs employing conventional comparative compounds (Comparative Examples 32 to 51).

## Claims

1. An organic light emitting diode comprising:
a first electrode;
a second electrode facing the first electrode; and
an organic layer interposed between the first electrode and the second electrode and comprising a light-emitting layer and an emitting-auxiliary layer,
wherein the emitting layer includes at least one amine compound represented by Chemical Formula 1, and the emitting-auxiliary layer includes at least one amine compound represented by Chemical Formula 2 or Chemical Formula 3: 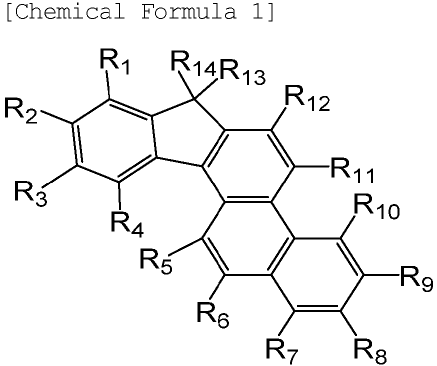 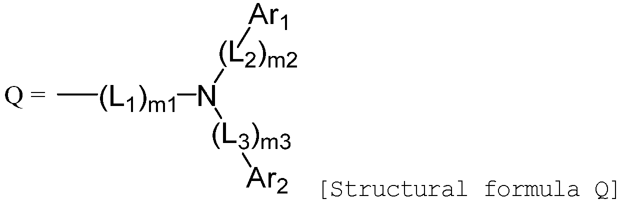 in Chemical Formula 1,
the substituents R₁ to R₄, which are same or different, are each independently one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₅ to R₁₂, which are same or different, are each independently one selected from among a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a substituted or unsubstituted a germanium of 0 to 40 carbon atoms, a nitro, a cyano, a halogen, and the structural formula Q,
one or two of the substituents R₅ to R₁₂ are single bonds connected to the linker L₁ or nitrogen atom (N) within the structural formula Q,
adjacent two of the substituents R₁ to R₁₂ may be linked to each other to form a aliphatic or aromatic single ring or polycyclic fused ring,
the substituents R₁₃ and R₁₄, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₁₃ and R₁₄ may be linked to each other to additionally form an aliphatic or aromatic mono- or polycyclic ring,
the linkers L₁ to L₃, which are same or different, are each independently a single bond or a linker selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
m1 to m3, which are same or different, are each independently 1 or 2, wherein when m1 is 2, the corresponding L₁ radicals are same or different, when m2 is 2, the corresponding L₂ radicals are same or different, and when m3 is 2, the corresponding L₃ radicals are same or different,
Ar₁ and Ar₂, which are same or different, are each independently a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, and a substituted or unsubstituted aliphatic hydrocarbon ring-fused aryl of 8 to 30 carbon atoms; 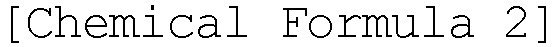 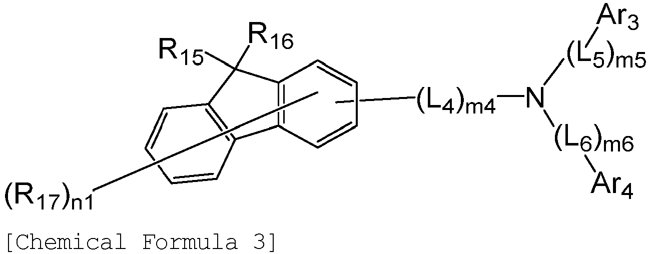 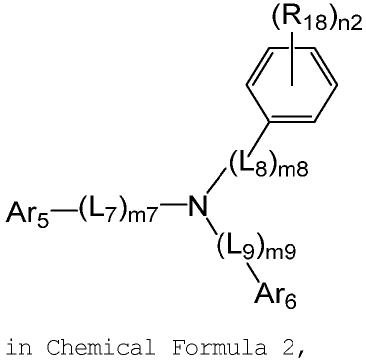
the substituents R₁₅ and R₁₆, which are same or different, are each independently any one selected from among a substituted or unsubstituted alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the substituents R₁₅ and R₁₆ may be linked to each other to additionally form an aliphatic or aromatic mono- or polycyclic ring,
the substituent R₁₇ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
n1 is 7, wherein the corresponding R₁₇ radicals are same or different,
two adjacent substituents R₁₇ radicals may be linked to each other to additionally form an aliphatic or aromatic mono- or polycyclic ring,
the linkers L₄ to L₆, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
m4 to m6, which are same or different, are each independently 1 or 2, wherein when m4 is 2, the corresponding L₄ radicals are same or different, when m5 is 2, the corresponding L₅ radicals are same or different, and when m6 is 2, the corresponding L₆ radicals are same or different,
the substituents Ar₃ and Ar₄, which are same or different, are each independently any one selected from among a substituted or unsubstituted aryl of 6 to 50 carbon atoms, a substituted or unsubstituted cycloalkyl of 3 to 30 carbon atoms, and a substituted or unsubstituted aliphatic hydrocarbon ring-fused aryl of 8 to 30 carbon atoms; and
in Chemical Formula 3,
the substituent R₁₈ is any one selected from among a hydrogen atom, a deuterium atom, a tritium atom, a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
n2 is 5, with the corresponding R₁₈ being same or different,
wherein at least one of the five R₁₈ is a substituted or unsubstituted aryl of 6 to 20 carbon atoms,
two adjacent substituents R₁₈ radicals may be linked to each other to additionally form an aliphatic or aromatic mono- or polycyclic ring,
the linkers L₇ to L₉, which are same or different, are each independently a single bond, or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
m7 to m9, which are same or different, are each independently 1 or 2, wherein when m7 is 2, the corresponding L₇ are same or different, when m8 is 2, the corresponding L₈ are same or different, and when m9 is 2, the corresponding L₉ are same or different,
the substituents Ar₅ and Ar₆, which are same or different, are each independently any one selected from among a substituted or unsubstituted aryl of 6 to 30 carbon atoms, a substituted or unsubstituted cycloalkyl of 3 to 30 carbon atoms, and a substituted or unsubstituted aliphatic hydrocarbon ring-fused aryl of 8 to 30 carbon atoms,
wherein the term "substituted" in the expression "substituted or unsubstituted" used for the compounds of Chemical Formulas 1 to 3 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroaryl alkyl of 3 to 24 carbon atoms, an alkyl heteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a heteroaliphatic ring-fused aryl of 6 to 30 carbon atoms, a heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

2. The organic light-emitting diode of claim 1, wherein the amine compound represented by Chemical Formula 1 is any one of the amine compounds represented by the following Chemical Formulas 1-1 to 1-4: 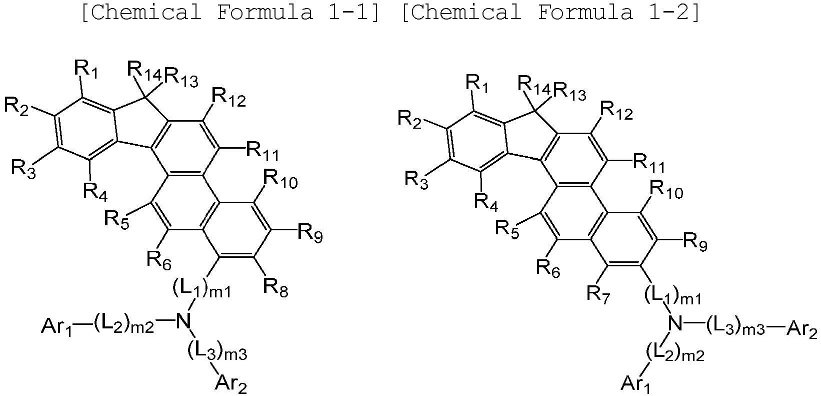 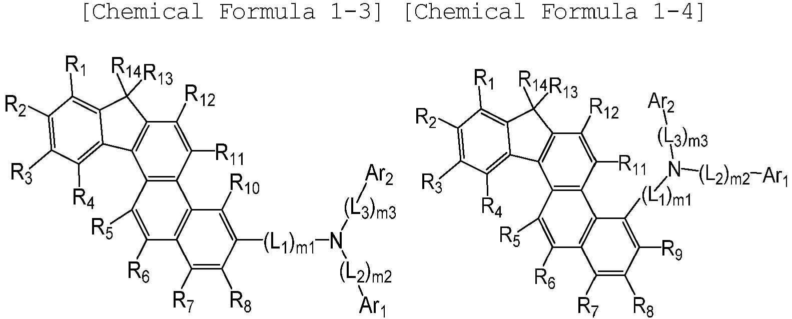 wherein,
the substituents R₁ to R₁₂, which are same or different, are each independently a hydrogen atom or a deuterium atom,
the substituents R₁₃ and R₁₄, which are same or different, are each independently any one selected from among a substituted or unsubstituted alkyl of 1 to 30 carbon atoms, a substituted or unsubstituted cycloalkyl of 3 to 30 carbon atoms, a substituted or unsubstituted aryl of 6 to 30 carbon atoms, a substituted or unsubstituted heteroaryl of 3 to 50 carbon atoms, and a substituted or unsubstituted aliphatic hydrocarbon ring-fused aryl of 8 to 30 carbon atoms,
the linkers L₁ to L₃, which are same or different, are each independently a single bond or any one selected from among a substituted or unsubstituted arylene of 6 to 24 carbon atoms, a substituted or unsubstituted heteroarylene of 3 to 24 carbon atoms, and a substituted or unsubstituted aliphatic hydrocarbon ring-fused arylene of 8 to 24 carbon atoms,
the substituents Ar₁ and Ar₂, which are same or different, are each independently any one selected from a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, and a substituted or unsubstituted aliphatic hydrocarbon ring-fused aryl of 8 to 30 carbon atoms, either or both of Ar₁ and Ar₂ being a substituted or unsubstituted heteroaryl of 3 to 30 carbon atoms,
m1 to m3 are each 1 or 2, wherein when m1 is 2, the corresponding L₁ are same or different, when m2 is 2, the corresponding L₂ are same or different, and when m3 is 2, the corresponding L₃ are same or different,
adjacent two of the substituents R₁ to R₁₂ are linked to each other to additionally form an aliphatic or aromatic mono- or polycyclic ring, and
R₁₃ and R₁₄ are connected to each other to additionally form an aliphatic or aromatic mono- or polycyclic ring,
wherein the term "substituted" in the expression "substituted or unsubstituted" used for the compounds of Chemical Formulas 1-1 to 1-4 is as defined in claim 1.

3. The organic light-emitting diode of claim 1, wherein at least one of Ar₁ and Ar₂ in Chemical Formula 1 is a substituted or unsubstituted heteroaryl of 4 to 20 carbon atoms bearing an oxygen atom (O) or sulfur atom (S).

4. The organic light-emitting diode of claim 1, wherein R₁₃ to R₁₆ in Chemical Formulas 1 and 2 are same or different and are each independently a substituted or unsubstituted alkyl of 1 to 10 carbon atoms.

5. The organic light-emitting diode of claim 1, wherein at least one of Ar₃ and Ar₄ in Chemical Formula 2 is a substituted or unsubstituted cycloalkyl of 4 to 20 carbon atoms.

6. The organic light-emitting diode of claim 5, wherein Ar₃ and Ar₄ in Chemical Formula 2 are same or different and are each independently a substituted or unsubstituted cycloalkyl of 4 to 20 carbon atoms.

7. The organic light-emitting diode of claim 5, wherein the ring structure in the substituted or unsubstituted cycloalkyl of 4 to 20 carbon atoms has a ring structure selected from among the following Structural Formulas 1 to 6: 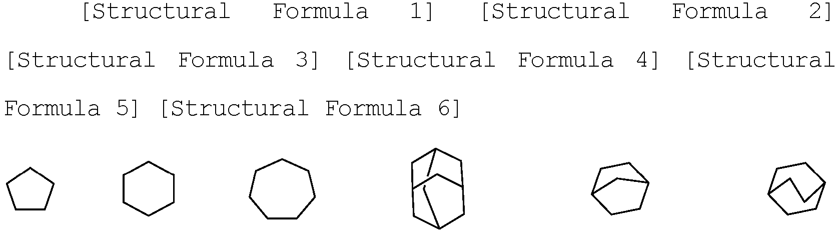 wherein, one hydrogen atom within the ring structures is removed, and the carbon atom in the ring structure that is bonded to the removed hydrogen is bonded to a linker L₅ or L₆ or a nitrogen atom (N) within Chemical Formula 2.

8. The organic light-emitting diode of claim 1, wherein Ar₅ and Ar₆ in Chemical Formula 3 are same or different and are each independently a substituted or unsubstituted aryl of 6 to 20 carbon atoms.

9. The organic light-emitting diode of claim 1, wherein the R₁₇ radicals in Chemical Formula 2 are same or different and are each independently a hydrogen atom or a deuterium atom.

10. The organic light-emitting diode of claim 1, wherein the amine compound represented by Chemical Formula 1 is any one selected from the following Compound 1-1 to Compound 1-120:

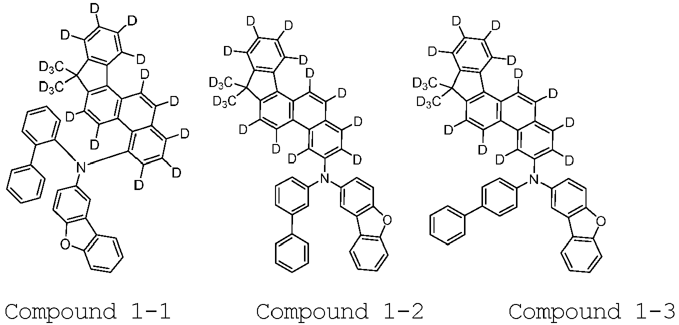

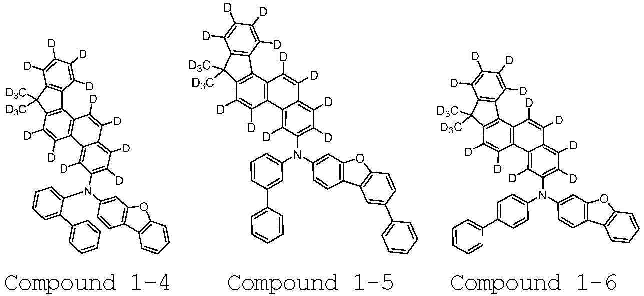

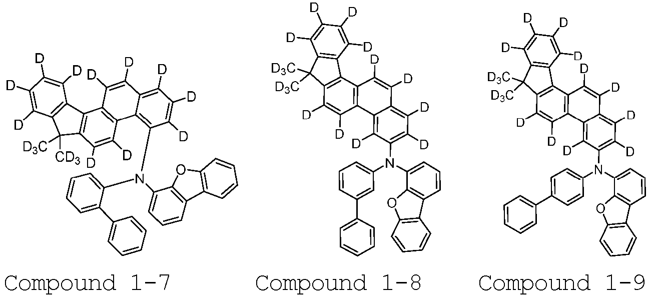

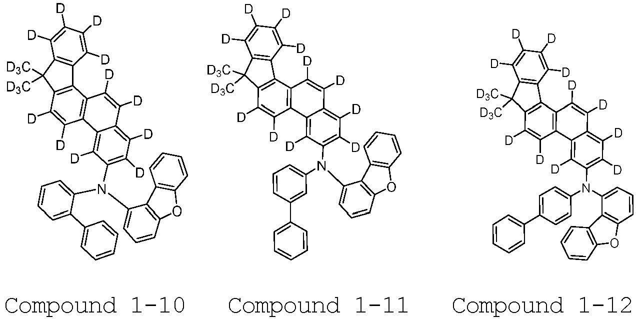

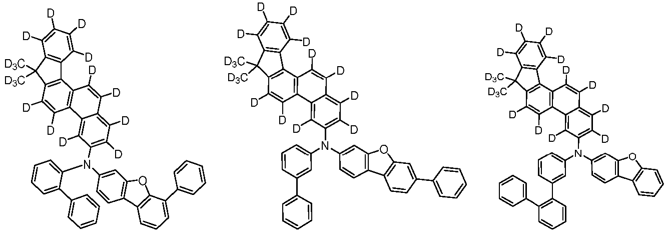

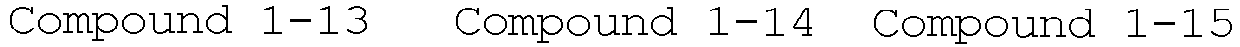

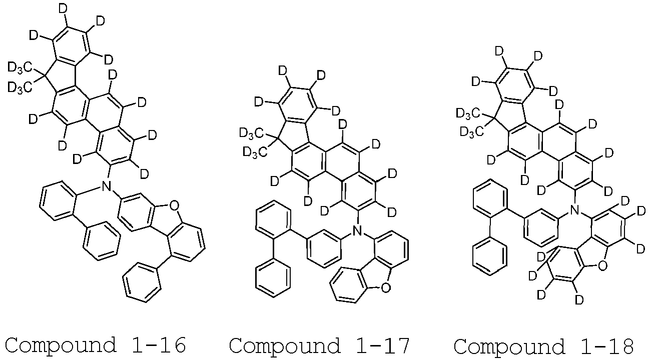

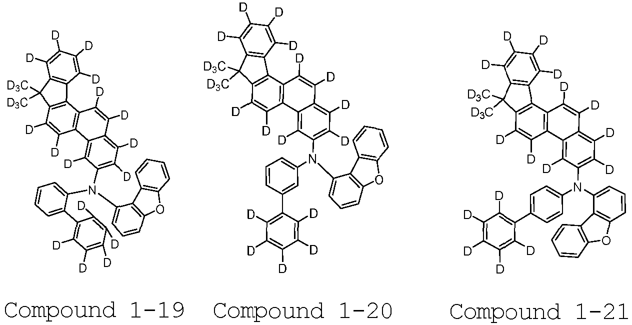

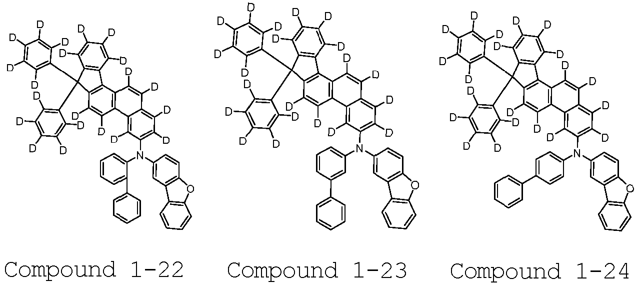

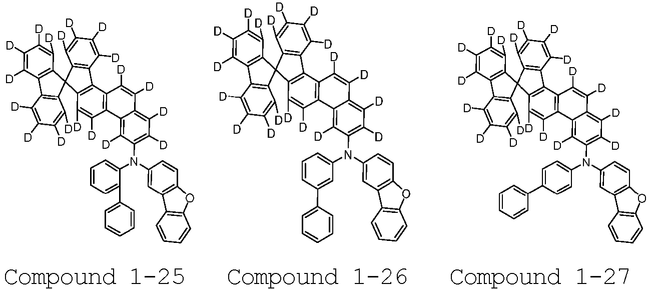

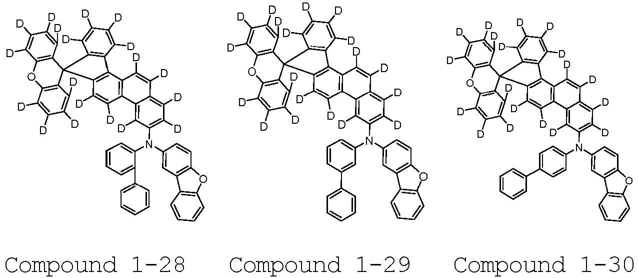

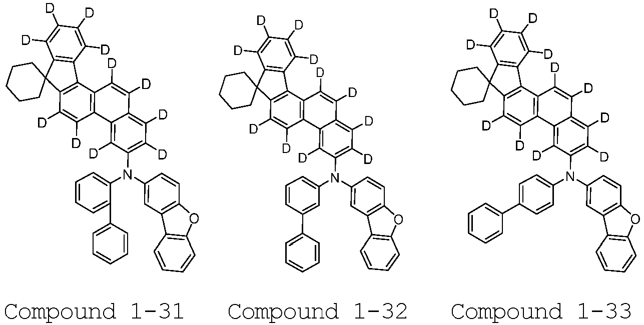

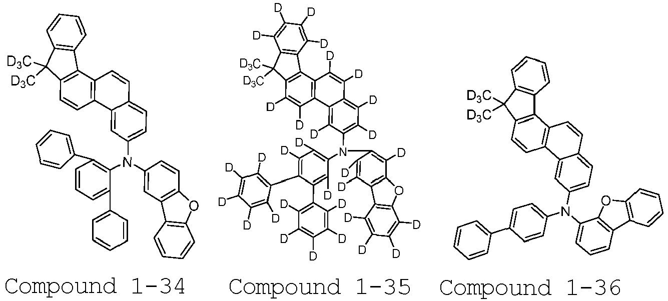

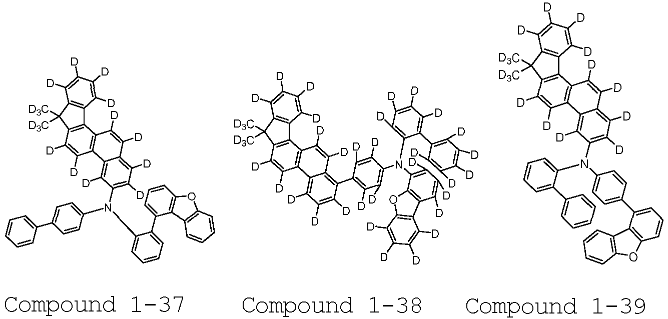

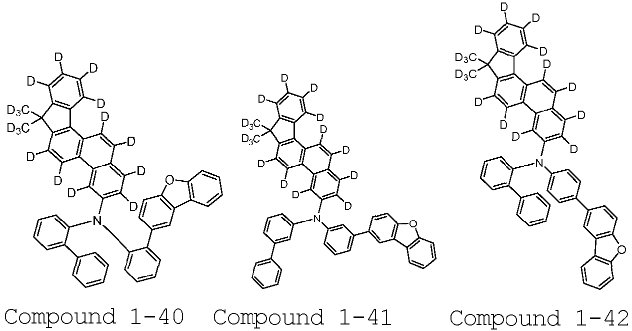

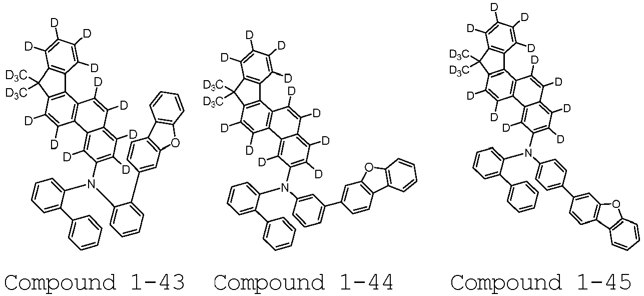

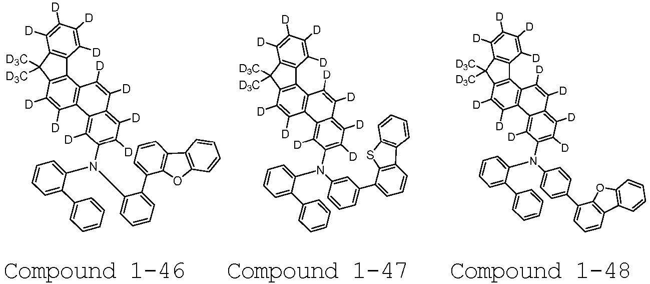

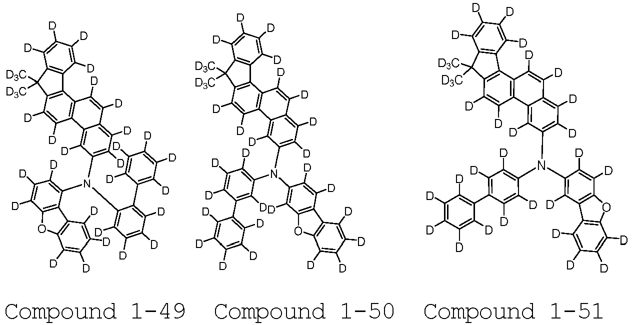

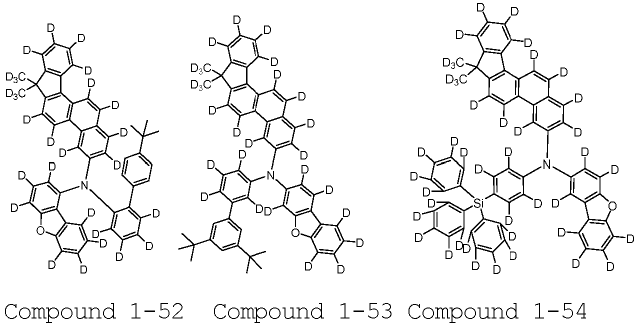

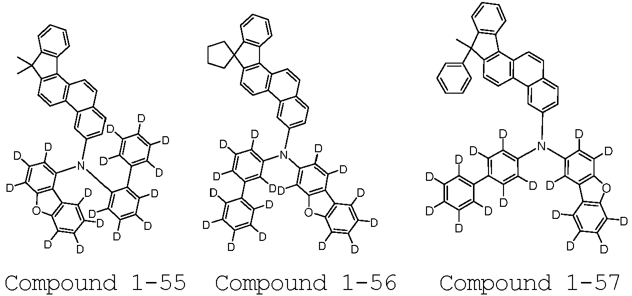

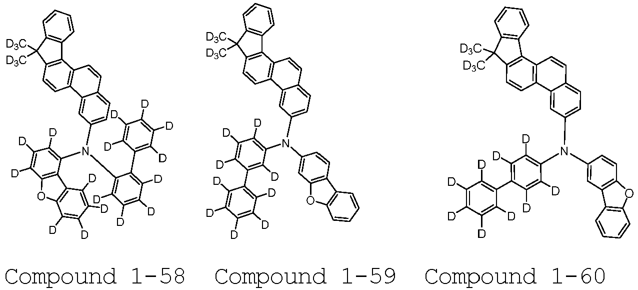

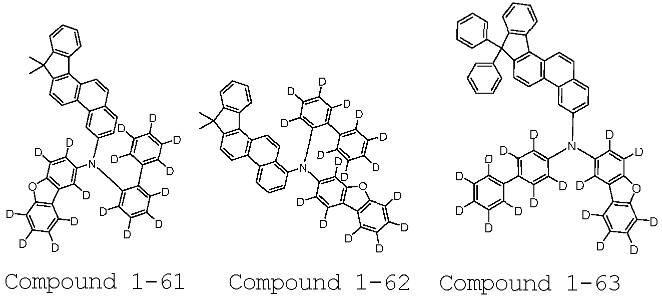

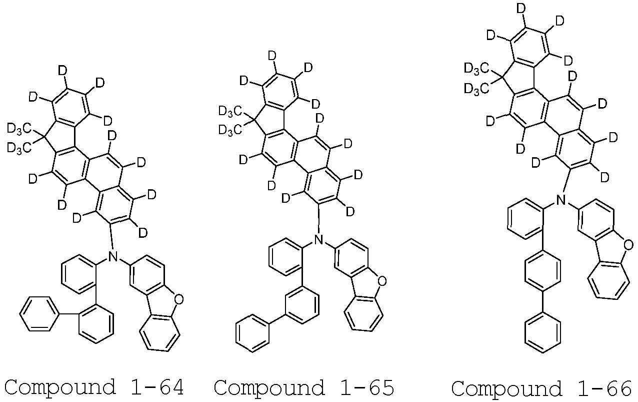

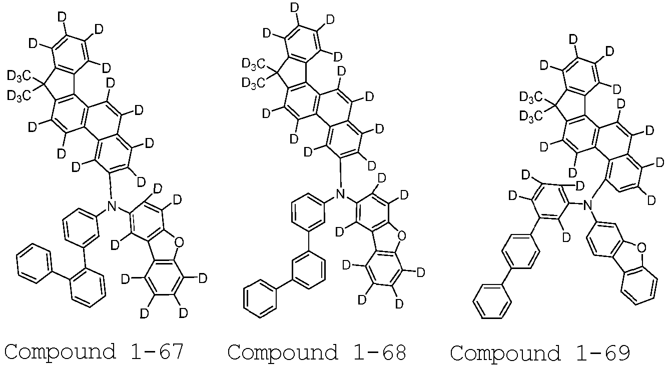

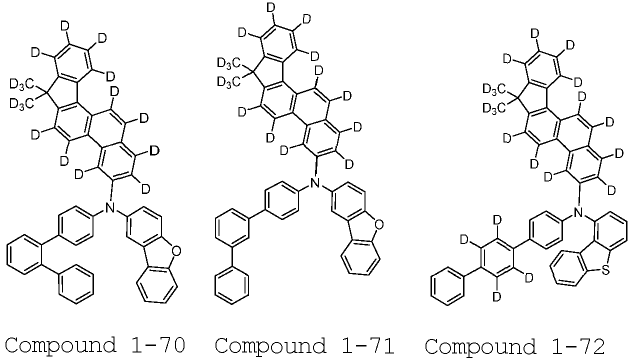

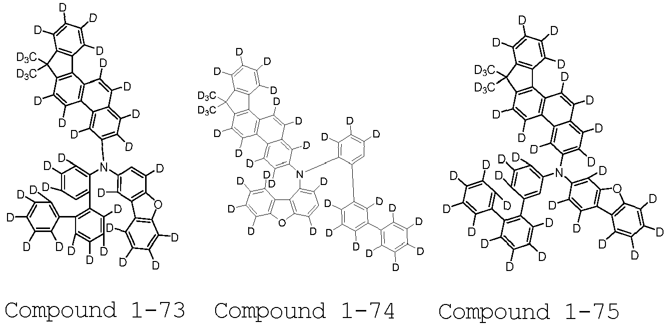

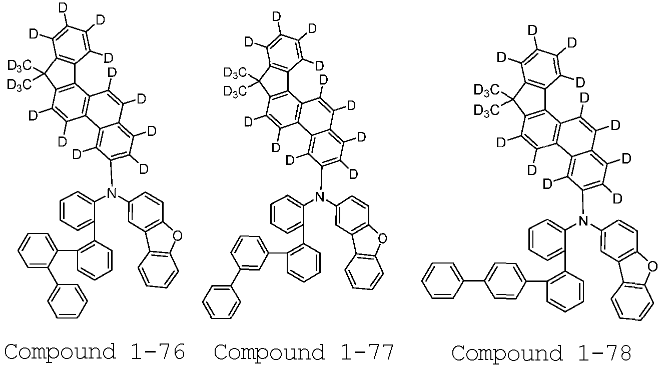

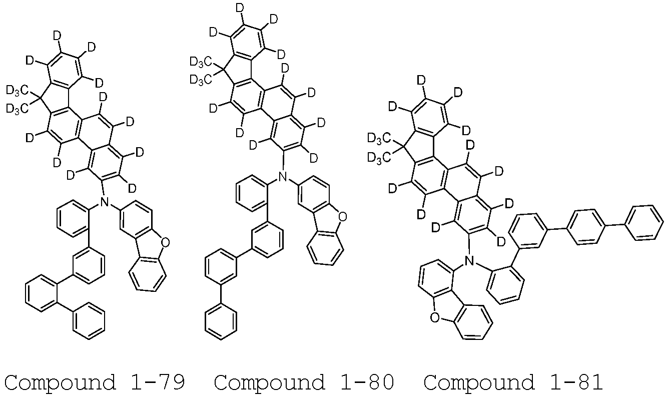

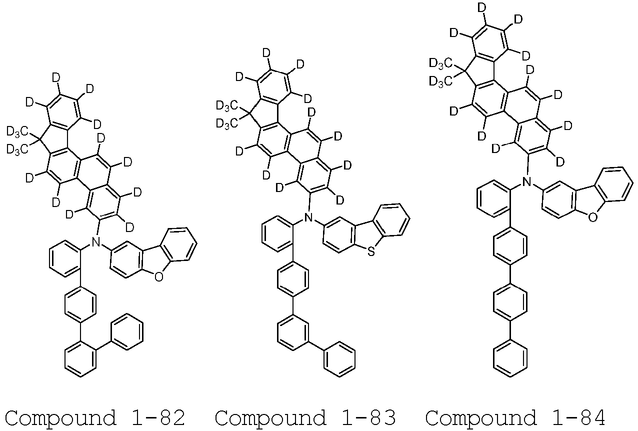

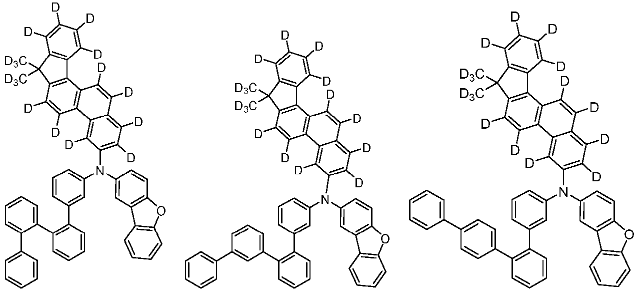

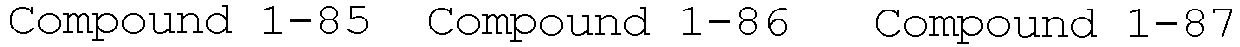

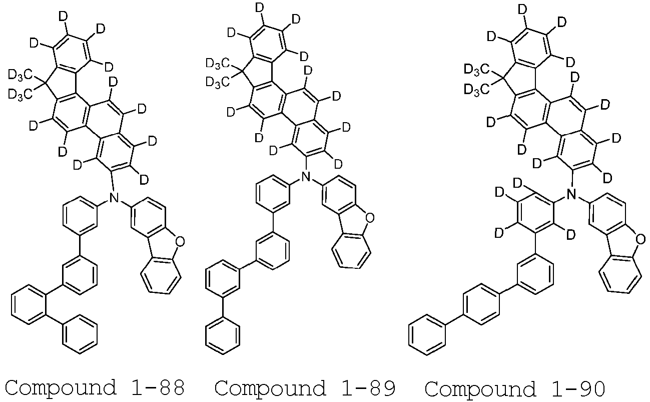

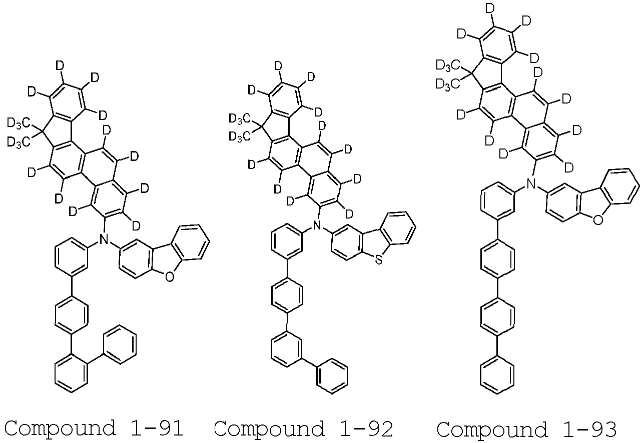

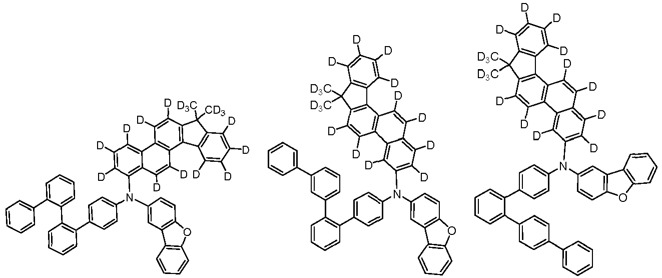

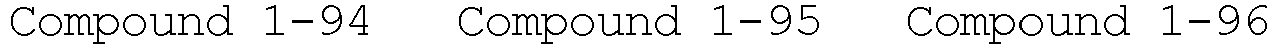

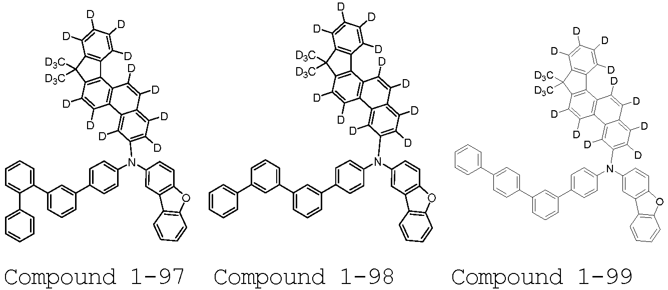

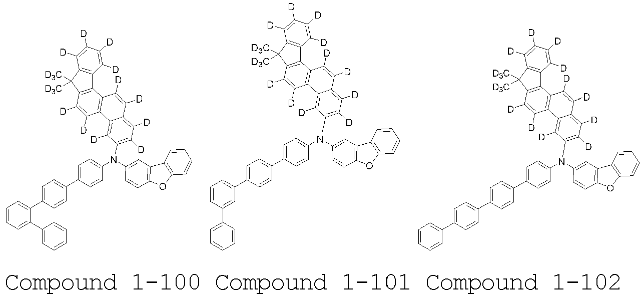

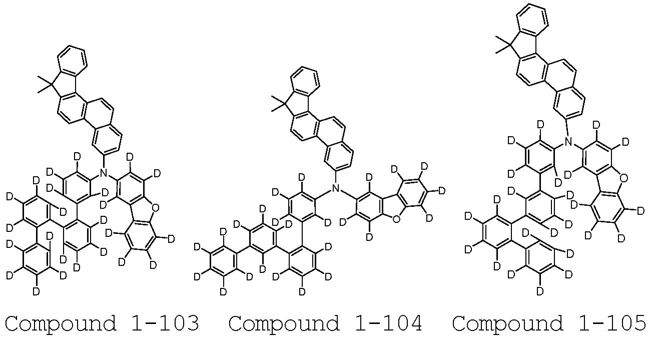

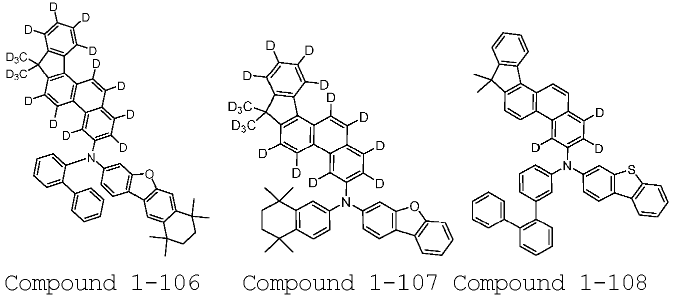

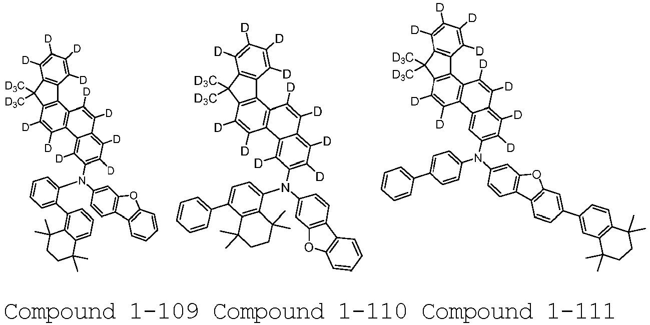

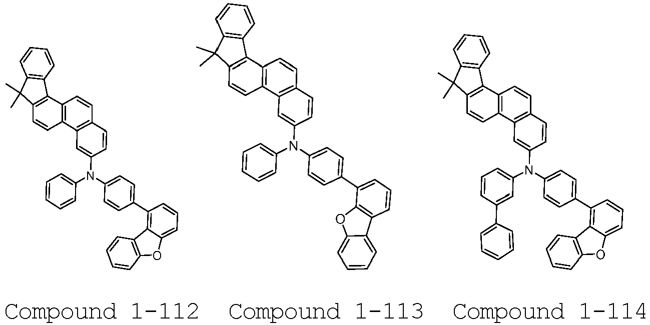

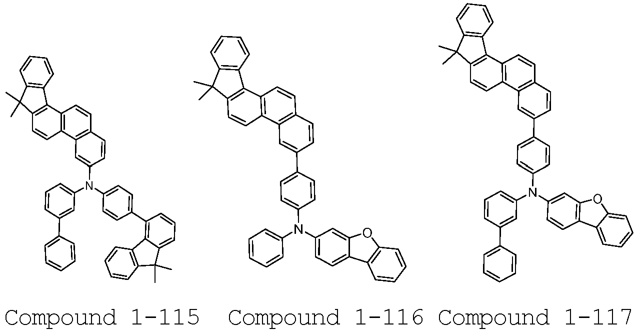

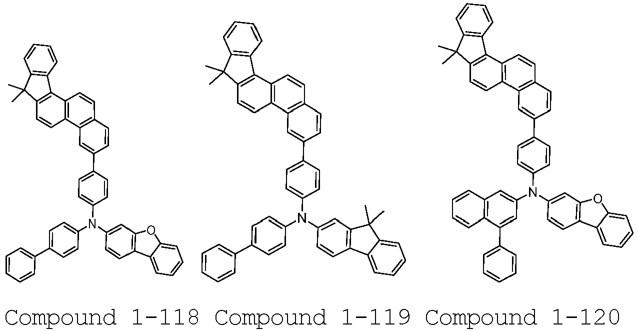

11. The organic light-emitting diode of claim 1, wherein the amine compound represented by Chemical Formula 2 is any one selected from among the following Compound 2-1 to Compound 2-48:

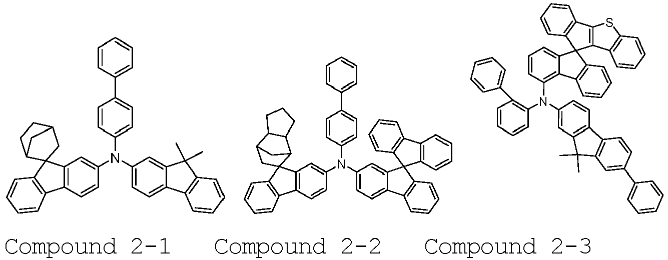

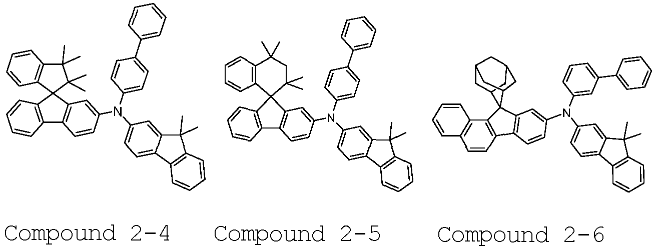

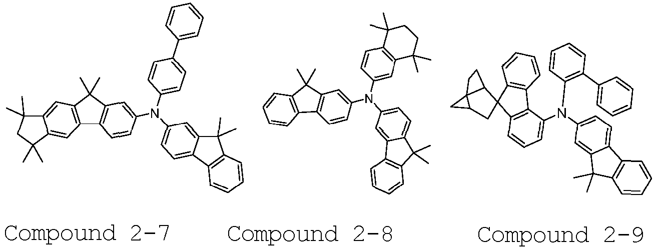

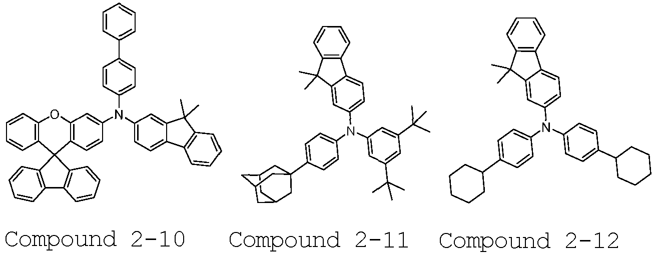

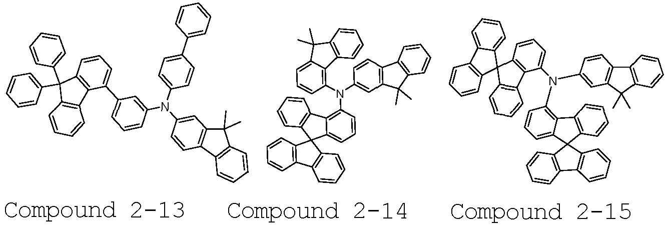

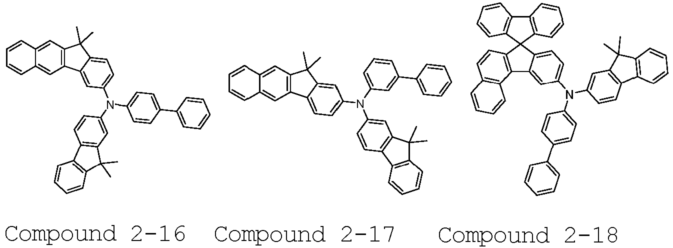

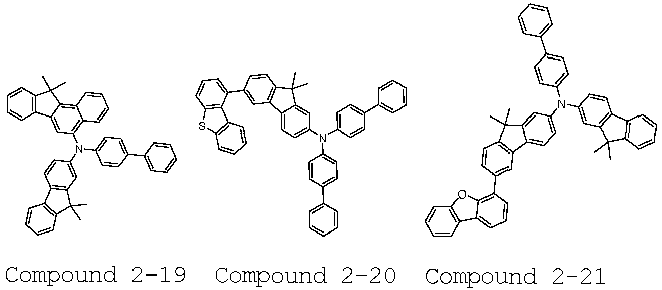

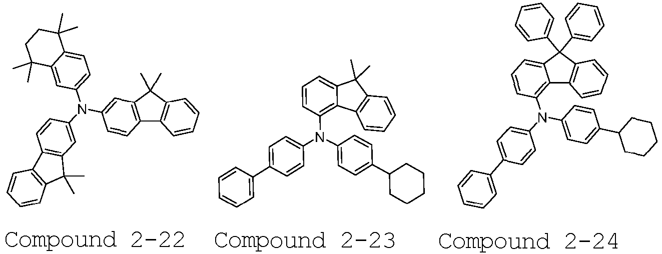

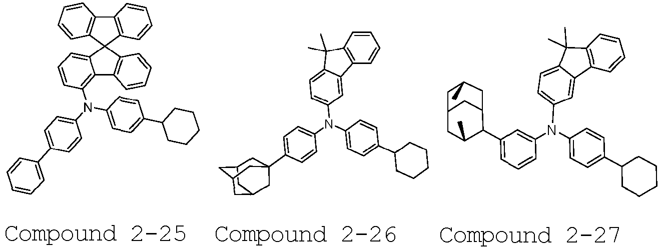

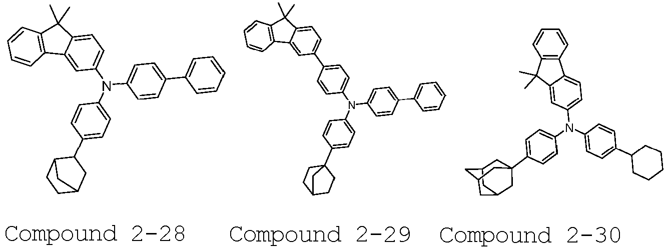

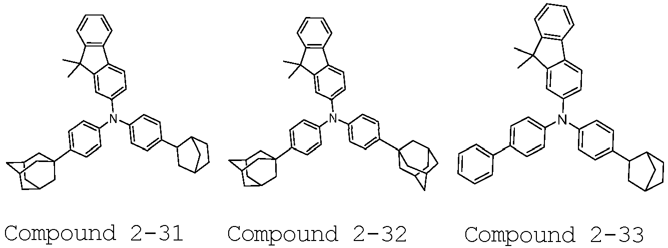

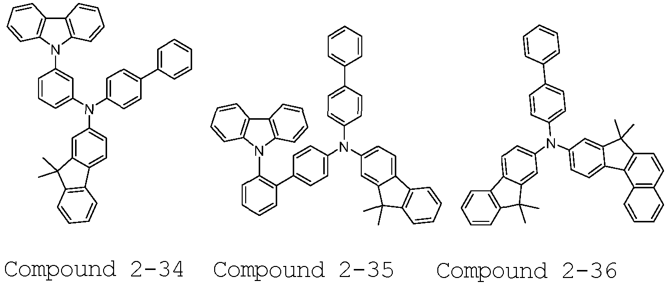

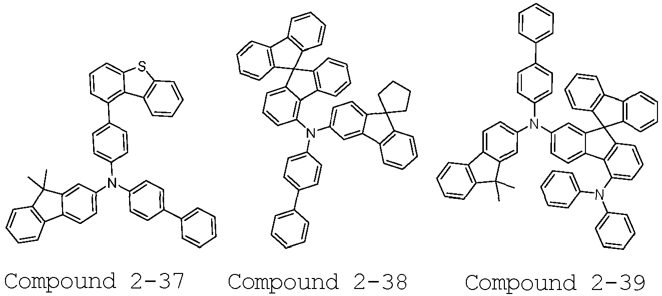

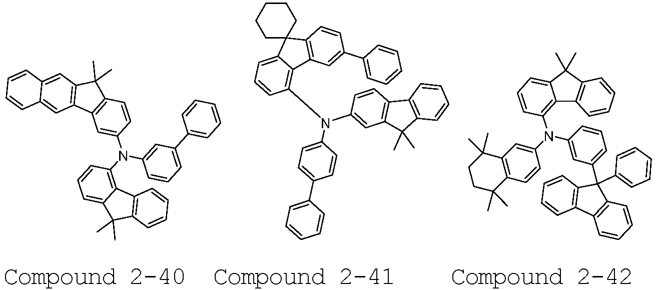

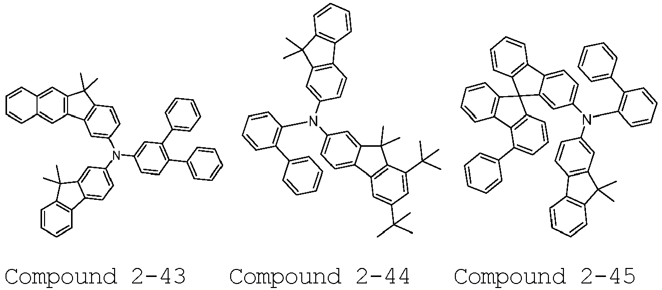

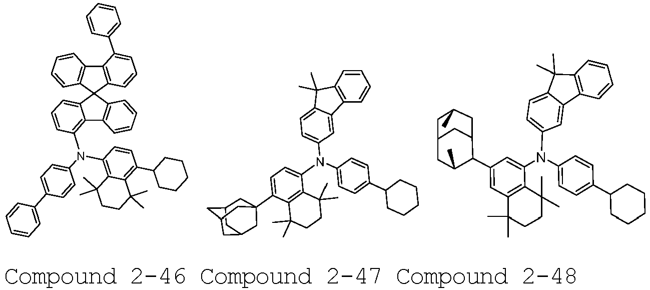

12. The organic light-emitting diode of claim 1, wherein the amine compound represented by Chemical Formula 3 is any one selected from among the following Compound 3-1 to Compound 3-39:

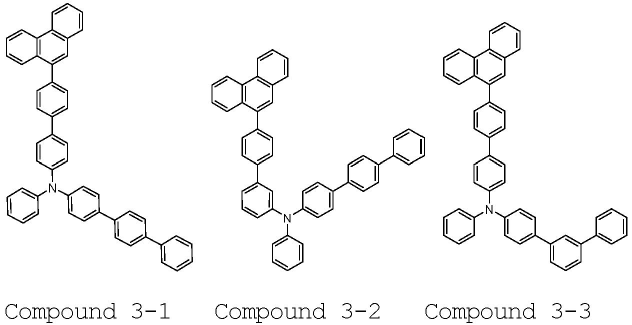

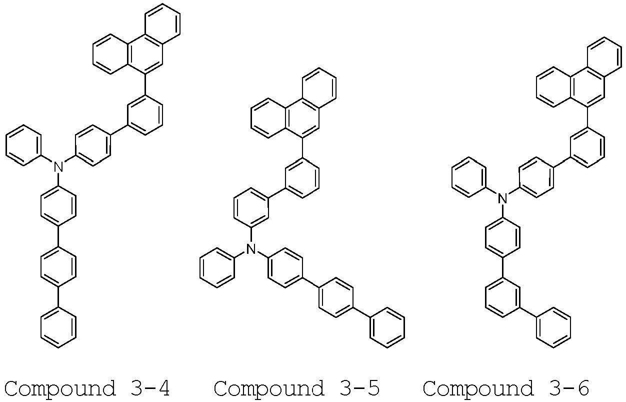

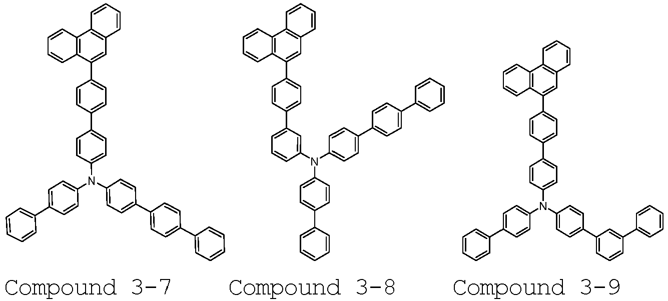

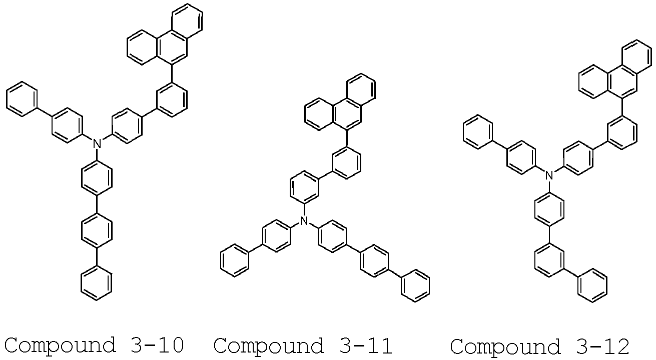

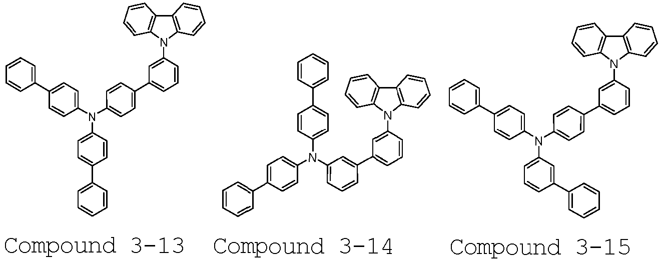

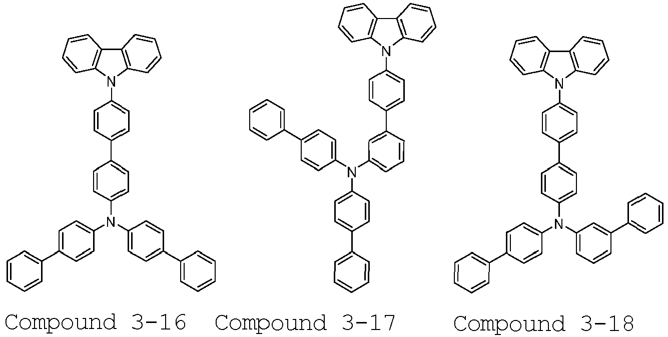

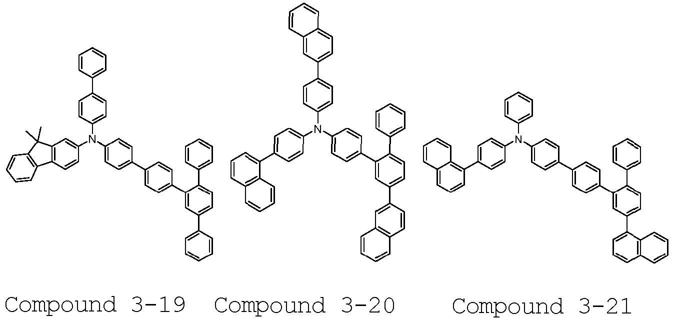

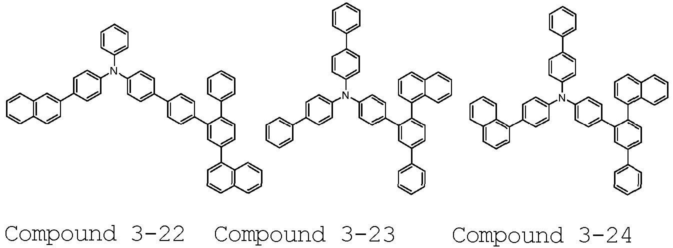

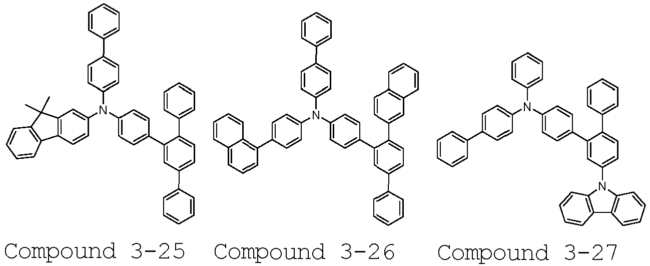

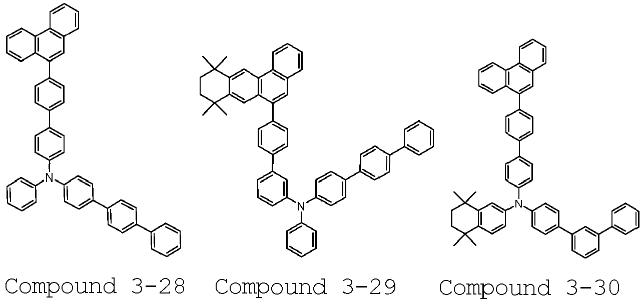

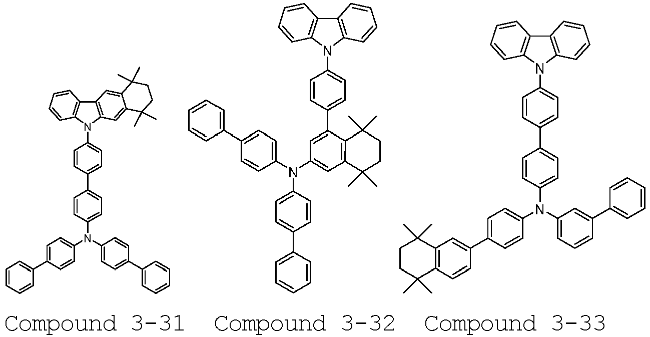

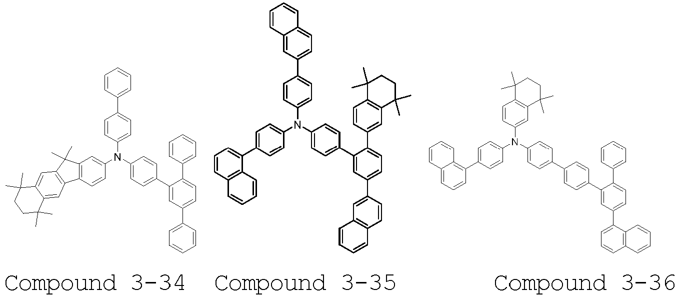

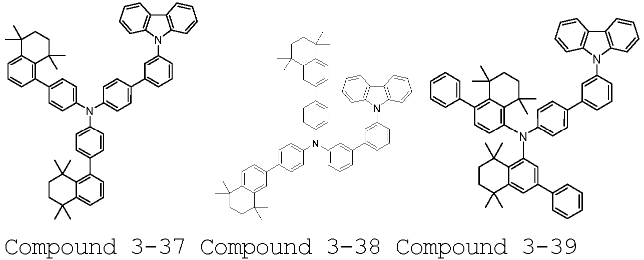

13. The organic light-emitting diode of claim 1, wherein the light-emitting layer comprises, in addition to the amine compound represented by Chemical Formula 1, at least one host compound different from the amine compound as a host.

14. The organic light-emitting diode of claim 1, wherein the emitting-auxiliary layer comprises, in addition to the amine compound represented by Chemical Formula 2 or Chemical Formula 3, an emitting-auxiliary layer compound different from the amine compound represented by Chemical Formula 2 or Chemical Formula 3.

15. The organic light-emitting diode of claim 1, wherein the organic light-emitting diode is used in any one selected from flat display devices, flexible display devices, stretchable display devices, monochrome or grayscale flat illumination devices, monochrome or grayscale flexible illumination devices, vehicle or aircraft display devices, and display devices for virtual or augmented reality.
